# EUROPEAN PATENT SPECIFICATION

(11) **EP 3 229 284 B1**
(45) Date of publication and mention of the grant of the patent: **31.08.2022**
(21) Application number: 15866092.8
(22) Date of filing: 01.12.2015
(51) Int. Cl.: H01L 51/50, C09K 11/06, C09K 11/02, H01L 51/00, H01L 51/52, C09B 57/00

(54) **ORGANIC ELECTROLUMINESCENT ELEMENT**
ORGANISCHES ELEKTROLUMINESZENTES ELEMENT
ÉLÉMENT ÉLECTROLUMINESCENT ORGANIQUE

(30) Priority: 05.12.2014 JP 2014246681
(43) Date of publication of application: 11.10.2017
(73) Proprietor: Hodogaya Chemical Co., Ltd., Chuo-ku Tokyo 104-0028 (JP); SFC Co., Ltd., Chungcheongbuk-do (KR)
(72) Inventor: HAYASHI, Shuichi, Tokyo 104-0028 (JP); KABASAWA, Naoaki, Tokyo 104-0028 (JP); KANDA, Daizou, Tokyo 104-0028 (JP); MOCHIZUKI, Shunji, Tokyo 104-0028 (JP); CHA, Soon-wook, Cheongju-si Chungcheongbuk-do (KR); PARK, Sang-woo, Cheongju-si Chungcheongbuk-do (KR); SONG, Ju-man, Cheongju-si Chungcheongbuk-do (KR); JEON, Kyung-seok, Cheongju-si Chungcheongbuk-do (KR)
(74) Representative: Müller-Boré & Partner Patentanwälte PartG mbB
(86) International application number: PCT/JP2015/083776
(87) International publication number: WO 2016/088759

(56) References cited:
- EP-A1- 2 682 997
- WO-A1-2011/134458
- WO-A1-2012/117973
- WO-A1-2014/129201
- WO-A1-2014/129201
- JP-A- 2008 115 093
- JP-A- 2013 118 288
- JP-A- 2013 118 288
- JP-A- 2013 531 360
- US-A1- 2009 267 491

## Description

The present invention relates to an organic electroluminescent device which is a preferred self-luminous device for various display devices. Specifically, this invention relates to organic electroluminescent devices (hereinafter referred to as organic EL devices) using specific arylamine compounds doped with an electron acceptor.

The organic EL device is a self-luminous device and has been actively studied for its brighter, superior visibility and the ability to display clearer images in comparison with liquid crystal devices.

In 1987, C. W. Tang and colleagues at Eastman Kodak developed a laminated structure device using materials assigned with different roles, realizing practical applications of an organic EL device with organic materials. These researchers laminated an electron-transporting phosphor and a hole-transporting organic substance, and injected both charges into a phosphor layer to cause emission in order to obtain a high luminance of 1,000 cd/m² or more at a voltage of 10 V or less (refer to Patent Documents 1 and 2, for example) .

To date, various improvements have been made for practical applications of the organic EL device. Various roles of the laminated structure are further subdivided to provide an electroluminescence device that includes an anode, a hole injection layer, a hole transport layer, a light emitting layer, an electron transport layer, an electron injection layer, and a cathode successively formed on a substrate, and high efficiency and durability have been achieved by the electroluminescence device (refer to Non-Patent Document 1, for example).

Further, there have been attempts to use triplet excitons for further improvements of luminous efficiency, and the use of a phosphorescence-emitting compound has been examined (refer to Non-Patent Document 2, for example).

Devices that use light emission caused by thermally activated delayed fluorescence (TADF) have also been developed. In 2011, Adachi et al. at Kyushu University, National University Corporation realized 5.3% external quantum efficiency with a device using a thermally activated delayed fluorescent material (refer to Non-Patent Document 3, for example).

The light emitting layer can also be fabricated by doping a charge-transporting compound generally called a host material, with a fluorescent compound, a phosphorescence-emitting compound, or a delayed fluorescent-emitting material. As described in the Non-Patent Document, the selection of organic materials in an organic EL device greatly influences various device characteristics such as efficiency and durability (refer to Non-Patent Document 2, for example).

In an organic EL device, charges injected from both electrodes recombine in a light emitting layer to cause emission. What is important here is how efficiently the hole and electron charges are transferred to the light emitting layer in order to form a device having excellent carrier balance . The probability of hole-electron recombination can be improved by improving hole injectability and electron blocking performance of blocking injected electrons from the cathode, and high luminous efficiency can be obtained by confining excitons generated in the light emitting layer. The role of a hole transport material is therefore important, and there is a need for a hole transport material that has high hole injectability, high hole mobility, high electron blocking performance, and high durability to electrons.

Heat resistance and amorphousness of the materials are also important with respect to the lifetime of the device. The materials with low heat resistance cause thermal decomposition even at a low temperature by heat generated during the drive of the device, which leads to the deterioration of the materials . The materials with low amorphousness cause crystallization of a thin film even in a short time and lead to the deterioration of the device. The materials in use are therefore required to have characteristics of high heat resistance and satisfactory amorphousness.

N,N'-diphenyl-N,N'-di(a-naphthyl)benzidine (NPD) and various aromatic amine derivatives are known as the hole transport materials used for the organic EL device (refer to Patent Documents 1 and 2, for example) . Although NPD has desirable hole transportability, its glass transition point (Tg), which is an index of heat resistance, is as low as 96°C, which causes the degradation of device characteristics by crystallization under a high-temperature condition (refer to Non-Patent Document 4, for example). The aromatic amine derivatives described in the Patent Documents include a compound known to have an excellent hole mobility of 10⁻³ cm²/Vs or higher (refer to Patent Documents 1 and 2, for example). However, since the compound is insufficient in terms of electron blocking performance, some of the electrons pass through the light emitting layer, and improvements in luminous efficiency cannot be expected. For such a reason, a material with higher electron blocking performance, a more stable thin-film state and higher heat resistance is needed for higher efficiency. Although an aromatic amine derivative having high durability is reported (refer to Patent Document 3, for example), the derivative is used as a charge transporting material used in an electrophotographic photoconductor, and there is no example of using the derivative in the organic EL device.

Arylamine compounds having a substituted carbazole structure are proposed as compounds improved in the characteristics such as heat resistance and hole injectability (refer to Patent Documents 4 and 5, for example). Further, it is proposed that hole injectability can be improved by p-doping materials such as trisbromophenylamine hexachloroantimony, radialene derivatives, and F4-TCNQ into a material commonly used for the hole injection layer or the hole transport layer (refer to Patent Document 6 and Non-Patent Document 5). However, while the devices using these compounds for the hole injection layer or the hole transport layer have been improved in lower driving voltage and heat resistance, luminous efficiency and the like, the improvements are still insufficient. Further lower driving voltage and higher luminous efficiency are therefore needed.

In order to improve characteristics of the organic EL device and to improve the yield of the device production, it has been desired to develop a device having high luminous efficiency, low driving voltage and a long lifetime by using in combination the materials that excel in hole and electron injection/transport performances, stability as a thin film and durability, permitting holes and electrons to be highly efficiently recombined together.

Further, in order to improve characteristics of the organic EL device, it has been desired to develop a device that maintains carrier balance and has high efficiency, low driving voltage and a long lifetime by using in combination the materials that excel in hole and electron injection/transport performances, stability as a thin film and durability.

Patent Document 1: JP-A-8-048656
Patent Document 2: Japanese Patent No. 3194657
Patent Document 3: Japanese Patent No. 4943840
Patent Document 4: JP-A-2006-151979
Patent Document 5: WO2008/62636
Patent Document 6: WO2014/009310
Patent Document 7: WO2005/115970
Patent Document 8: JP-A-7-126615
Patent Document 9: JP-A-8-048656
Patent Document 10: JP-A-2005-108804
Patent Document 11: WO2011/059000
Patent Document 12: WO2003/060956
Patent Document 13: KR-A-2013-060157
Further, Patent Document 14 (WO 2011/134458 A1) describes an organic semiconducting material and an electronic component.
Patent Document 15 (EP 2 682 997 A1) describes an organic electroluminescent element.
Patent Document 16 (WO 2014/129201 A1) describes an organic electroluminescence element.

Non-Patent Document 1: The Japan Society of Applied Physics, 9th Lecture Preprints, pp. 55 to 61 (2001)
Non-Patent Document 2: The Japan Society of Applied Physics, 9th Lecture Preprints, pp. 23 to 31 (2001)
Non-Patent Document 3: Appl. Phys. Let., 98, 083302 (2011)
Non-Patent Document 4: Organic EL Symposium, the 3rd Regular presentation Preprints, pp. 13 to 14 (2006)
Non-Patent Document 5: Appl. Phys. Let., 89, 253506 (2006)

An object of the present invention is to provide an organic EL device having low driving voltage, high luminous efficiency and a long lifetime, by combining various materials for an organic EL device, which are excellent, as materials for an organic EL device having high luminous efficiency and high durability, in hole and electron injection/transport performances, electron blocking ability, stability in a thin-film state and durability, so as to allow the respective materials to effectively reveal their characteristics.

Physical properties of the organic EL device to be provided by the present invention include (1) low turn on voltage, (2) low actual driving voltage, (3) high luminous efficiency and high power efficiency, and (4) a long lifetime.

For achieving the object, the present inventors, who pay attention to the fact that an arylamine compound doped with an electron acceptor is excellent in the hole injection/transport performances and the stability and durability of the thin film, select a particular arylamine compound (having a particular structure), so as to perform efficiently injection/transport of holes from the anode, and produce various organic EL devices having a material of a hole injection layer doped with an electron acceptor, and the devices are earnestly evaluated for characteristics. Furthermore, the inventors produce various organic EL devices having a combination of a particular arylamine compound (having a particular structure) doped with an electron acceptor and a particular arylamine compound (having a particular structure) not doped with an electron acceptor, and the devices are earnestly evaluated for characteristics. As a result, the present invention has been completed.

According to the present invention, the following organic EL devices are provided.
1) An organic electroluminescent device having at least an anode, a hole injection layer, a hole transport layer, a light emitting layer, an electron transport layer, and a cathode, in this order, wherein the hole injection layer includes an arylamine compound of the following general formula (1) and an electron acceptor: 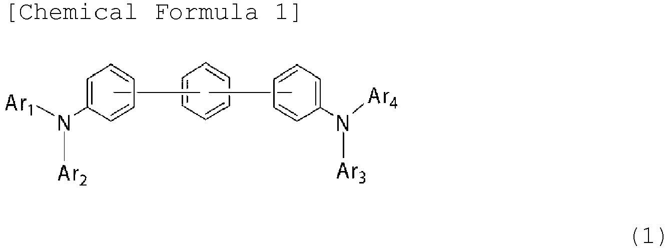 In the formula, Ar₁ to Ar₄ may be the same or different, and represent a substituted or unsubstituted aromatic hydrocarbon group, a substituted or unsubstituted aromatic heterocyclic group, or a substituted or unsubstituted condensed polycyclic aromatic group,
   wherein the substituent in the substituted aromatic hydrocarbon group, the substituted aromatic heterocyclic group, or the substituted condensed polycyclic aromatic group represented by Ar₁ to Ar₄ in the general formula (1) include a deuterium atom; cyano; nitro; halogen atoms; linear or branched alkyls of 1 to 6 carbon atoms; linear or branched alkyloxys of 1 to 6 carbon atoms; alkenyls; aryloxys; arylalkyloxys; aromatic hydrocarbon groups or condensed polycyclic aromatic groups; aromatic heterocyclic groups; arylvinyls; acyls; and silyls,
   wherein the hole transport layer consists of an arylamine compound of the general formula (1), and
   wherein the electron transport layer includes a compound represented by the following general formula (5b) having an anthracene ring structure or a compound represented by the following general formula (6) having a pyrimidine ring structure: 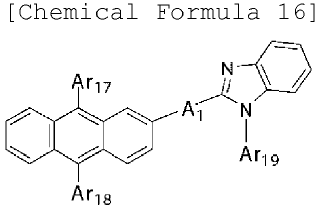 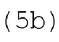 wherein A₁ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond; Ar₁₇, Ar₁₈, and Ar₁₉ may be the same or different, and represent a substituted or unsubstituted aromatic hydrocarbon group, a substituted or unsubstituted aromatic heterocyclic group, or a substituted or unsubstituted condensed polycyclic aromatic group; and 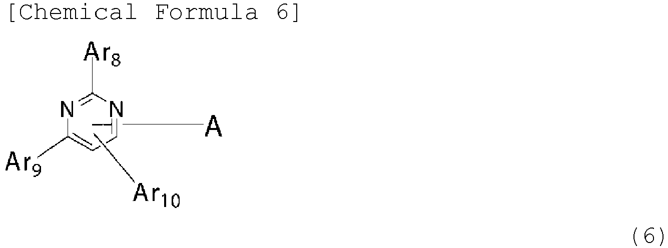 wherein Ar₈ represents a substituted or unsubstituted aromatic hydrocarbon group, a substituted or unsubstituted aromatic heterocyclic group, or a substituted or unsubstituted condensed polycyclic aromatic group; Ar₉ and Ar₁₀ may be the same or different, and represent a hydrogen atom, a substituted or unsubstituted aromatic hydrocarbon group, a substituted or unsubstituted aromatic heterocyclic group, or a substituted or unsubstituted condensed polycyclic aromatic group; and A represents a monovalent group represented by the following structural formula (7), where Ar₉ and Ar₁₀ are not simultaneously a hydrogen atom: 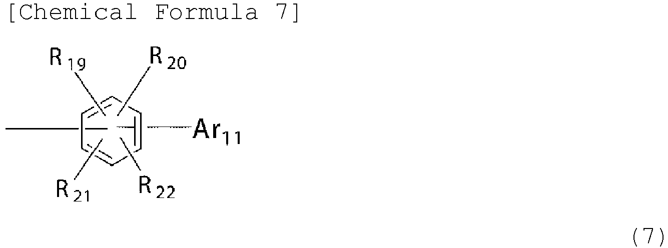 wherein Ar₁₁ represents a substituted or unsubstituted aromatic heterocyclic group; and R₁₉ to R₂₂ may be the same or different, and represent a hydrogen atom, a deuterium atom, a fluorine atom, a chlorine atom, cyano, trifluoromethyl, linear or branched alkyl of 1 to 6 carbon atoms, a substituted or unsubstituted aromatic hydrocarbon group, a substituted or unsubstituted aromatic heterocyclic group, or a substituted or unsubstituted condensed polycyclic aromatic group, where R₁₉ to R₂₂ may bind to Ar₁₁ via a single bond, substituted or unsubstituted methylene, an oxygen atom, or a sulfur atom to form a ring.
2) The organic electroluminescent device of 1), wherein the layers that are adjacent to the light emitting layer do not include an electron acceptor.
3) The organic EL device of 1) or 2), wherein the electron acceptor is an electron acceptor selected from trisbromophenylamine hexachloroantimony, tetracyanoquinodimethane (TCNQ), 2,3,5,6-tetrafluoro-tetracyano-1,4-benzoquinodimethane (F4TCNQ), and a radialene derivative.
4) The organic EL device of any one of 1) to 3), wherein the electron acceptor is a radialene derivative of the following general formula (2): 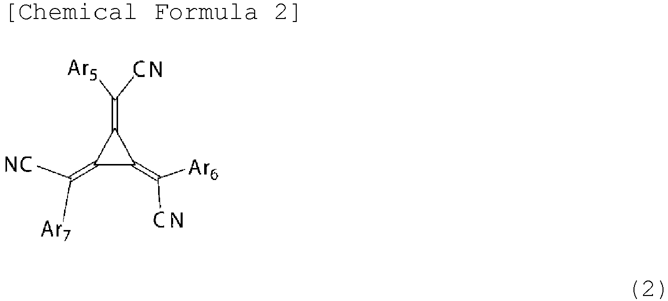 In the formula, Ar₅ to Ar₇ may be the same or different, and represent an aromatic hydrocarbon group, an aromatic heterocyclic group, or a condensed polycyclic aromatic group, having an electron acceptor group as a substituent.
5) The organic EL device of any one of 1) to 4), wherein the light emitting layer includes a blue light emitting dopant.
6) The organic EL device of 5), wherein the light emitting layer includes a pyrene derivative as the blue light emitting dopant.
7) The organic EL device of 5), wherein the blue light emitting dopant includes a light emitting dopant which is an amine derivative having a condensed ring structure of the following general formula (8). 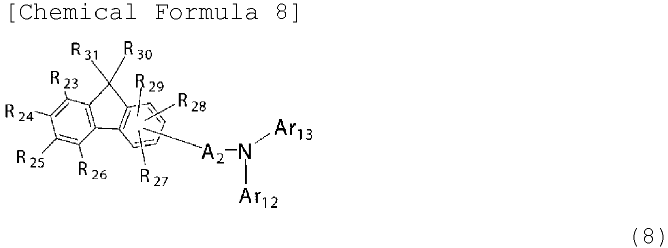 In the formula, A₂ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond. Ar₁₂ and Ar₁₃ may be the same or different, represent a substituted or unsubstituted aromatic hydrocarbon group, a substituted or unsubstituted aromatic heterocyclic group, or a substituted or unsubstituted condensed polycyclic aromatic group, and may bind to each other via a single bond, substituted or unsubstituted methylene, an oxygen atom, or a sulfur atom to form a ring. R₂₃ to R₂₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, substituted or unsubstituted aryloxy, or a disubstituted amino group substituted by groups selected from an aromatic hydrocarbon group, an aromatic heterocyclic group, and a condensed polycyclic aromatic group, where these groups may bind to each other via a single bond, substituted or unsubstituted methylene, an oxygen atom, or a sulfur atom to form a ring, and may bind to the benzene ring binding to R₂₃ to R₂₆ via substituted or unsubstituted methylene, an oxygen atom, a sulfur atom, or a monosubstituted amino group to form a ring. R₂₇ to R₂₉ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, where these groups may bind to each other via a single bond, substituted or unsubstituted methylene, an oxygen atom, or a sulfur atom to form a ring, and may bind to the benzene ring binding to R₂₇ to R₂₉ via substituted or unsubstituted methylene, an oxygen atom, a sulfur atom, or a monosubstituted amino group to form a ring. R₃₀ and R₃₁ may be the same or different, and represent linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy, where these groups may bind to each other via a single bond, substituted or unsubstituted methylene, an oxygen atom, a sulfur atom, or a monosubstituted amino group to form a ring.
8) The organic EL device of any one of 1) to 7), wherein the light emitting layer includes an anthracene derivative.
9) The organic EL device of 8), wherein the light emitting layer includes a host material which is the anthracene derivative.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1) include phenyl, biphenylyl, terphenylyl, naphthyl, anthracenyl, phenanthrenyl, fluorenyl, indenyl, pyrenyl, perylenyl, fluoranthenyl, triphenylenyl, pyridyl, pyrimidinyl, triazinyl, furyl, pyrrolyl, thienyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, naphthyridinyl, phenanthrolinyl, acridinyl, and carbolinyl.

According to the present disclosure:
10) The organic EL device of any one of 1) to 4), wherein the hole transport layer includes an arylamine compound having a structure in which two to six triphenylamine structures are joined within a molecule via a single bond or a divalent group that does not contain a heteroatom.
11) The organic EL device of 10), wherein the arylamine compound having a structure in which two to six triphenylamine structures are joined within a molecule via a single bond or a divalent group that does not contain a heteroatom is an arylamine compound of the following general formula (3).

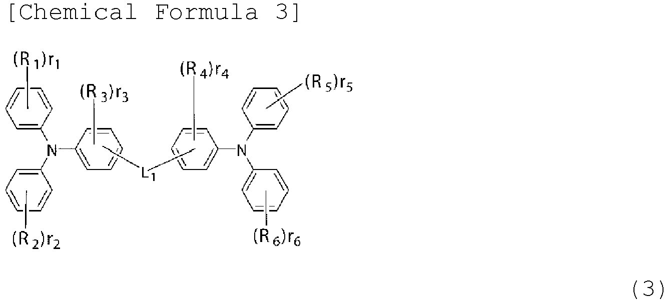

In the formula, R₁ to R₆ represent a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. r₁ to r₆ may be the same or different, r₁, r₂, r₅, and r₆ representing an integer of 0 to 5, and r₃ and r₄ representing an integer of 0 to 4. When r₁, r₂, r₅, and r₆ are an integer of 2 to 5, or when r₃ and r₄ are an integer of 2 to 4, R₁ to R₆, a plurality of which bind to the same benzene ring, may be the same or different and may bind to each other via a single bond, substituted or unsubstituted methylene, an oxygen atom, or a sulfur atom to form a ring. L₁ represents a divalent linking group.

12) The organic EL device of 10), wherein the arylamine compound having a structure in which two to six triphenylamine structures are joined within a molecule via a single bond or a divalent group that does not contain a heteroatom is an arylamine compound of the following general formula (4).

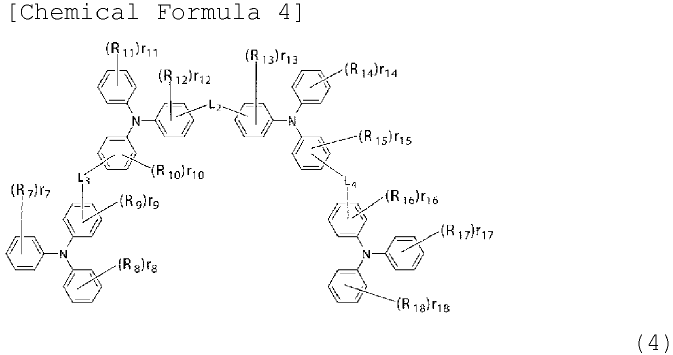

In the formula, R₇ to R₁₈ represent a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy. r₇ to r₁₈ may be the same or different, r₇, r₈, r₁₁, r₁₄, r₁₇, and r₁₈ representing an integer of 0 to 5, and r₉, r₁₀, r₁₂, r₁₃, r₁₅, and r₁₆ representing an integer of 0 to 4. When r₇, r₈, r₁₁, r₁₄, r₁₇, and r₁₈ are an integer of 2 to 5, or when r₉, r₁₀, r₁₂, r₁₃, r₁₅, and r₁₆ are an integer of 2 to 4, R₇ to R₁₈, a plurality of which bind to the same benzene ring, may be the same or different and may bind to each other via a single bond, substituted or unsubstituted methylene, an oxygen atom, or a sulfur atom to form a ring. L₂, L₃, and L₄ may be the same or different, and represent a divalent linking group or a single bond.

Specific examples of the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, include a deuterium atom; cyano; nitro; halogen atoms such as a fluorine atom, a chlorine atom, a bromine atom, and an iodine atom; linear or branched alkyls of 1 to 6 carbon atoms such as methyl, ethyl, n-propyl, isopropyl, n-butyl, isobutyl, tert-butyl, n-pentyl, isopentyl, neopentyl, and n-hexyl; linear or branched alkyloxys of 1 to 6 carbon atoms such as methyloxy, ethyloxy, and propyloxy; alkenyls such as allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl; arylvinyls such as styryl and naphthylvinyl; acyls such as acetyl and benzoyl; and silyls, such as trimethylsilyl and triphenylsilyl. These substituents may be further substituted with the exemplified substituents above. These substituents may bind to each other via a single bond, substituted or unsubstituted methylene, an oxygen atom, or a sulfur atom to form a ring.

Specific examples of the "electron acceptor group" in the "aromatic hydrocarbon group, aromatic heterocyclic group, or condensed polycyclic aromatic ring having an electron acceptor group as a substituent" represented by Ar₅ to Ar₁ in the general formula (2), according to the present invention, include a fluorine atom, a chlorine atom, a bromine atom, cyano, trimethylfluoro, and nitro.

Examples of the "aromatic hydrocarbon group", the "aromatic heterocyclic group", or the "condensed polycyclic aromatic group" in the "aromatic hydrocarbon group, aromatic heterocyclic group, or condensed polycyclic aromatic ring having an electron acceptor group as a substituent" represented by Ar₅ to Ar₇ in the general formula (2), according to the present invention, include the same groups exemplified as the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention.

These groups may have a substituent, in addition to the electron acceptor group, and specific examples of the substituent include a deuterium atom; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; and aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl. These substituents may be further substituted with the exemplified substituents or electron acceptor groups above. These substituents may bind to each other via a single bond, substituted or unsubstituted methylene, an oxygen atom, or a sulfur atom to form a ring.

Specific examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₁ to R₆ in the general formula (3), according to the present disclosure, include methyl, ethyl, n-propyl, isopropyl, n-butyl, isobutyl, tert-butyl, n-pentyl, isopentyl, neopentyl, n-hexyl, cyclopentyl, cyclohexyl, 1-adamantyl, 2-adamantyl, vinyl, allyl, isopropenyl, and 2-butenyl. These groups may bind to each other via a single bond, substituted or unsubstituted methylene, an oxygen atom, or a sulfur atom to form a ring.

Specific examples of the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₁ to R₆ in the general formula (3), according to the present disclosure, include a deuterium atom; cyano; nitro; halogen atoms such as a fluorine atom, a chlorine atom, a bromine atom, and an iodine atom; linear or branched alkyloxys of 1 to 6 carbon atoms such as methyloxy, ethyloxy, and propyloxy; alkenyls such as allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; and aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl. These substituents may be further substituted with the exemplified substituents above. These substituents may bind to each other via a single bond, substituted or unsubstituted methylene, an oxygen atom, or a sulfur atom to form a ring.

Specific examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₁ to R₆ in the general formula (3), according to the present disclosure, include methyloxy, ethyloxy, n-propyloxy, isopropyloxy, n-butyloxy, tert-butyloxy, n-pentyloxy, n-hexyloxy, cyclopentyloxy, cyclohexyloxy, cycloheptyloxy, cyclooctyloxy, 1-adamantyloxy, and 2-adamantyloxy. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₁ to R₆ in the general formula (3), according to the present disclosure, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₁ to R₆ in the general formula (3), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Specific examples of the "aryloxy group" in the "substituted or unsubstituted aryloxy group" represented by R₁ to R₆ in the general formula (3), according to the present disclosure, include phenyloxy, biphenylyloxy, terphenylyloxy, naphthyloxy, anthracenyloxy, phenanthrenyloxy, fluorenyloxy, indenyloxy, pyrenyloxy, and perylenyloxy. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

In the general formula (3), according to the present disclosure, r₁ to r₆ may be the same or different, r₁, r₂, r₅, and r₆ representing an integer of 0 to 5, and r₃ and r₄ representing an integer of 0 to 4. When r₁, r₂, r₅, and r₆ are an integer of 2 to 5, or when r₃ and r₄ are an integer of 2 to 4, R₁ to R₆, a plurality of which bind to the same benzene ring, may be the same or different and may bind to each other via a single bond, substituted or unsubstituted methylene, an oxygen atom, or a sulfur atom to form a ring.

Examples of the "divalent linking group" represented by L₁ in the general formula (3), according to the present disclosure, include "linear or branched alkylenes of 1 to 6 carbon atoms", such as methylene, ethylene, n-propylene, isopropylene, n-butylene, isobutylene, tert-butylene, n-pentylene, isopentylene, neopentylene, and n-hexylene; "cycloalkylenes of 5 to 10 carbon atoms", such as cyclopentylene, cyclohexylene, and adamantylene; "linear or branched alkenylenes of 2 to 6 carbon atoms", such as vinylene, arylene, isopropenylene, and butenylene; "divalent groups of aromatic hydrocarbons" that result from the removal of two hydrogen atoms from aromatic hydrocarbons, such as benzene, biphenyl, terphenyl, and tetrakisphenyl; and "divalent groups of condensed polycyclic aromatics" that result from the removal of two hydrogen atoms from condensed polycyclic aromatics, such as naphthalene, anthracene, acenaphthalene, fluorene, phenanthrene, indane, pyrene, and triphenylene.

These divalent groups may have a substituent. Examples of the substituent of the "linear or branched alkylene of 1 to 6 carbon atoms", the "cycloalkylene of 5 to 10 carbon atoms", or the "linear or branched alkenylene of 2 to 6 carbon atoms" include the same groups exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₁ to R₆ in the general formula (3), according to the present disclosure, and examples of the substituent in the "divalent group of aromatic hydrocarbons" or the "divalent group of condensed polycyclic aromatics" include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention.

Examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₇ to R₁₈ in the general formula (4), according to the present disclosure, include the same groups exemplified as the groups for the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₁ to R₆ in the general formula (3), according to the present disclosure, and possible embodiments may also be the same embodiments as the exemplified embodiments.

Examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₇ to R₁₈ in the general formula (4), according to the present disclosure, include the same groups exemplified as the groups for the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₁ to R₆ in the general formula (3), according to present disclosure, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₇ to R₁₈ in the general formula (4), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. These groups may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Examples of the "aryloxy" in the "substituted or unsubstituted aryloxy" represented by R₇ to R₁₈ in the general formula (4), according to the present disclosure, include the same groups exemplified as the groups for the "aryloxy" in the "substituted or unsubstituted aryloxy" represented by R₁ to R₆ in the general formula (3), according to the present disclosure, and possible embodiments may also be the same embodiments as the exemplified embodiments.

In the general formula (4), according to the present disclosure, r₇ to r₁₈ may be the same or different, r₇, r₈, r₁₁, r₁₄, r₁₇, and r₁₈ representing an integer of 0 to 5, and r₉, r₁₀, r₁₂, r₁₃, r₁₅ and r₁₆ representing an integer of 0 to 4. When r₇, r₈, r₁₁, r₁₄, r₁₇, and r₁₈ is an integer of 2 to 5, or r₉, r₁₀, r₁₂, r₁₃, r₁₅ and r₁₆ is an integer of 2 to 4, R₇ to R₁₈, a plurality of which bind to the same benzene ring, may be the same or different and may bind to each other via a single bond, substituted or unsubstituted methylene, an oxygen atom, or a sulfur atom to form a ring.

Examples of the "divalent linking group" represented by L₂, L₃, and L₄ in the general formula (4), according to the present disclosure, include the same groups exemplified as the groups for the "divalent linking group" represented by L₁ in the general formula (3), according to the present disclosure, and possible embodiments may also be the same embodiments as the exemplified embodiments.

Specific examples of the "aromatic hydrocarbon", the "aromatic heterocyclic ring", or the "condensed polycyclic aromatics" of the "substituted or unsubstituted aromatic hydrocarbon", the "substituted or unsubstituted aromatic heterocyclic ring", or the "substituted or unsubstituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ in the general formula (5), according to the present disclosure, include benzene, biphenyl, terphenyl, tetrakisphenyl, styrene, naphthalene, anthracene, acenaphthalene, fluorene, phenanthrene, indane, pyrene, triphenylene, pyridine, pyrimidine, triazine, pyrrole, furan, thiophene, quinoline, isoquinoline, benzofuran, benzothiophene, indoline, carbazole, carboline, benzoxazole, benzothiazole, quinoxaline, benzimidazole, pyrazole, dibenzofuran, dibenzothiophene, naphthyridine, phenanthroline, and acridine.

The "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ in the general formula (5), according to the present disclosure, is a divalent group that results from the removal of two hydrogen atoms from the above "aromatic hydrocarbon", "aromatic heterocyclic ring", or "condensed polycyclic aromatics".

These divalent groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Specific examples of the "aromatic heterocyclic group" in the "substituted or unsubstituted aromatic heterocyclic group" represented by B in the general formula (5), according to the present disclosure, include triazinyl, pyridyl, pyrimidinyl, furyl, pyrrolyl, thienyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, naphthyridinyl, phenanthrolinyl, acridinyl, and carbolinyl.

Specific examples of the "substituent" in the "substituted aromatic heterocyclic group" represented by B in the general formula (5), according to the present disclosure, include a deuterium atom; cyano; nitro; halogen atoms such as a fluorine atom, a chlorine atom, a bromine atom, and an iodine atom; linear or branched alkyls of 1 to 6 carbon atoms such as methyl, ethyl, n-propyl, isopropyl, n-butyl, isobutyl, tert-butyl, n-pentyl, isopentyl, neopentyl, and n-hexyl; cycloalkyls of 5 to 10 carbon atoms such as cyclopentyl, cyclohexyl, 1-adamantyl, and 2-adamantyl; linear or branched alkyloxys of 1 to 6 carbon atoms such as methyloxy, ethyloxy, and propyloxy; cycloalkyloxys of 5 to 10 carbon atoms such as cyclopentyloxy, cyclohexyloxy, 1-adamantyloxy, and 2-adamantyloxy; alkenyls such as allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl; aryloxys such as phenyloxy, biphenylyloxy, naphthyloxy, anthracenyloxy, and phenanthrenyloxy; arylvinyls such as styryl and naphthylvinyl; and acyls such as acetyl and benzoyl. These substituents may be further substituted with the exemplified substituents above. These substituents may bind to each other via a single bond, substituted or unsubstituted methylene, an oxygen atom, or a sulfur atom to form a ring.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by C in the general formula (5), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. When a plurality of these groups binds to the same anthracene ring (when q is 2), these groups may be the same or different.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Specific examples of the "linear or branched alkyl of 1 to 6 carbon atoms" represented by D in the general formula (5), according to the present disclosure, include methyl, ethyl, n-propyl, isopropyl, n-butyl, isobutyl, tert-butyl, n-pentyl, isopentyl, neopentyl, and n-hexyl.

The plural groups represented by D may be the same or different, and may bind to each other via a single bond, substituted or unsubstituted methylene, an oxygen atom, or a sulfur atom to form a ring.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by D in the general formula (5), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. The plural groups represented by D may be the same or different, and may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₈, Ar₉, and Ar₁₀ in the general formula (6), according to the present invention, include phenyl, biphenylyl, terphenylyl, tetrakisphenyl, styryl, naphthyl, anthracenyl, acenaphthenyl, phenanthrenyl, fluorenyl, indenyl, pyrenyl, perylenyl, fluoranthenyl, triphenylenyl, spirobifluorenyl, furyl, thienyl, benzofuranyl, benzothienyl, dibenzofuranyl, and dibenzothienyl.

Specific examples of the "substituent" in the "substituted aromatic hydrocarbon group", the "substituted aromatic heterocyclic group", and the "substituted condensed polycyclic aromatic group" represented by Ar₈, Ar₉, and Ar₁₀ in the general formula (6), according to the present invention, include a deuterium atom; cyano; nitro; halogen atoms such as a fluorine atom, a chlorine atom, a bromine atom, and an iodine atom; linear or branched alkyls of 1 to 6 carbon atoms such as methyl, ethyl, n-propyl, isopropyl, n-butyl, isobutyl, tert-butyl, n-pentyl, isopentyl, neopentyl, and n-hexyl; linear or branched alkyloxys of 1 to 6 carbon atoms such as methyloxy, ethyloxy, and propyloxy; alkenyls such as vinyl and allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, triphenylenyl, and spirobifluorenyl; aromatic heterocyclic groups such as pyridyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, azafluorenyl, diazafluorenyl, carbolinyl, azaspirobifluorenyl, and diazaspirobifluorenyl; arylvinyls such as styryl and naphthylvinyl; and acyls such as acetyl and benzoyl. These substituents may be further substituted with the exemplified substituents above.

These substituents may bind to each other via a single bond, substituted or unsubstituted methylene, an oxygen atom, or a sulfur atom to form a ring. These substituents may bind to Ar₈, Ar₉, or Ar₁₀ that bind to the substituents, via an oxygen atom or a sulfur atom to form a ring.

Specific examples of the "aromatic heterocyclic group" in the "substituted or unsubstituted aromatic heterocyclic group" represented by Ar₁₁ in the structural formula (7), according to the present invention, include triazinyl, pyridyl, pyrimidinyl, furyl, pyrrolyl, thienyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, azafluorenyl, diazafluorenyl, naphthyridinyl, phenanthrolinyl, acridinyl, carbolinyl, azaspirobifluorenyl, and diazaspirobifluorenyl.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₈, Ar₉, or Ar₁₀ in the general formula (6), according to the present invention, and possible embodiments may also be the same embodiments as the exemplified embodiments.

Specific examples of the "linear or branched alkyl of 1 to 6 carbon atoms" represented by R₁₉ to R₂₂ in the structural formula (7), according to the present invention, include methyl, ethyl, n-propyl, i-propyl, n-butyl, 2-methylpropyl, t-butyl, n-pentyl, 3-methylbutyl, tert-pentyl, n-hexyl, iso-hexyl, and tert-hexyl.

Specific examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₁₉ to R₂₂ in the structural formula (7), according to the present invention, include phenyl, biphenylyl, terphenylyl, tetrakisphenyl, styryl, naphthyl, anthracenyl, acenaphthenyl, phenanthrenyl, fluorenyl, indenyl, pyrenyl, perylenyl, fluoranthenyl, triphenylenyl, spirobifluorenyl, triazinyl, pyridyl, pyrimidinyl, furyl, pyrrolyl, thienyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, azafluorenyl, diazafluorenyl, naphthyridinyl, phenanthrolinyl, acridinyl, carbolinyl, phenoxazinyl, phenothiazinyl, phenazinyl, azaspirobifluorenyl, and diazaspirobifluorenyl.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₈, Ar₉, or Ar₁₀ in the general formula (6), according to the present invention, and possible embodiments may also be the same embodiments as the exemplified embodiments.

Examples of the "aromatic hydrocarbon", the "aromatic heterocyclic ring", or the "condensed polycyclic aromatics" of the "substituted or unsubstituted aromatic hydrocarbon", the "substituted or unsubstituted aromatic heterocyclic ring", or the "substituted or unsubstituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₂ in the general formula (8), according to the present invention include the same groups exemplified as the groups for the "aromatic hydrocarbon", the "aromatic heterocyclic ring", or the "condensed polycyclic aromatics" of the "substituted or unsubstituted aromatic hydrocarbon", the "substituted or unsubstituted aromatic heterocyclic ring", or the "substituted or unsubstituted condensed polycyclic aromatics" in the "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₁ in the general formula (5), according to the present disclosure.

The "divalent group of a substituted or unsubstituted aromatic hydrocarbon", the "divalent group of a substituted or unsubstituted aromatic heterocyclic ring", or the "divalent group of substituted or unsubstituted condensed polycyclic aromatics" represented by A₂ in the general formula (8), according to the present invention, is a divalent group that results from the removal of two hydrogen atoms from the above "aromatic hydrocarbon", "aromatic heterocyclic ring", or "condensed polycyclic aromatics".

These divalent groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁₂ and Ar₁₃ in the general formula (8), according to the present invention, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention, and Ar₁₂ and Ar₁₃ may bind to each other via a single bond, substituted or unsubstituted methylene, an oxygen atom, or a sulfur atom to form a ring.

These groups may have a substituent, and examples of the substituent include the same substituents exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Specific examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₂₃ to R₂₉ in the general formula (8), according to the present invention, include methyl, ethyl, n-propyl, isopropyl, n-butyl, isobutyl, tert-butyl, n-pentyl, isopentyl, neopentyl, n-hexyl, cyclopentyl, cyclohexyl, 1-adamantyl, 2-adamantyl, vinyl, allyl, isopropenyl, and 2-butenyl. These groups may bind to each other via a single bond, substituted or unsubstituted methylene, an oxygen atom, or a sulfur atom to form a ring. These groups (R₂₃ to R₂₉) may bind to the benzene ring, to which these groups (R₂₃ to R₂₉) directly bind, via a linking group, such as substituted or unsubstituted methylene, an oxygen atom, a sulfur atom, or a monosubstituted amino group, to form a ring.

Specific examples of the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₂₃ to R₂₉ in the general formula (8), according to the present invention, include a deuterium atom; cyano; nitro; halogen atoms such as a fluorine atom, a chlorine atom, a bromine atom, and an iodine atom; linear or branched alkyloxys of 1 to 6 carbon atoms such as methyloxy, ethyloxy, and propyloxy; alkenyls such as allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl; disubstituted amino groups substituted by an aromatic hydrocarbon group or a condensed polycyclic aromatic group, such as diphenylamino and dinaphthylamino; disubstituted amino groups substituted by an aromatic heterocyclic group, such as dipyridylamino and dithienylamino; and disubstituted amino groups substituted by substituents selected from aromatic hydrocarbon groups, condensed polycyclic aromatic groups, and aromatic heterocyclic groups. These substituents may be further substituted with the exemplified substituents above. These substituents may bind to each other via a single bond, substituted or unsubstituted methylene, an oxygen atom, or a sulfur atom to form a ring.

Specific examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₂₃ to R₂₉ in the general formula (8), according to the present invention, include methyloxy, ethyloxy, n-propyloxy, isopropyloxy, n-butyloxy, tert-butyloxy, n-pentyloxy, n-hexyloxy, cyclopentyloxy, cyclohexyloxy, cycloheptyloxy, cyclooctyloxy, 1-adamantyloxy, and 2-adamantyloxy. These groups may bind to each other via a single bond, substituted or unsubstituted methylene, an oxygen atom, or a sulfur atom to form a ring. These groups (R₂₃ to R₂₉) may bind to the benzene ring, to which these groups (R₂₃ to R₂₉) directly bind, via a linking group, such as substituted or unsubstituted methylene, an oxygen atom, a sulfur atom, or a monosubstituted amino group, to form a ring.

These groups may have a substituent. Examples of the substituent include the same groups exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₂₃ to R₂₉ in the general formula (8), according to the present invention, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₂₃ to R₂₉ in the general formula (8), according to the present invention, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. These groups may bind to each other via a single bond, substituted or unsubstituted methylene, an oxygen atom, or a sulfur atom to form a ring. These groups (R₂₃ to R₂₉) may bind to the benzene ring, to which these groups (R₂₃ to R₂₉) directly bind, via a linking group, such as substituted or unsubstituted methylene, an oxygen atom, a sulfur atom, or a monosubstituted amino group, to form a ring.

Specific examples of the "substituent" in the "substituted or unsubstituted aromatic hydrocarbon group", the "substituted or unsubstituted aromatic heterocyclic group", and the "substituted or unsubstituted condensed polycyclic aromatic group" represented by R₂₃ to R₂₉ in the general formula (8), according to the present invention, include a deuterium atom; cyano; nitro; halogen atoms such as a fluorine atom, a chlorine atom, a bromine atom, and an iodine atom; linear or branched alkyls of 1 to 6 carbon atoms such as methyl, ethyl, n-propyl, isopropyl, n-butyl, isobutyl, tert-butyl, n-pentyl, isopentyl, neopentyl, and n-hexyl; linear or branched alkyloxys of 1 to 6 carbon atoms such as methyloxy, ethyloxy, and propyloxy; alkenyls such as allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl; arylvinyls such as styryl and naphthylvinyl; acyls such as acetyl and benzoyl; silyls, such as trimethylsilyl and triphenylsilyl; disubstituted amino groups substituted by an aromatic hydrocarbon group or a condensed polycyclic aromatic group, such as diphenylamino and dinaphthylamino; disubstituted amino groups substituted by an aromatic heterocyclic group, such as dipyridylamino and dithienylamino; and disubstituted amino groups substituted by substituents selected from aromatic hydrocarbon groups, condensed polycyclic aromatic groups, and aromatic heterocyclic groups. These substituents may be further substituted with the exemplified substituents above. These substituents may bind to each other via a single bond, substituted or unsubstituted methylene, an oxygen atom, or a sulfur atom to form a ring.

Specific examples of the "aryloxy group" in the "substituted or unsubstituted aryloxy group" represented by R₂₃ to R₂₉ in the general formula (8), according to the present invention, include phenyloxy, biphenylyloxy, terphenylyloxy, naphthyloxy, anthracenyloxy, phenanthrenyloxy, fluorenyloxy, indenyloxy, pyrenyloxy, and perylenyloxy. These groups may bind to each other via a single bond, substituted or unsubstituted methylene, an oxygen atom, or a sulfur atom to form a ring. These groups (R₂₃ to R₂₉) may bind to the benzene ring, to which these groups (R₂₃ to R₂₉) directly bind, via a linking group, such as substituted or unsubstituted methylene, an oxygen atom, a sulfur atom, or a monosubstituted amino group, to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by R₂₃ to R₂₉ in the general formula (8), according to the present invention, and possible embodiments may also be the same embodiments as the exemplified embodiments.

Examples of the "aromatic hydrocarbon group", the "aromatic heterocyclic group", or the "condensed polycyclic aromatic group" in the "disubstituted amino group substituted by substituents selected from aromatic hydrocarbon groups, condensed polycyclic aromatic groups, and aromatic heterocyclic groups" represented by R₂₃ to R₂₆ in the general formula (8), according to the present invention, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by R₂₃ to R₂₉ in the general formula (8), according to the present invention, and possible embodiments may also be the same embodiments as the exemplified embodiments.

As for the "disubstituted amino group substituted by substituents selected from aromatic hydrocarbon groups, condensed polycyclic aromatic groups, and aromatic heterocyclic groups" represented by R₂₃ to R₂₆ in the general formula (8), according to the present invention, these groups (R₂₃ to R₂₆) may bind to each other via a single bond, substituted or unsubstituted methylene, an oxygen atom, or a sulfur atom and via the "aromatic hydrocarbon group", the "aromatic heterocyclic group", or the "condensed polycyclic aromatic group" of these groups (R₂₃ to R₂₆) to form a ring, and these groups (R₂₃ to R₂₆) may bind to the benzene ring, to which these groups (R₂₃ to R₂₆) directly bind, via a linking group, such as substituted or unsubstituted methylene, an oxygen atom, a sulfur atom, or a monosubstituted amino group, and via the "aromatic hydrocarbon group", the "aromatic heterocyclic group", or the "condensed polycyclic aromatic group" of these groups (R₂₃ to R₂₆) to form a ring.

Examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₃₀ and R₃₁ in the general formula (8), according to the present invention, include the same groups exemplified as the groups for the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₂₃ to R₂₉ in the general formula (8), according to the present invention. These groups may bind to each other via a linking group, such as a single bond, substituted or unsubstituted methylene, an oxygen atom, a sulfur atom, or a monosubstituted amino group to form a ring.

These groups may have a substituent. Examples of the substituent include the same groups exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₂₃ to R₂₉ in the general formula (8), according to the present invention and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₃₀ and R₃₁ in the general formula (8), according to the present invention, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. These groups may bind to each other via a linking group, such as a single bond, substituted or unsubstituted methylene, an oxygen atom, a sulfur atom, or a monosubstituted amino group to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by R₂₃ to R₂₉ in the general formula (8), according to the present invention, and possible embodiments may also be the same embodiments as the exemplified embodiments.

Examples of the "aryloxy" in the "substituted or unsubstituted aryloxy" represented by R₃₀ and R₃₁ in the general formula (8), according to the present invention, include the same groups exemplified as the groups for the "aryloxy" in the "substituted or unsubstituted aryloxy" represented by R₂₃ to R₂₉ in the general formula (8), according to the present invention, and possible embodiments may also be the same embodiments as the exemplified embodiments. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by R₂₃ to R₂₉ in the general formula (8), according to the present invention, and possible embodiments may also be the same embodiments as the exemplified embodiments.

Examples of the "substituent" in the "monosubstituted amino group" as the linking group in the general formula (8), according to the present invention, include the same groups exemplified as the "linear or branched alkyl of 1 to 6 carbon atoms", the "cycloalkyl of 5 to 10 carbon atoms", the "aromatic hydrocarbon group", the "aromatic heterocyclic group", or the "condensed polycyclic aromatic group" in the "linear or branched alkyl of 1 to 6 carbon atoms that may have a substituent", the "cycloalkyl of 5 to 10 carbon atoms that may have a substituent", the "substituted or unsubstituted aromatic hydrocarbon group", the "substituted or unsubstituted aromatic heterocyclic group", or the "substituted or unsubstituted condensed polycyclic aromatic group" represented by R₂₃ to R₂₉ in the general formula (8), according to the present invention.

These groups may have a substituent. Examples of the substituent of the "linear or branched alkyl of 1 to 6 carbon atoms that has a substituent" and the "cycloalkyl of 5 to 10 carbon atoms that has a substituent" include the same groups exemplified as the "substituent" in the "linear or branched alkyl of 1 to 6 carbon atoms that has a substituent" or the "cycloalkyl of 5 to 10 carbon atoms that has a substituent" represented by R₂₃ to R₂₉ in the general formula (8), according to the present invention, and examples of the substituent of the "substituted aromatic hydrocarbon group", the "substituted aromatic heterocyclic group", or the "substituted condensed polycyclic aromatic group" include the same groups exemplified as the "substituent" in the "substituted aromatic hydrocarbon group", the "substituted aromatic heterocyclic group" represented by R₂₃ to R₂₉ in the general formula (8), according to the present invention, and possible embodiments may also be the same embodiments as the exemplified embodiments.

Ar₁ to Ar₄ in the general formula (1), according to the present invention, include the "substituted or unsubstituted aromatic hydrocarbon group", the "substituted or unsubstituted aromatic heterocyclic group", preferably a "substituted or unsubstituted sulfur-containing aromatic heterocyclic group", or the "substituted or unsubstituted condensed polycyclic aromatic group", and preferably, phenyl, biphenylyl, terphenylyl, naphthyl, phenanthryl, fluorenyl, or dibenzothienyl.

The "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, is preferably a deuterium atom, the "linear or branched alkyl of 1 to 6 carbon atoms that may have a substituent", the "linear or branched alkenyl of 2 to 6 carbon atoms that may have a substituent", the "substituted or unsubstituted aromatic hydrocarbon group", or the "substituted or unsubstituted condensed polycyclic aromatic group", and further preferably, a deuterium atom, phenyl, biphenylyl, naphthyl, or vinyl. It is preferable that these groups bind to each other via a single bond to form a condensed aromatic ring.

Examples of the electron acceptor, with which the arylamine compound represented by the general formula (1), according to the present invention, is doped, in the hole injection layer of the organic EL device of the present invention include trisbromophenylamine hexachloroantimony, tetracyanoquinodimethane (TCNQ), 2,3,5,6-tetrafluoro-tetracyano-1,4-benzoquinodimethane (F4TCNQ), and a radialene derivative (see, for example, JP-A-2011-100621), and the radialene derivative of the general formula (2), according to the present invention, is preferably used.

Ar₅ to Ar₇ in the general formula (2), according to the present invention, are preferably the "aromatic hydrocarbon group", the "condensed polycyclic aromatic group", or pyridyl, and further preferably phenyl, biphenylyl, terphenylyl, naphthyl, phenanthryl, fluorenyl, or pyridyl, and the "electron acceptor group" therein is preferably a fluorine atom, a chlorine atom, cyano, or trifluoromethyl.

An embodiment is preferable that Ar₅ to Ar₇ in the general formula (2), according to the present invention, are at least partially, preferably completely, substituted by the "electron acceptor group".

Ar₅ to Ar₇ in the general formula (2), according to the present invention, are preferably phenyl that is completely substituted by a fluorine atom, a chlorine atom, cyano, or trifluoromethyl, such as tetrafluoropyridyl, tetrafluoro(trifluoromethyl)phenyl, cyanotetrafluorophenyl, dichlorodifluoro(trifluoromethyl)phenyl, or pentafluorophenyl, or pyridyl.

R₁ to R₆ in the general formula (3), according to the present disclosure, are preferably a deuterium atom, the "linear or branched alkyl of 1 to 6 carbon atoms that may have a substituent", the "linear or branched alkenyl of 2 to 6 carbon atoms that may have a substituent", the "substituted or unsubstituted aromatic hydrocarbon group", or the "substituted or unsubstituted condensed polycyclic aromatic group", and further preferably, a deuterium atom, phenyl, biphenylyl, naphthyl, or vinyl. It is also preferable that these groups bind to each other via a single bond to form a condensed aromatic ring. A deuterium atom, phenyl, and biphenylyl are particularly preferable.

r₁ to r₆ in the general formula (3), according to the present disclosure, are preferably an integer of 0 to 3, and further preferably an integer of 0 to 2.

The "divalent linking group" represented by L₁ in the general formula (3), according to the present disclosure, is preferably methylene, the "cycloalkyl of 5 to 10 carbon atoms", the "divalent group of an aromatic hydrocarbon", or the "divalent group of condensed polycyclic aromatics", or a single bond, further preferably divalent groups represented by the following structural formulae (B) to (G), or a single bond, and particularly preferably a divalent group represented by the following structural formula (B).

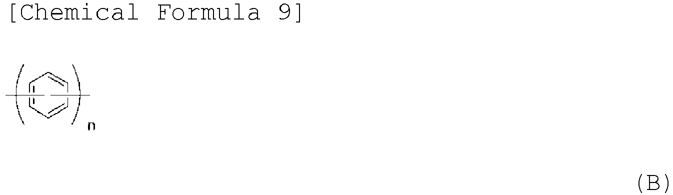

In the formula, n1 represents an integer of 1 to 3.

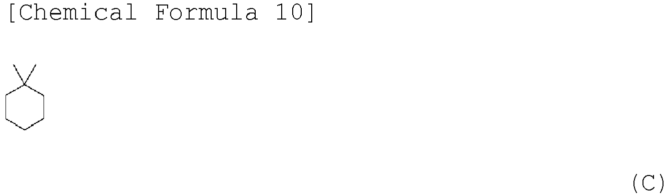

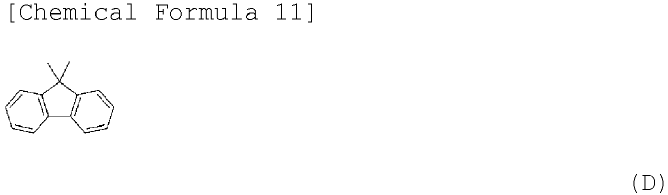

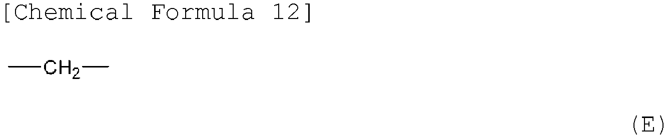

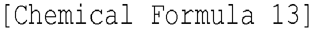

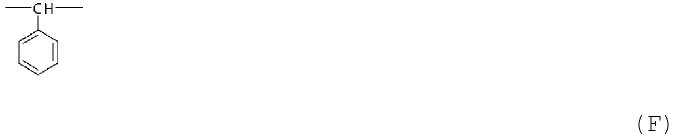

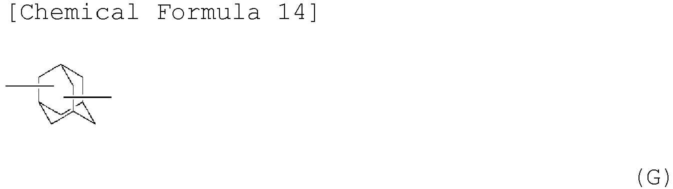

R₇ to R₁₈ in the general formula (4), according to the present disclosure, are preferably a deuterium atom, the "linear or branched alkyl of 1 to 6 carbon atoms that may have a substituent", the "linear or branched alkenyl of 2 to 6 carbon atoms that may have a substituent", the "substituted or unsubstituted aromatic hydrocarbon group", or the "substituted or unsubstituted condensed polycyclic aromatic group", and further preferably, a deuterium atom, phenyl, biphenylyl, naphthyl, or vinyl. It is also preferable that these groups bind to each other via a single bond to form a condensed aromatic ring. A deuterium atom, phenyl, and biphenylyl are particularly preferable.

r₇ to r₁₈ in the general formula (4), according to the present disclosure, are preferably an integer of 0 to 3, and further preferably an integer of 0 to 2.

The "divalent linking groups" represented by L₂ to L₄ in the general formula (4), according to the present disclosure, are preferably methylene, the "cycloalkyl of 5 to 10 carbon atoms", the "divalent group of an aromatic hydrocarbon", or the "divalent group of condensed polycyclic aromatics", or a single bond, and further preferably divalent groups represented by the structural formulae (B) to (G), or a single bond.

The "aromatic heterocyclic group" in the "substituted or unsubstituted aromatic heterocyclic group" represented by B in the general formula (5), according to the present disclosure, is preferably a nitrogen-containing aromatic heterocyclic group, such as pyridyl, pyrimidinyl, pyrrolyl, quinolyl, isoquinolyl, indolyl, carbazolyl, benzoxazolyl, benzothiazolyl, quinoxalinyl, benzoimidazolyl, pyrazolyl, or carbolinyl, and further preferably pyridyl, pyrimidinyl, quinolyl, isoquinolyl, indolyl, pyrazolyl, benzoimidazolyl, or carbolinyl.

For p and q in the general formula (5), according to the present disclosure, p represents 7 or 8, and q represents 1 or 2, while maintaining the relationship, in which the sum of p and q (p+q) is 9.

A₁ in the general formula (5), according to the present disclosure, is preferably the "divalent group of a substituted or unsubstituted aromatic hydrocarbon" or the "divalent group of substituted or unsubstituted condensed polycyclic aromatics", and further preferably divalent groups that result from the removal of two hydrogen atoms from benzene, biphenyl, naphthalene, or phenanthrene.

The compound having an anthracene ring structure of the general formula (5), according to the present disclosure, is, according to the present invention, a compound having an anthracene ring structure of the following general formula (5b). Other compounds, according to the present disclosure, having an anthracene ring structure, are the compounds represented by the following general formula (5a) or the following general formula (5c).

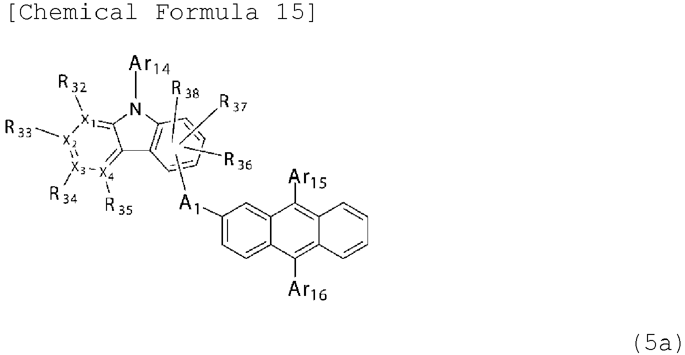

In the formula (5a), according to the disclosure, A₁ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond. Ar₁₄, Ar₁₅, and Ar₁₆ may be the same or different, and represent a substituted or unsubstituted aromatic hydrocarbon group, a substituted or unsubstituted aromatic heterocyclic group, or a substituted or unsubstituted condensed polycyclic aromatic group. R₃₂ to R₃₈ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, where these groups may bind to each other via a single bond, substituted or unsubstituted methylene, an oxygen atom, or a sulfur atom to form a ring. X₁, X₂, X₃, and X₄ represent a carbon atom or a nitrogen atom, and only one of X₁, X₂, X₃, and X₄ is a nitrogen atom. In this case, the nitrogen atom does not have the hydrogen atom or substituent for R₃₂ to R₃₅.

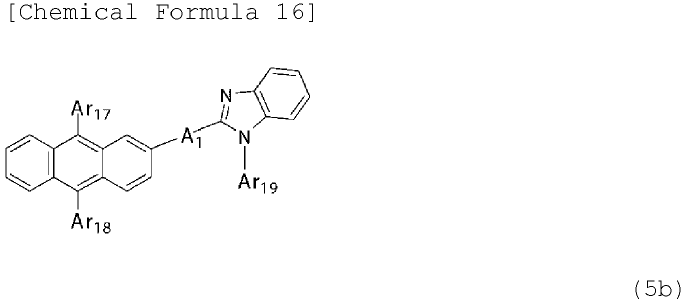

In the formula (5b), according to the present invention, A₁ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond. Ar₁₇, Ar₁₅, and Ar₁₉ may be the same or different, and represent a substituted or unsubstituted aromatic hydrocarbon group, a substituted or unsubstituted aromatic heterocyclic group, or a substituted or unsubstituted condensed polycyclic aromatic group.

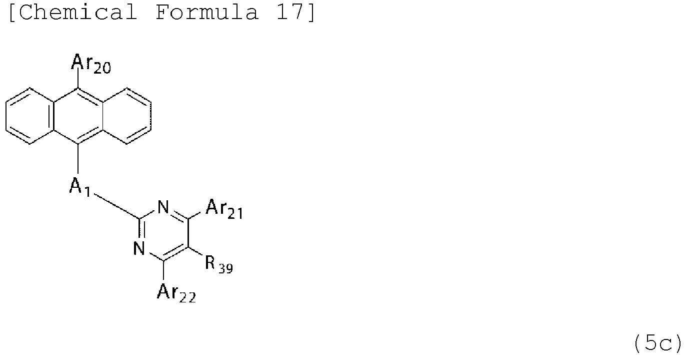

In the formula (5c), according to the present disclosure, A₁ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond. Ar₂₀, Ar₂₁, and Ar₂₂ may be the same or different, and represent a substituted or unsubstituted aromatic hydrocarbon group, a substituted or unsubstituted aromatic heterocyclic group, or a substituted or unsubstituted condensed polycyclic aromatic group. R₃₉ represents a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁₄, Ar₁₅, and Ar₁₆ in the general formula (5a), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Specific examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₃₂ to R₃₈ in the general formula (5a), according to the present disclosure, include methyl, ethyl, n-propyl, isopropyl, n-butyl, isobutyl, tert-butyl, n-pentyl, isopentyl, neopentyl, n-hexyl, cyclopentyl, cyclohexyl, 1-adamantyl, 2-adamantyl, vinyl, allyl, isopropenyl, and 2-butenyl. These groups may bind to each other via a single bond, substituted or unsubstituted methylene, an oxygen atom, or a sulfur atom to form a ring.

Specific examples of the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₃₂ to R₃₈ in the general formula (5a), according to the present disclosure, include a deuterium atom; cyano; nitro; halogen atoms such as a fluorine atom, a chlorine atom, a bromine atom, and an iodine atom; linear or branched alkyloxys of 1 to 6 carbon atoms such as methyloxy, ethyloxy, and propyloxy; alkenyls such as allyl; aryloxys such as phenyloxy and tolyloxy; arylalkyloxys such as benzyloxy and phenethyloxy; aromatic hydrocarbon groups or condensed polycyclic aromatic groups such as phenyl, biphenylyl, terphenylyl, naphthyl, anthracenyl, phenanthrenyl, fluorenyl, indenyl, pyrenyl, perylenyl, fluoranthenyl, and triphenylenyl; and aromatic heterocyclic groups such as pyridyl, pyrimidinyl, triazinyl, thienyl, furyl, pyrrolyl, quinolyl, isoquinolyl, benzofuranyl, benzothienyl, indolyl, carbazolyl, benzoxazolyl, benzothiazolyl, quinoxalinyl, benzoimidazolyl, pyrazolyl, dibenzofuranyl, dibenzothienyl, and carbolinyl. These substituents may be further substituted with the exemplified substituents above. These substituents may bind to each other via a single bond, substituted or unsubstituted methylene, an oxygen atom, or a sulfur atom to form a ring.

Specific examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₃₂ to R₃₈ in the general formula (5a), according to the present disclosure, include methyloxy, ethyloxy, n-propyloxy, isopropyloxy, n-butyloxy, tert-butyloxy, n-pentyloxy, n-hexyloxy, cyclopentyloxy, cyclohexyloxy, cycloheptyloxy, cyclooctyloxy, 1-adamantyloxy, and 2-adamantyloxy. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "linear or branched alkyl of 1 to 6 carbon atoms that has a substituent", the "cycloalkyl of 5 to 10 carbon atoms that has a substituent", or the "linear or branched alkenyl of 2 to 6 carbon atoms that has a substituent" represented by R₃₂ to R₃₈ in the general formula (5a), according to the present disclosure, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₃₂ to R₃₈ in the general formula (5a), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Specific examples of the "aryloxy group" in the "substituted or unsubstituted aryloxy group" represented by R₃₂ to R₃₈ in the general formula (5a), according to the present disclosure, include phenyloxy, biphenylyloxy, terphenylyloxy, naphthyloxy, anthracenyloxy, phenanthrenyloxy, fluorenyloxy, indenyloxy, pyrenyloxy, and perylenyloxy. These groups may bind to each other via a single bond, substituted or unsubstituted methylene, an oxygen atom, or a sulfur atom to form a ring.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

In the general formula (5a), according to the present disclosure, X₁, X₂, X₃, and X₄ represent a carbon atom or a nitrogen atom, and only one of X₁, X₂, X₃, and X₄ is a nitrogen atom (and the others are carbon atoms). In this case, the nitrogen atom does not have the hydrogen atom or substituent for R₃₂ to R₃₅. That is, R₃₂ does not exist when X₁ is a nitrogen atom, R₃₃ does not exist when X₂ is a nitrogen atom, R₃₄ does not exist when X₃ is a nitrogen atom, and R₃₅ does not exist when X₄ is a nitrogen atom.

In the general formula (5a), according to the present disclosure, it is preferable that X₃ is a nitrogen atom (and X₁, X₂, and X₄ are carbon atoms), and in this case, a hydrogen atom or substituent for R₃₄ does not exist.

The binding position of the linking group L₁ is preferably the position corresponding to the para-position of the nitrogen atom of the pyridoindole ring.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁₇, Ar₁₅, and Ar₁₉ in the general formula (5b), according to the present invention, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₂₀, Ar₂₁, and Ar₂₂ in the general formula (5c), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Examples of the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₃₉ in the general formula (5c), according to the present disclosure, include the same groups exemplified as the groups for the "linear or branched alkyl of 1 to 6 carbon atoms", the "cycloalkyl of 5 to 10 carbon atoms", or the "linear or branched alkenyl of 2 to 6 carbon atoms" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₃₂ to R₃₈ in the general formula (5a), according to the present disclosure.

These groups may have a substituent. Examples of the substituent include the same groups exemplified as the "substituent" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₃₂ to R₃₈ in the general formula (5a), according to the present disclosure, and possible embodiments may also be the same embodiments as the exemplified embodiments.

Examples of the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₃₉ in the general formula (5c), according to the present disclosure, include the same groups exemplified as the "substituent" in the "linear or branched alkyloxy of 1 to 6 carbon atoms" or the "cycloalkyloxy of 5 to 10 carbon atoms" in the "linear or branched alkyloxy of 1 to 6 carbon atoms that may have a substituent" or the "cycloalkyloxy of 5 to 10 carbon atoms that may have a substituent" represented by R₃₂ to R₃₈ in the general formula (5a), according to the present disclosure.

These groups may have a substituent. Examples of the substituent include the same groups exemplified as the "substituent" in the "linear or branched alkyl of 1 to 6 carbon atoms that may have a substituent", the "cycloalkyl of 5 to 10 carbon atoms that may have a substituent", or the "linear or branched alkenyl of 2 to 6 carbon atoms that may have a substituent" represented by R₃₂ to R₃₈ in the general formula (5a), according to the present disclosure, and possible embodiments may also be the same embodiments as the exemplified embodiments.

Examples of the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by R₃₉ in the general formula (5c), according to the present disclosure, include the same groups exemplified as the groups for the "aromatic hydrocarbon group", the "aromatic heterocyclic group", or the "condensed polycyclic aromatic group" in the "substituted or unsubstituted aromatic hydrocarbon group", the "substituted or unsubstituted aromatic heterocyclic group", or the "substituted or unsubstituted condensed polycyclic aromatic group" represented by Ar₁ to Ar₄ in the general formula (1), according to the present invention.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Examples of the "aryloxy group" in the "substituted or unsubstituted aryloxy group" represented by R₃₉ in the general formula (5c), according to the present disclosure, include the same groups exemplified as the groups for the "aryloxy group" in the "substituted or unsubstituted aryloxy group" represented by R₃₂ to R₃₈ in the general formula (5a), according to the present disclosure.

These groups may have a substituent. Examples of the substituent include the same groups exemplified as the "substituent" in the "substituted aromatic hydrocarbon group", the "substituted aromatic heterocyclic group", or the "substituted condensed polycyclic aromatic group" represented by Ar₁ to Ar₄ in the general formula (1), according to the present invention, and possible embodiments may also be the same embodiments as the exemplified embodiments.

Ar₈ in the general formula (6), according to the present invention, is preferably phenyl, biphenylyl, naphthyl, anthracenyl, acenaphthenyl, phenanthrenyl, fluorenyl, indenyl, pyrenyl, perylenyl, fluoranthenyl, triphenylenyl, spirobifluorenyl, an oxygen-containing aromatic heterocyclic group, such as furyl, benzofuranyl, and dibenzofuranyl, or a sulfur-containing aromatic heterocyclic group, such as thienyl, benzothienyl, and dibenzothienyl, and further preferably phenyl, biphenylyl, naphthyl, phenanthrenyl, fluorenyl, pyrenyl, fluoranthenyl, triphenylenyl, spirobifluorenyl, dibenzofuranyl, or dibenzothienyl. The phenyl group preferably has a substituted or unsubstituted condensed polycyclic aromatic group or a phenyl group as a substituent, and further preferably has a substituent selected from naphthyl, phenanthrenyl, pyrenyl, fluoranthenyl, triphenylenyl, spirobifluorenyl, or phenyl, and it is also preferable that the substituent of the phenyl group and the phenyl group bind to each other via an oxygen atom or a sulfur atom to form a ring.

Ar₉ in the general formula (6), according to the present invention, is preferably phenyl that has a substituent, substituted or unsubstituted spirobifluorenyl, an oxygen-containing aromatic heterocyclic group, such as furyl, benzofuranyl, and dibenzofuranyl, or a sulfur-containing aromatic heterocyclic group, such as thienyl, benzothienyl, and dibenzothienyl. The substituent of the phenyl in this case is preferably an aromatic hydrocarbon group, such as phenyl, biphenylyl, and terphenylyl, a condensed polycyclic aromatic group, such as naphthyl, acenaphthenyl, phenanthrenyl, fluorenyl, indenyl, pyrenyl, perylenyl, fluoranthenyl, triphenylenyl, and spirobifluorenyl, an oxygen-containing aromatic heterocyclic group, such as furyl, benzofuranyl, and dibenzofuranyl, or a sulfur-containing aromatic heterocyclic group, such as thienyl, benzothienyl, and dibenzothienyl, and further preferably phenyl, naphthyl, phenanthrenyl, fluorenyl, pyrenyl, fluoranthenyl, triphenylenyl, spirobifluorenyl, dibenzofuranyl, or dibenzothienyl, and it is also preferable that the substituent of the phenyl group and the phenyl group bind to each other via an oxygen atom or a sulfur atom to form a ring.

Ar₁₀ in the general formula (6), according to the present invention, is preferably a hydrogen atom, phenyl that has a substituent, substituted or unsubstituted spirobifluorenyl, an oxygen-containing aromatic heterocyclic group, such as furyl, benzofuranyl, and dibenzofuranyl, or a sulfur-containing aromatic heterocyclic group, such as thienyl, benzothienyl, and dibenzothienyl. The substituent of the phenyl in this case is preferably an aromatic hydrocarbon group, such as phenyl, biphenylyl, and terphenylyl, a condensed polycyclic aromatic group, such as naphthyl, acenaphthenyl, phenanthrenyl, fluorenyl, indenyl, pyrenyl, perylenyl, fluoranthenyl, triphenylenyl, and spirobifluorenyl, an oxygen-containing aromatic heterocyclic group, such as furyl, benzofuranyl, and dibenzofuranyl, or a sulfur-containing aromatic heterocyclic group, such as thienyl, benzothienyl, and dibenzothienyl, and further preferably phenyl, naphthyl, phenanthrenyl, fluorenyl, pyrenyl, fluoranthenyl, triphenylenyl, spirobifluorenyl, dibenzofuranyl, or dibenzothienyl, and it is also preferable that the substituent of the phenyl group and the phenyl group bind to each other via an oxygen atom or a sulfur atom to form a ring.

In the general formula (6), according to the present invention, it is preferable that Ar₈ and Ar₉ are not the same as each other from the viewpoint of thin film stability. In the case where Ar₈ and Ar₉ are the same groups, the groups may have different substituents and may be substituted on different positions.

In the general formula (6), according to the present invention, Ar₉ and Ar₁₀ may be the same groups, but there may be a possibility that the compound is easily crystallized due to the high symmetry of the entire molecule, and from the viewpoint of thin film stability, it is preferable that Ar₉ and Ar₁₀ are not the same as each other, and Ar₉ and Ar₁₀ are not simultaneously a hydrogen atom where A represents a monovalent group represented by the structural formula (7).

It is preferable that one of Ar₉ and Ar₁₀ is a hydrogen atom.

Examples of the compound of the general formula (6), according to the present invention, having a pyrimidine ring structure include compounds of the following general formula (6a) and general formula (6b) having pyrimidine ring structures with different bonding patterns of substituents.

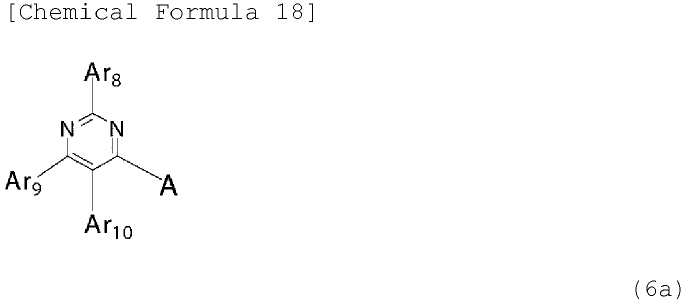

In the formula, Ar₈, Ar₉, Ar₁₀, and A have the same meanings as shown for the general formula (6), according to the present invention.

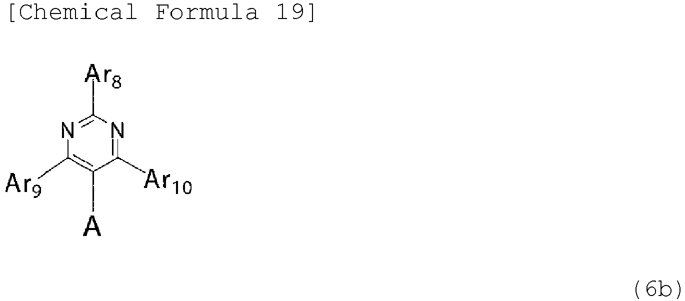

In the formula, Ar₈, Ar₉, Ar₁₀, and A have the same meanings as shown for the general formula (6), according to the present invention.

Ar₁₁ in the general formula (7), according to the present invention, is preferably a nitrogen-containing heterocyclic group, such as triazinyl, pyridyl, pyrimidinyl, pyrrolyl, quinolyl, isoquinolyl, indolyl, carbazolyl, benzoxazolyl, benzothiazolyl, quinoxalinyl, benzoimidazolyl, pyrazolyl, azafluorenyl, diazafluorenyl, naphthyridinyl, phenanthrolinyl, acridinyl, carbolinyl, azaspirobifluorenyl, and diazaspirobifluorenyl, further preferably triazinyl, pyridyl, pyrimidinyl, quinolyl, isoquinolyl, indolyl, quinoxalinyl, azafluorenyl, diazafluorenyl, benzoimidazolyl, naphthyridinyl, phenanthrolinyl, acridinyl, azaspirobifluorenyl, and diazaspirobifluorenyl, and particularly preferably pyridyl, pyrimidinyl, quinolyl, isoquinolyl, indolyl, azafluorenyl, diazafluorenyl, quinoxalinyl, benzoimidazolyl, naphthyridinyl, phenanthrolinyl, acridinyl, azaspirobifluorenyl, and diazaspirobifluorenyl.

In the general formula (7), according to the present invention, the binding position of Ar₁₁ on the benzene ring is preferably the meta-position with respect to the binding position to the pyrimidine ring of the general formula (6), according to the present invention, as shown in the following structural formula (7a), according to the present invention, from the viewpoint of thin film stability.

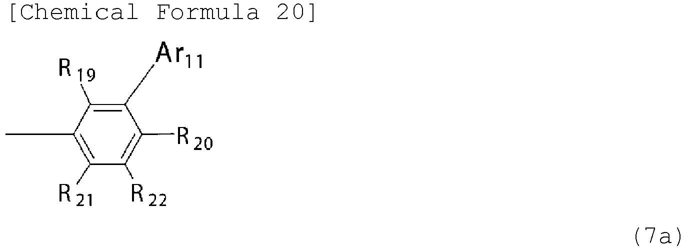

In the formula, Ar₁₁ and R₁₉ to R₂₂ have the same meanings as shown for the general formula (7), according to the present invention.

A₂ in the general formula (8), according to the present invention, is preferably the "divalent group of a substituted or unsubstituted aromatic hydrocarbon" or a single bond, further preferably a divalent group that results from the removal of two hydrogen atoms from benzene, biphenyl, or naphthalene, or a single bond, and particularly preferably a single bond.

Ar₁₂ and Ar₁₃ in the general formula (8), according to the present invention, are preferably phenyl, biphenylyl, naphthyl, fluorenyl, indenyl, pyridyl, dibenzofuranyl, or pyridobenzofuranyl.

Ar₁₂ and Ar₁₃ in the general formula (8), according to the present invention, may bind to each other via a single bond, substituted or unsubstituted methylene, an oxygen atom, or a sulfur atom and via the substituent of these groups or directly to form a ring.

In the general formula (8), according to the present invention, at least one of R₂₃ to R₂₆ is preferably the "disubstituted amino group substituted by groups selected from an aromatic hydrocarbon group, an aromatic heterocyclic group, and a condensed polycyclic aromatic group", and the "aromatic hydrocarbon group", the "aromatic heterocyclic group", and the "condensed polycyclic aromatic group" in this case are preferably phenyl, biphenylyl, naphthyl, fluorenyl, indenyl, pyridyl, dibenzofuranyl, or pyridobenzofuranyl.

In the general formula (8), according to the present invention, an embodiment where adjacent two or all of R₂₃ to R₂₆ are vinyls, and the adjacent vinyls bind to each other via a single bond to form a condensed ring, that is an embodiment where the groups form a naphthalene ring or a phenanthrene ring with the benzene ring, to which R₂₃ to R₂₆ bind, is also preferable.

In the general formula (8), according to the present invention, an embodiment where any one of R₂₃ to R₂₆ is the "aromatic hydrocarbon group", and binds to the benzene ring, to which R₂₃ to R₂₆ bind, via substituted or unsubstituted methylene, an oxygen atom, or a sulfur atom to form a ring is preferable. In this case, an embodiment where the "aromatic hydrocarbon group" is phenyl, and binds to the benzene ring, to which R₂₃ to R₂₆ bind, via an oxygen atom or a sulfur atom to form a ring, that is an embodiment where the group forms a dibenzofuran ring or a dibenzothiophene ring with the benzene ring, to which R₂₃ to R₂₆ bind, is particularly preferable.

In the general formula (8), according to the present invention, an embodiment where any one of R₂₇ to R₂₉ is the "aromatic hydrocarbon group", and binds to the benzene ring, to which R₂₇ to R₂₉ bind, via substituted or unsubstituted methylene, an oxygen atom, or a sulfur atom to form a ring is preferable. In this case, an embodiment where the "aromatic hydrocarbon group" is phenyl, and binds to the benzene ring, to which R₂₇ to R₂₉ bind, via an oxygen atom or a sulfur atom to form a ring, that is an embodiment where the group forms a dibenzofuran ring or a dibenzothiophene ring is particularly preferable.

In the amine derivative having a condensed ring structure of the general formula (8), according to the present invention, as the embodiment where R₂₃ to R₂₉ bind to each other to form a ring, or the embodiment where R₂₃ to R₂₉ bind to the benzene rings, to which R₂₃ to R₂₉ bind, to form a ring, as described above, embodiments of the following general formulae (8a-a), (8a-b), (8b-a), (8b-b), (8b-c), (8b-d), (8c-a), and (8c-b) are preferably used.

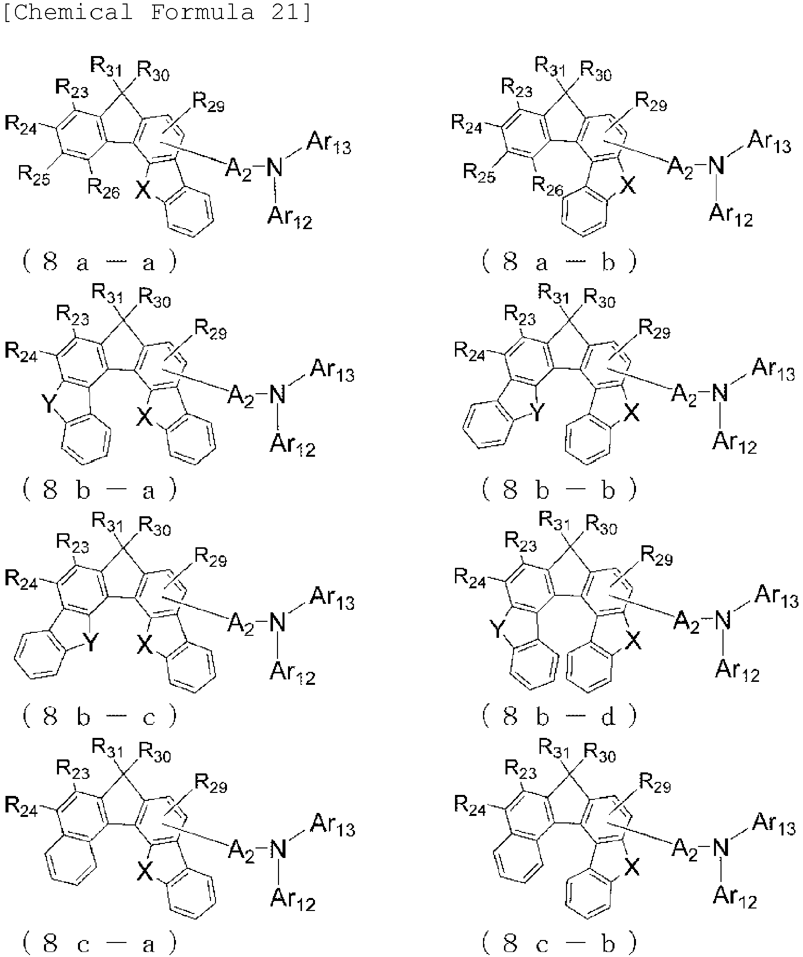

In the formulae, X and Y may be the same or different and represent an oxygen atom or a sulfur atom, and A₂, Ar₁₂, Ar₁₃, R₂₃ to R₂₆, R₂₉, and R₃₀ to R₃₁ have the same meanings as shown for the general formula (8), according to the present invention.

R₃₀ and R₃₁ in the general formula (8), according to the present invention, are preferably the "substituted or unsubstituted aromatic hydrocarbon group", the "substituted or unsubstituted aromatic heterocyclic group", or the "substituted or unsubstituted condensed polycyclic aromatic group", further preferably phenyl, naphthyl, phenanthrenyl, pyridyl, quinolyl, isoquinolyl, or dibenzofuranyl, and particularly preferably phenyl.

An embodiment where R₃₀ and R₃₁ bind to each other via a linking group, such as a single bond, substituted or unsubstituted methylene, an oxygen atom, a sulfur atom, or a monosubstituted amino group to form a ring is preferable, and an embodiment where the groups bind to each other via a single bond to form a ring is particularly preferable.

In the amine derivative having a condensed ring structure of the general formula (8), according to the present invention, as the embodiment where R₃₀ and R₃₁ bind to each other to form a ring as described above, embodiments of the following general formulae (8a-a1), (8a-b1), (8b-a1), (8b-b1), (8b-c1), (8b-d1), (8c-a1), and (8c-b1) are preferably used.

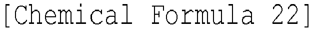

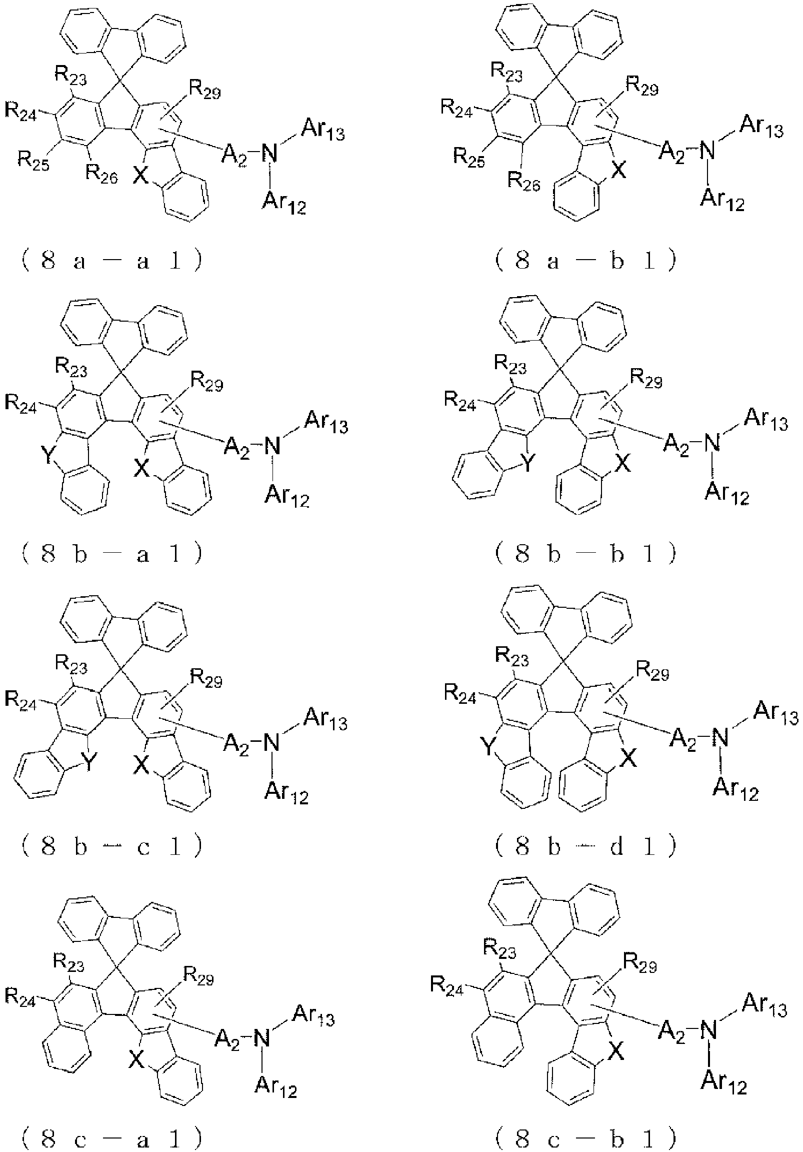

In the formulae, X and Y may be the same or different and represent an oxygen atom or a sulfur atom, and A₂, Ar₁₂, Ar₁₃, R₂₃ to R₂₆, and R₂₉ have the same meanings as shown for the general formula (8), according to the present invention.

The arylamine compound of the general formula (1), according to the invention, preferably used in the organic EL device of the present invention can be used as a constitutive material of a hole injection layer or a hole transport layer of an organic EL device. The compound has high hole mobility and is a preferred compound as a material of a hole injection layer or a hole transport layer.

The radialene derivative of the general formula (2), according to the present invention, preferably used in the organic EL device of the present invention is a preferred compound as a p-type doping material for a material generally used in a hole injection layer or a hole transport layer of an organic EL device.

According to the present disclosure, the arylamine compound of general formula (3) having two triphenylamine structures in the molecule and the arylamine compound of general formula (4) having four triphenylamine structures in the molecule are other constitutive materials of a hole injection layer or a hole transport layer of an organic EL device that can be used in organic EL devices.

The compound of the general formula (5b), according to the present invention, having an anthracene ring structure preferably used in the organic EL device of the present invention is a preferred compound as a constitutive material of an electron transport layer of an organic EL device.

The compound of the general formula (6), according to the present invention, having a pyrimidine ring structure preferably used in the organic EL device of the present invention is a preferred compound as a constitutive material of an electron transport layer of an organic EL device.

The amine derivative of the general formula (8), according to the present invention, having a condensed ring structure preferably used in the organic EL device of the present invention can be used as a constitutive material of a light emitting layer of an organic EL device. The compound is excellent in light emission efficiency as compared to the ordinary materials, and is a preferred compound as a dopant material for a light emitting layer.

The organic EL device of the present invention combines the materials for an organic EL device excellent in hole injection/transport performances, stability and durability as a thin film, taking the carrier balance into consideration. Therefore, as compared to the ordinary organic EL devices, the hole transport efficiency from the anode to the light emitting layer is improved (and furthermore the particular arylamine compound (having the particular structure) is used in the hole transport layer), and thereby the luminous efficiency is improved, and the durability of the organic EL device is improved, while retaining the lower driving voltage.

Thus, an organic EL device having a low driving voltage, a high light emission efficiency, and a long lifetime can be attained.

### Effects of the Invention

The organic EL device of the present invention can achieve an organic EL device having excellent hole injection/transport performance, low driving voltage, and high luminous efficiency, as a result of attaining efficient hole injection/transport from the electrode to the hole transport layer, by selecting the particular arylamine compound (having the particular structure) that can effectively achieve the hole injection/transport roles, as the material of the hole injection layer, and subjecting the electron acceptor to p-type doping.

An organic EL device having high efficiency, low driving voltage and a long lifetime can be achieved as a result of attaining good carrier balance, by selecting the particular arylamine compound (having the particular structure) without p-type doping as the material of the hole injection layer.

The organic EL device of the present invention can improve the luminous efficiency, particularly the durability, while retaining the low driving voltage of the conventional organic EL devices.

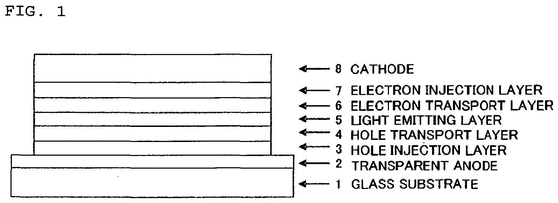

FIG. 1 is a diagram illustrating the configuration of the organic EL devices of Examples 52 to 59 and Comparative Examples 1 to 8.

The following presents specific examples of preferred compounds among the arylamine compounds of the general formula (1), according to the present invention, preferably used in the organic EL device of the present invention. The present invention, however, is not restricted to these compounds.

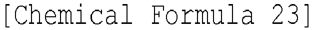

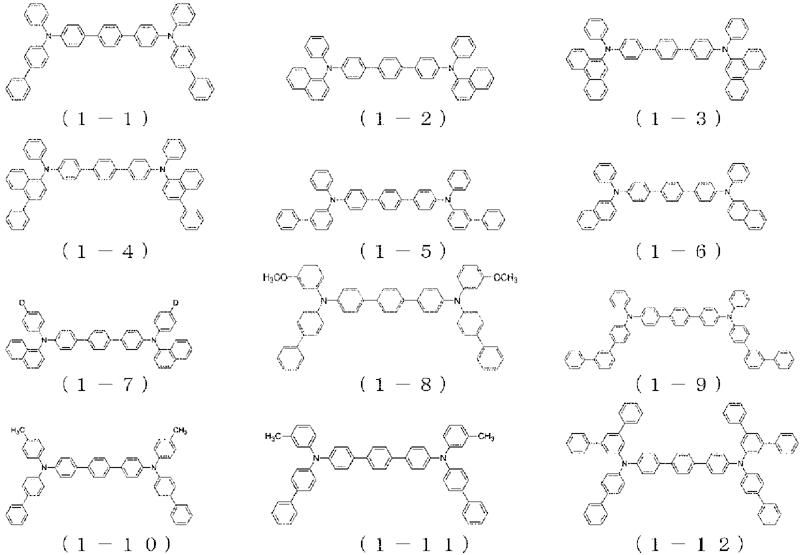

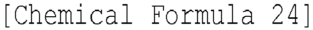

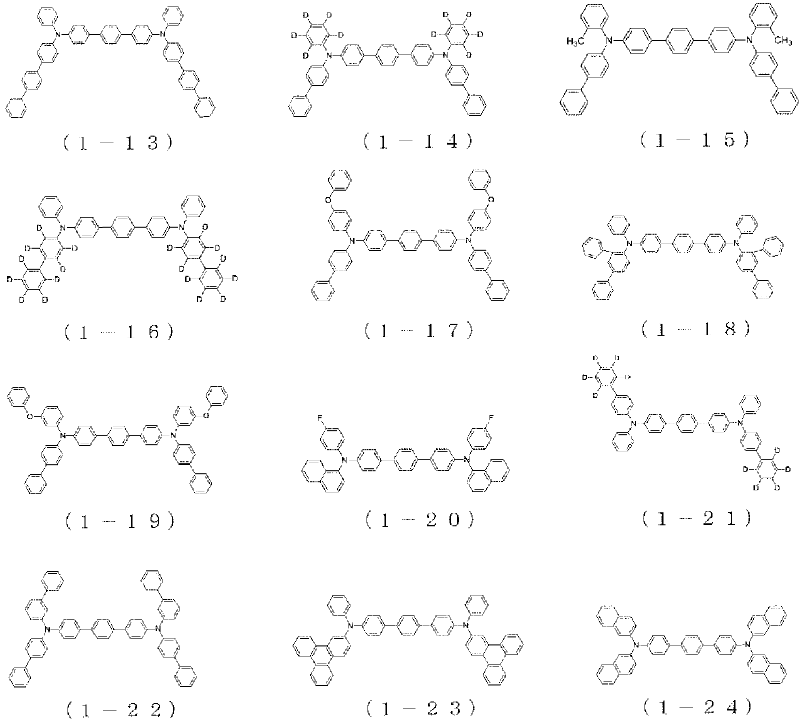

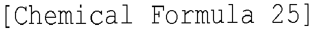

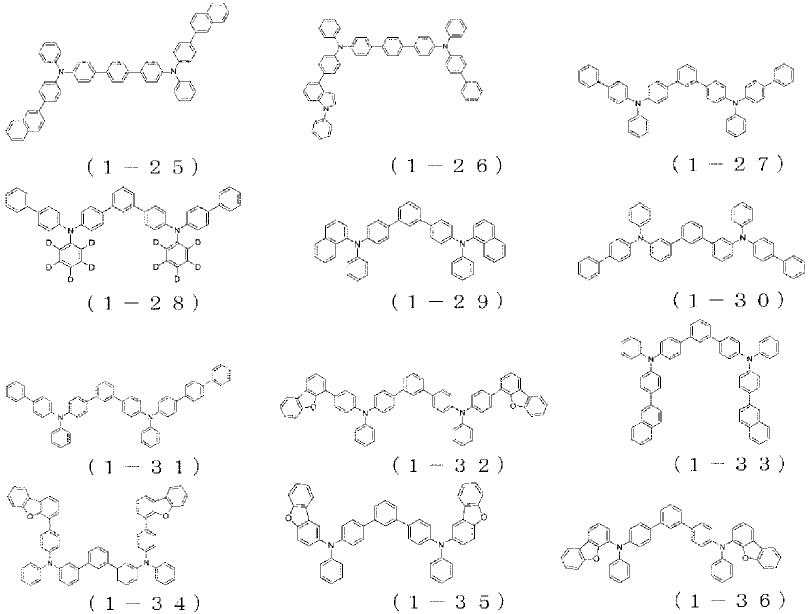

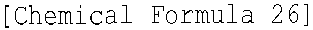

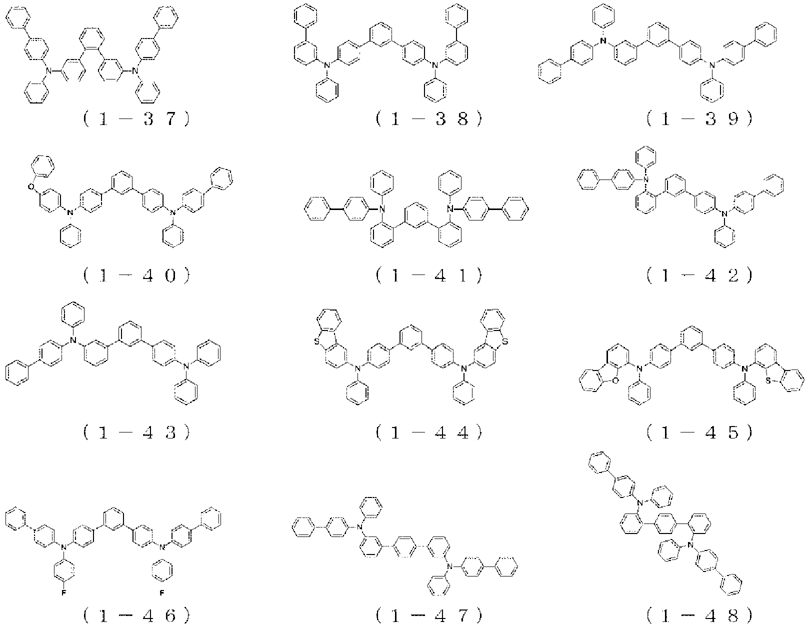

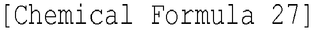

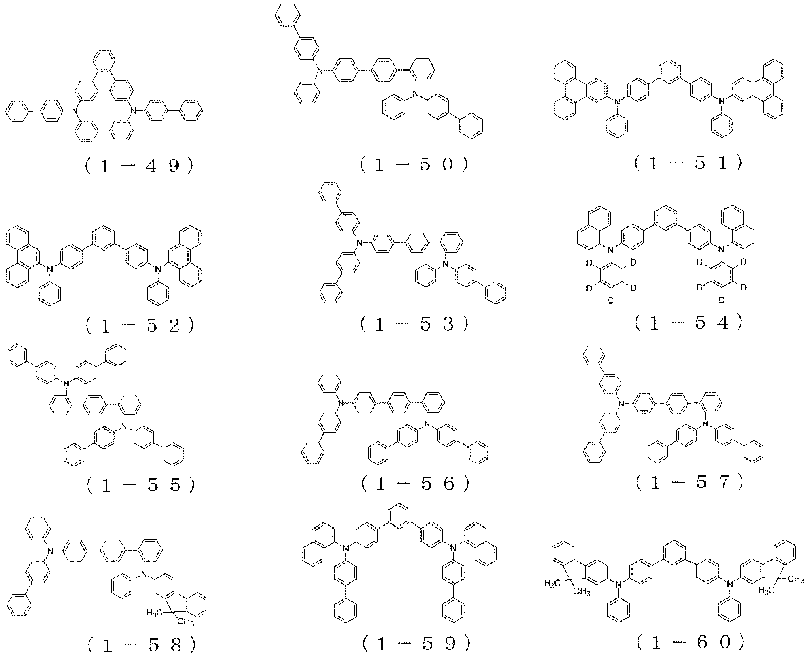

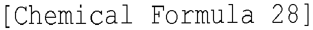

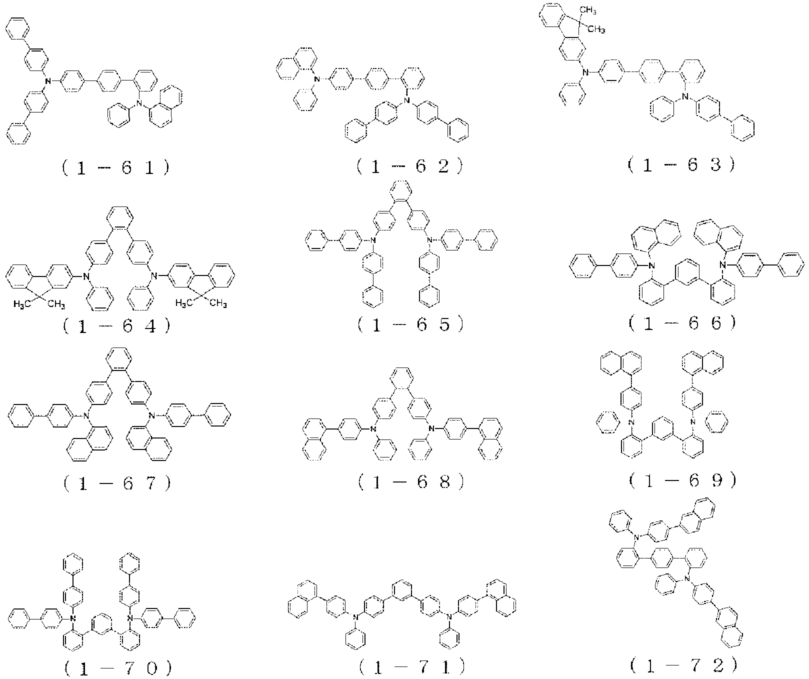

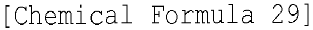

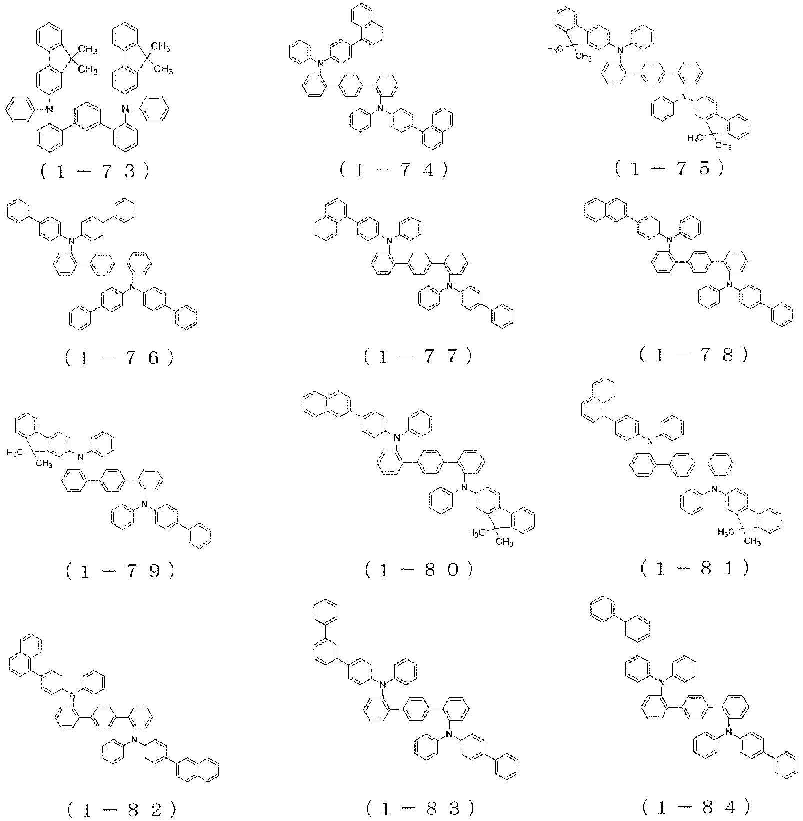

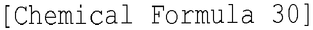

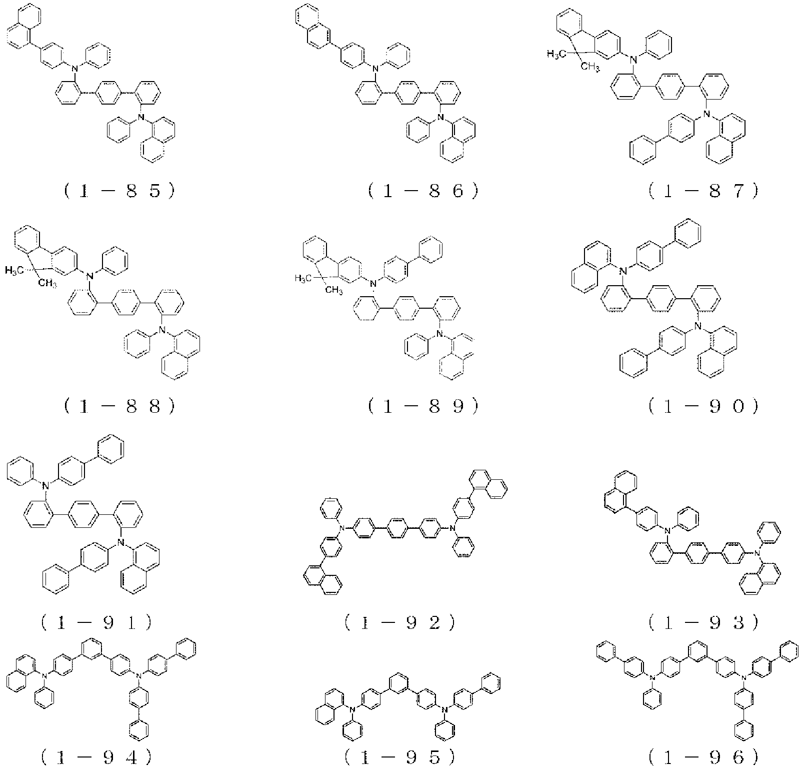

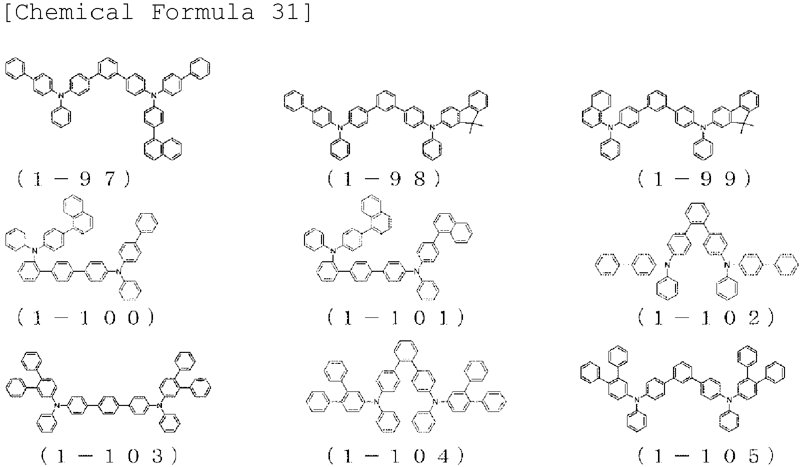

The arylamine compounds described above can be synthesized according to the known methods (refer to Patent Document 7, for example).

The following presents reference examples of preferred compounds among the arylamine compounds of the general formula (3), according to the present disclosure, used in organic EL devices.

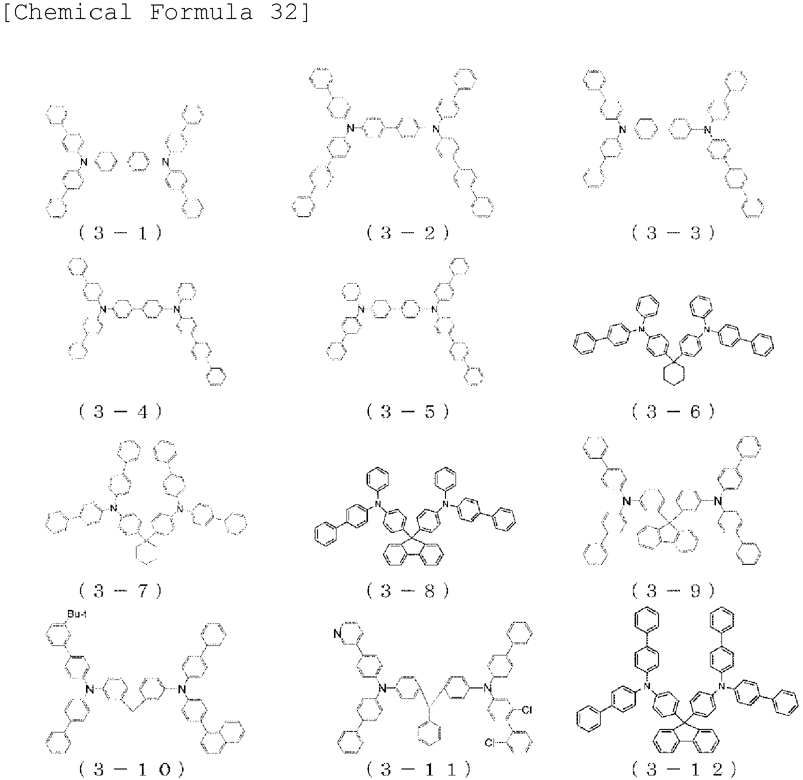

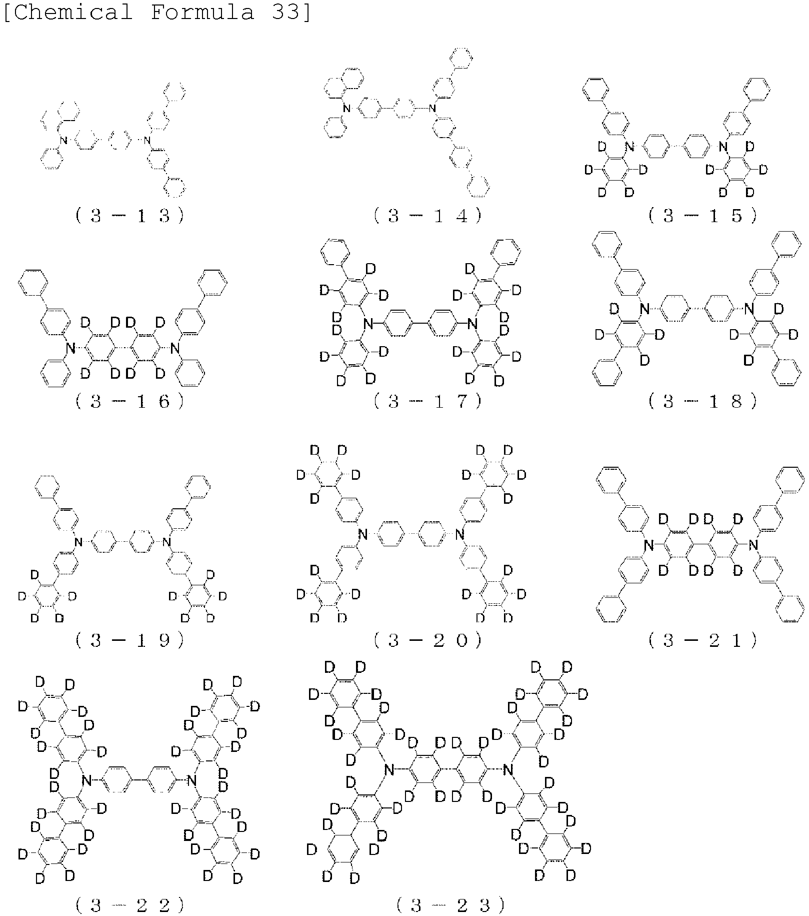

The following presents reference examples of preferred compounds of the arylamine compounds having two triphenylamine structures in the molecule among the triphenylamine compounds having a structure in which two to six triphenylamine structures in the molecule bind via a single bond or a divalent group that does not contain a heteroatom used in organic EL devices, in addition to the arylamine compounds of general formula (3), according to the present disclosure.

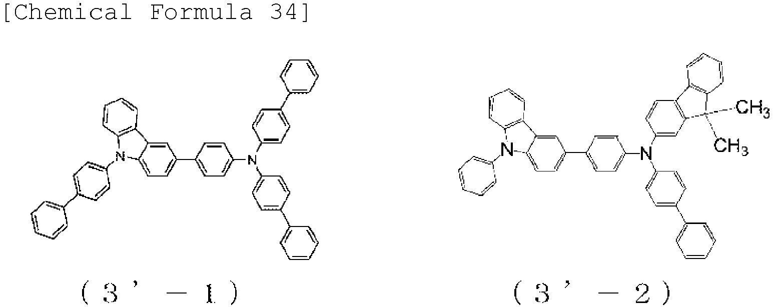

The following presents reference examples of preferred compounds among the arylamine compounds of the general formula (4), according to the present disclosure, used in organic EL devices.

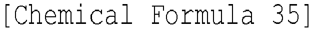

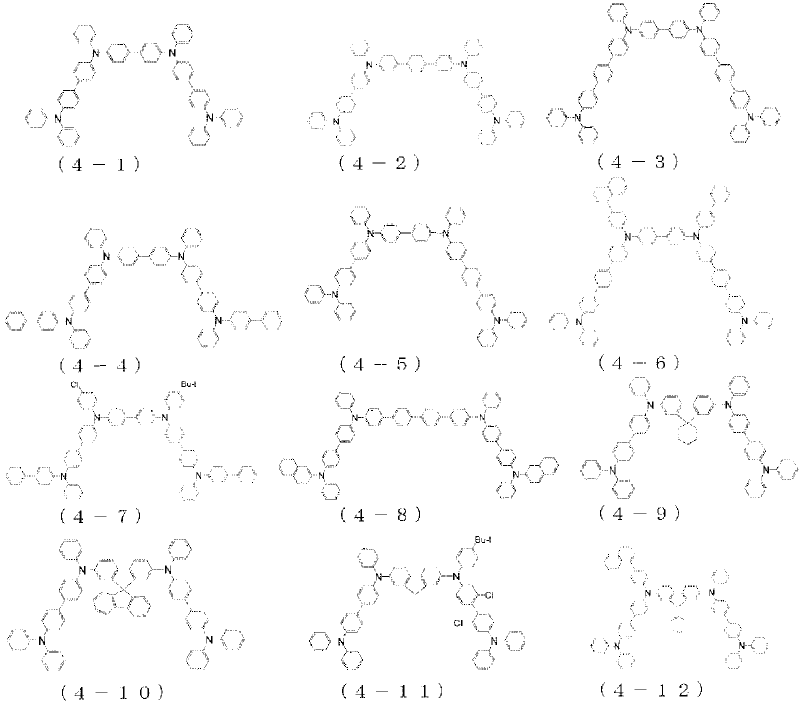

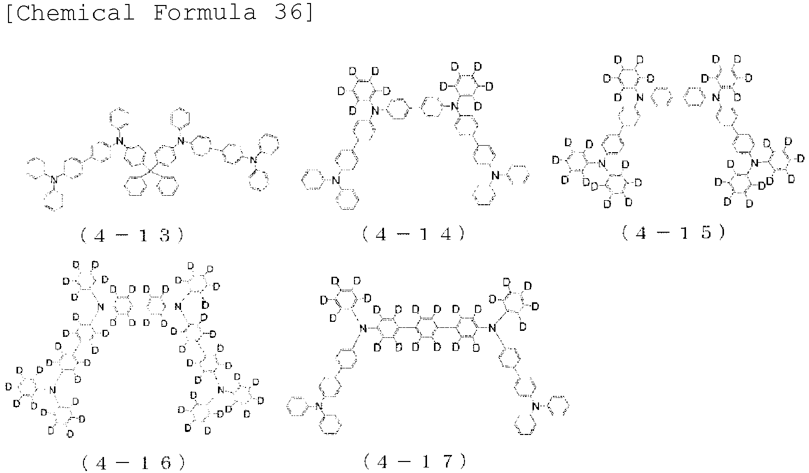

The arylamine compounds of the general formula (3), according to the present disclosure, and the arylamine compounds of the general formula (4), according to the present disclosure, can be synthesized by a known method (refer to Patent Documents 8 to 10, for example).

The following presents reference examples of preferred compounds among the compounds of the general formula (5a), according to the present disclosure, used in organic EL devices and having an anthracene ring structure.

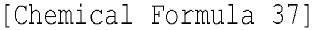

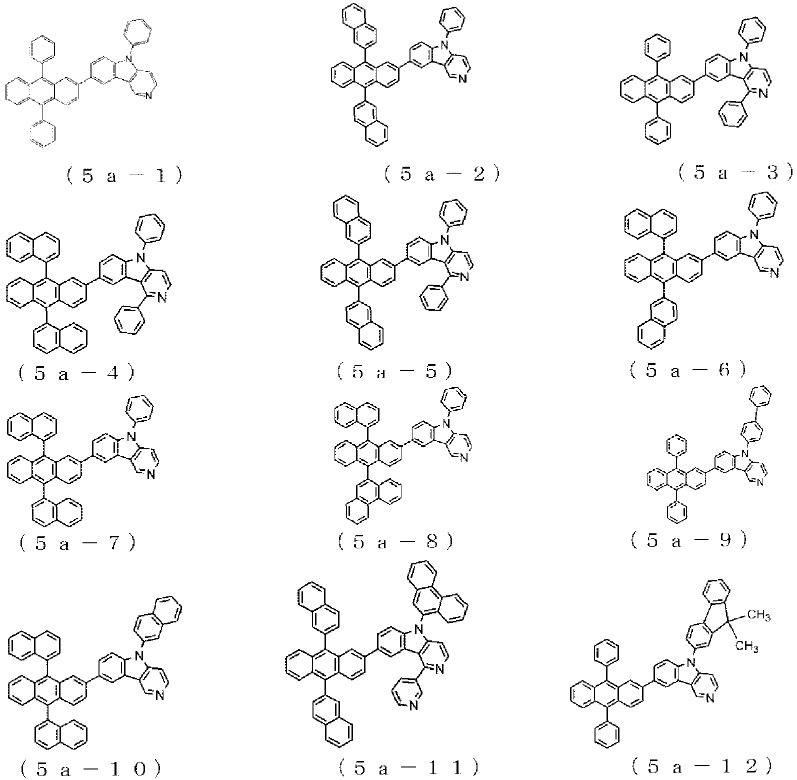

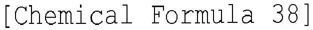

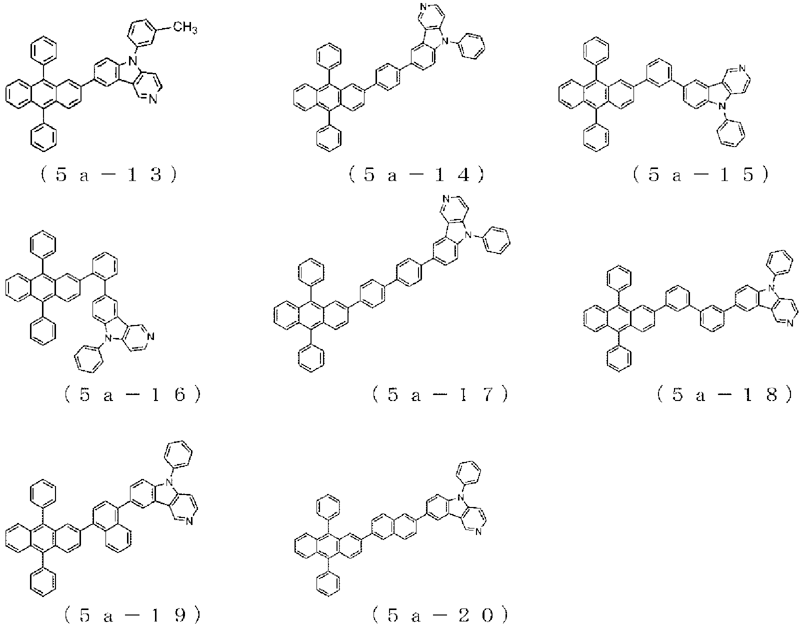

The following presents specific examples of preferred compounds among the compounds of the general formula (5b), according to the present invention, preferably used in the organic EL device of the present invention and having an anthracene ring structure. The present invention, however, is not restricted to these compounds.

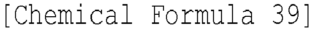

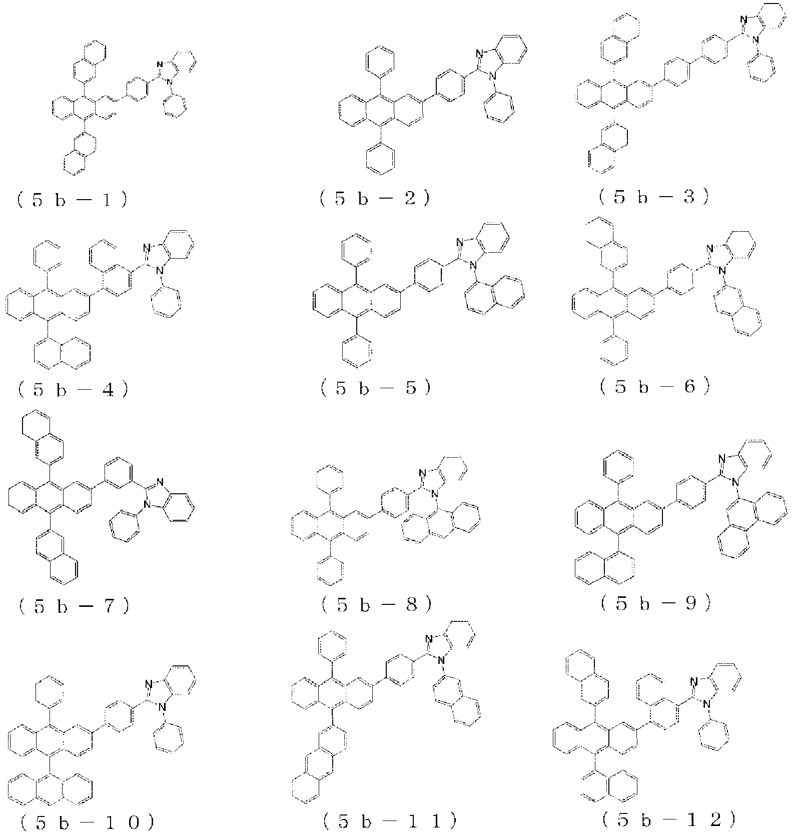

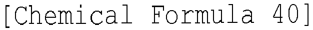

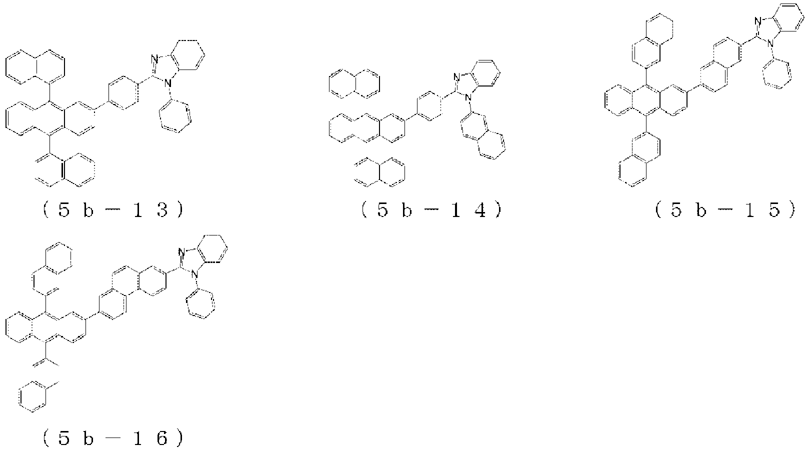

The following presents reference examples of preferred compounds among the compounds of the general formula (5c), according to the present disclosure, used in organic EL devices and having an anthracene ring structure.

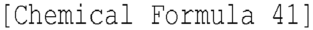

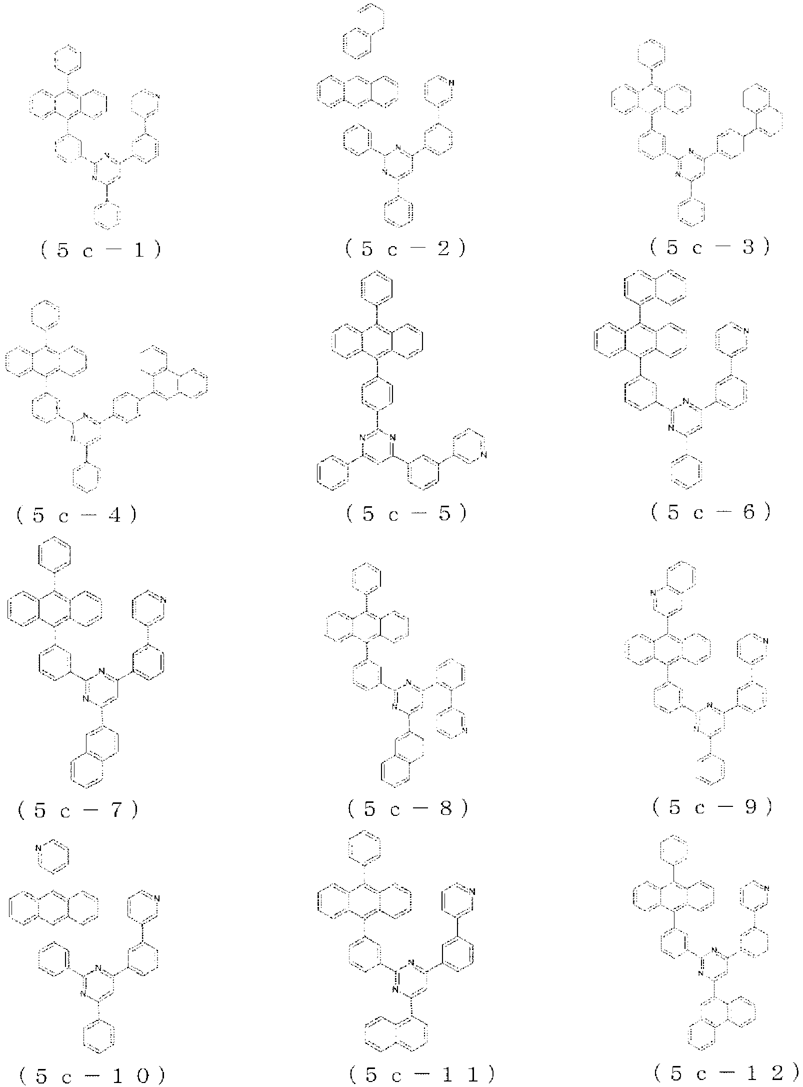

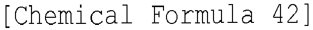

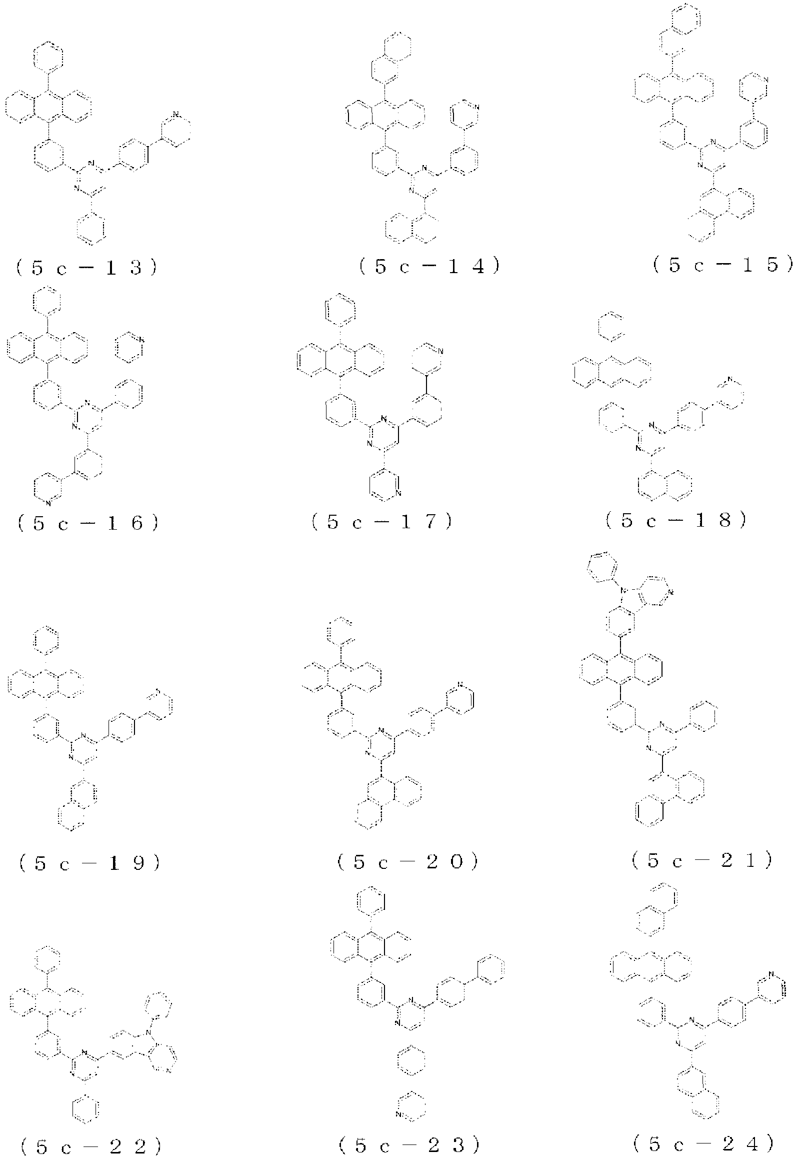

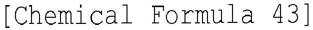

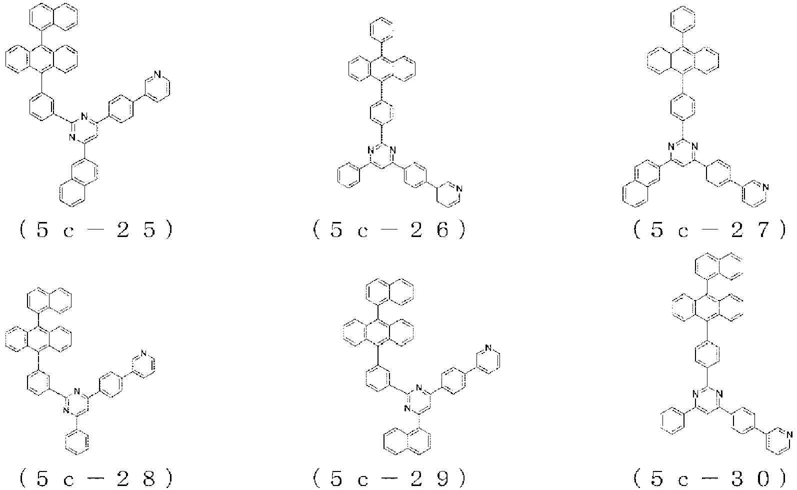

The compounds described above having an anthracene ring structure can be synthesized by a known method (refer to Patent Documents 11 to 13, for example).

The following presents specific examples of preferred compounds among the compounds of the general formula (6), according to the present invention, preferably used in the organic EL device of the present invention and having a pyrimidine ring structure. The present invention, however, is not restricted to these compounds.

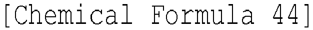

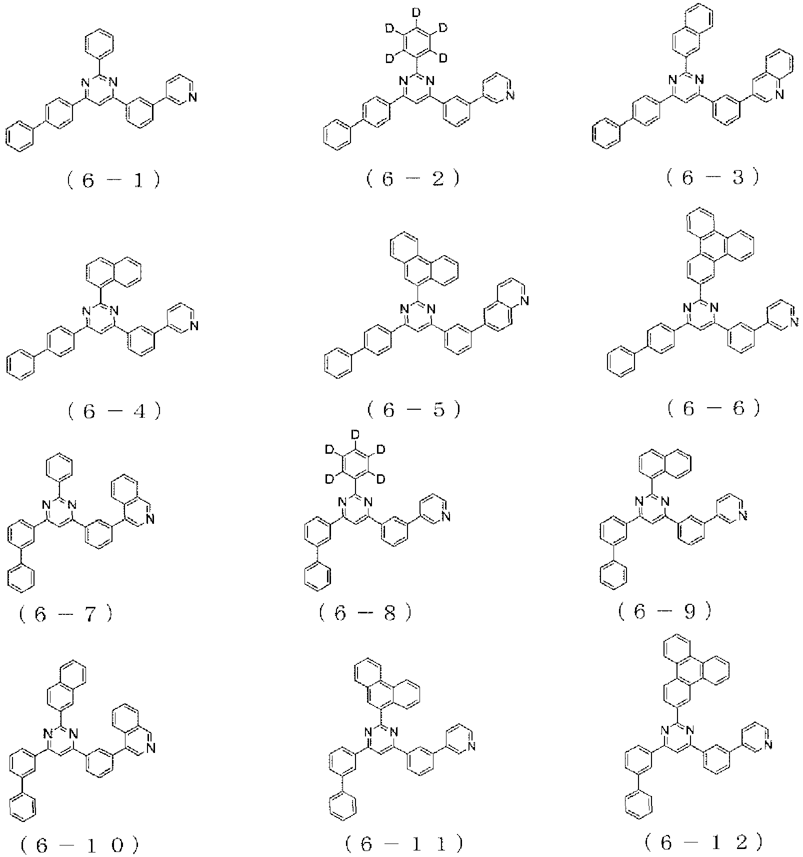

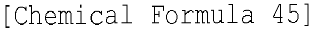

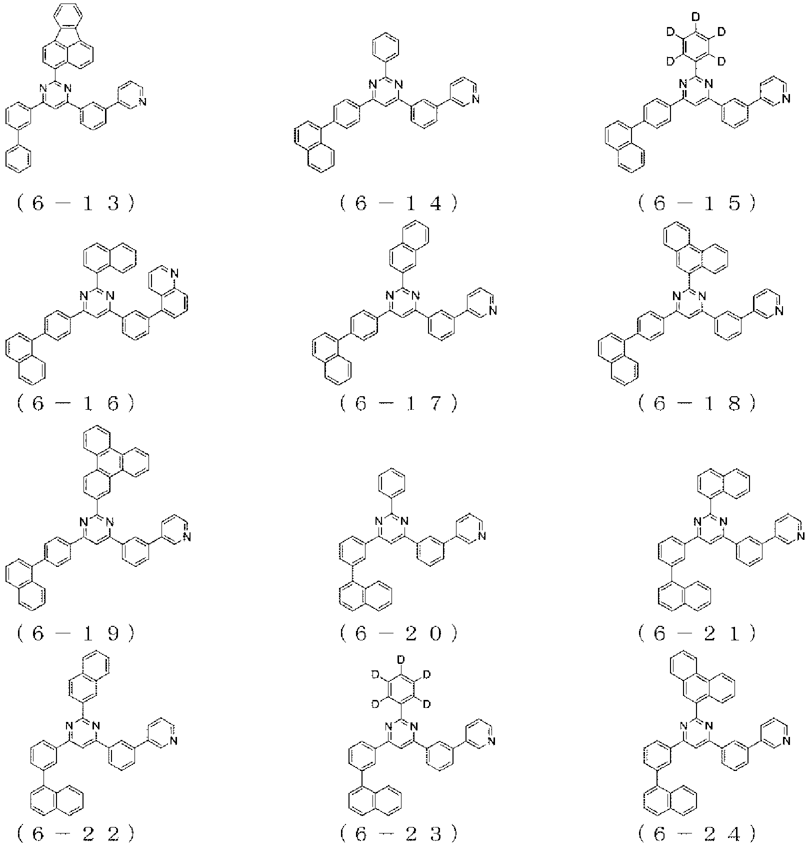

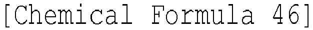

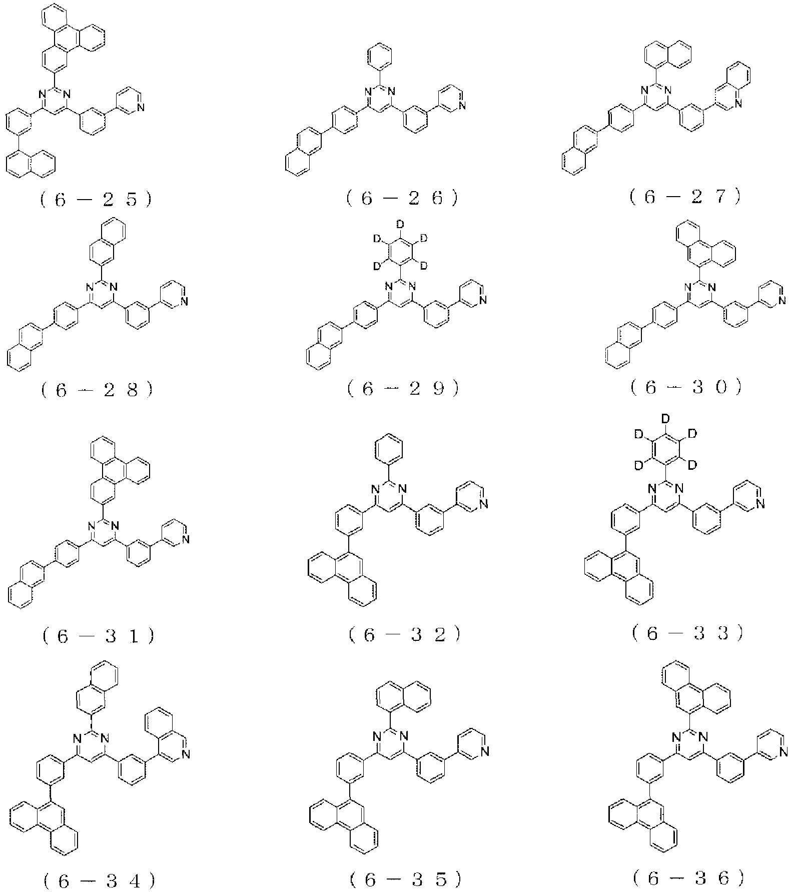

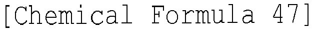

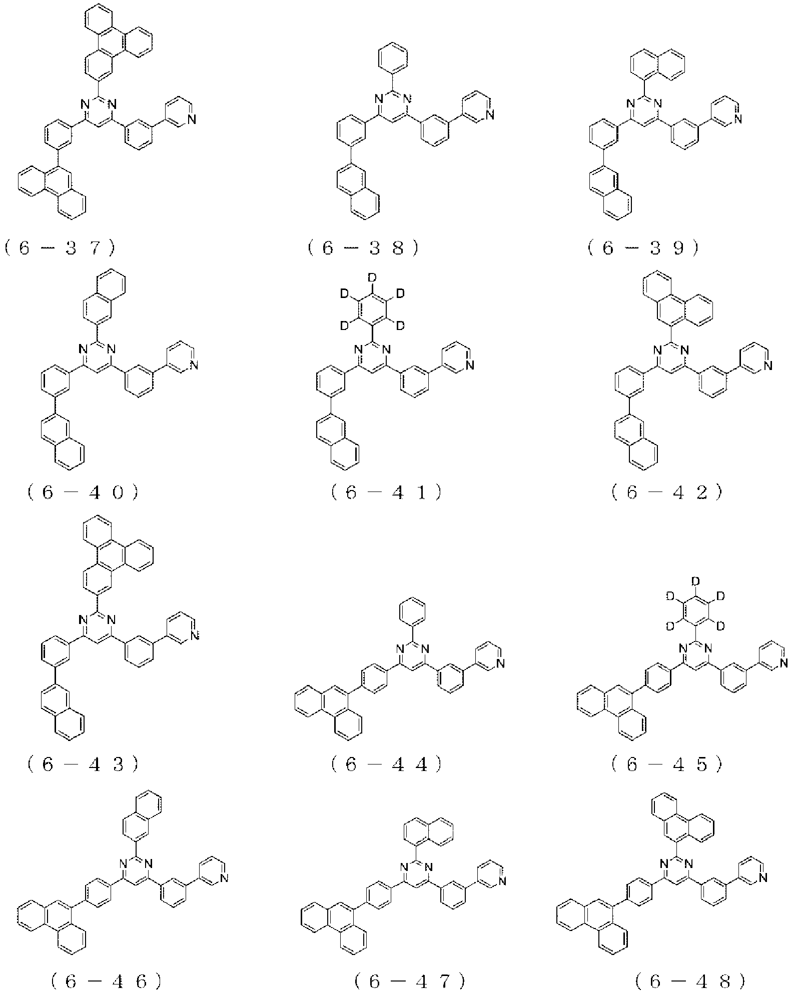

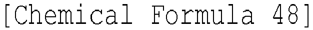

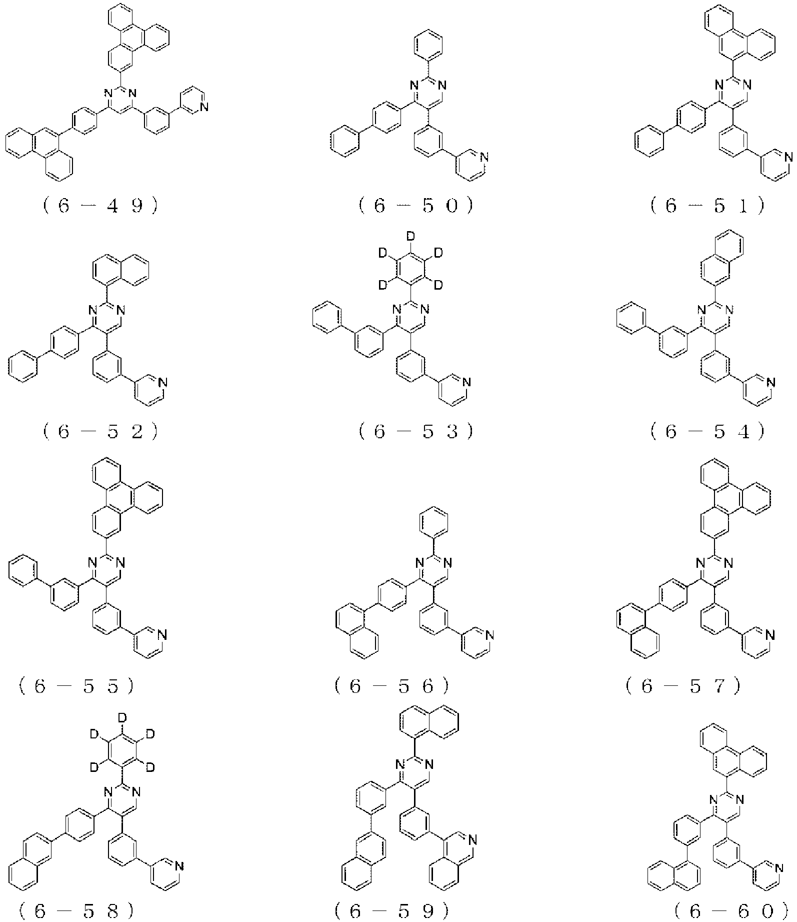

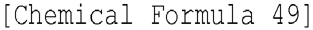

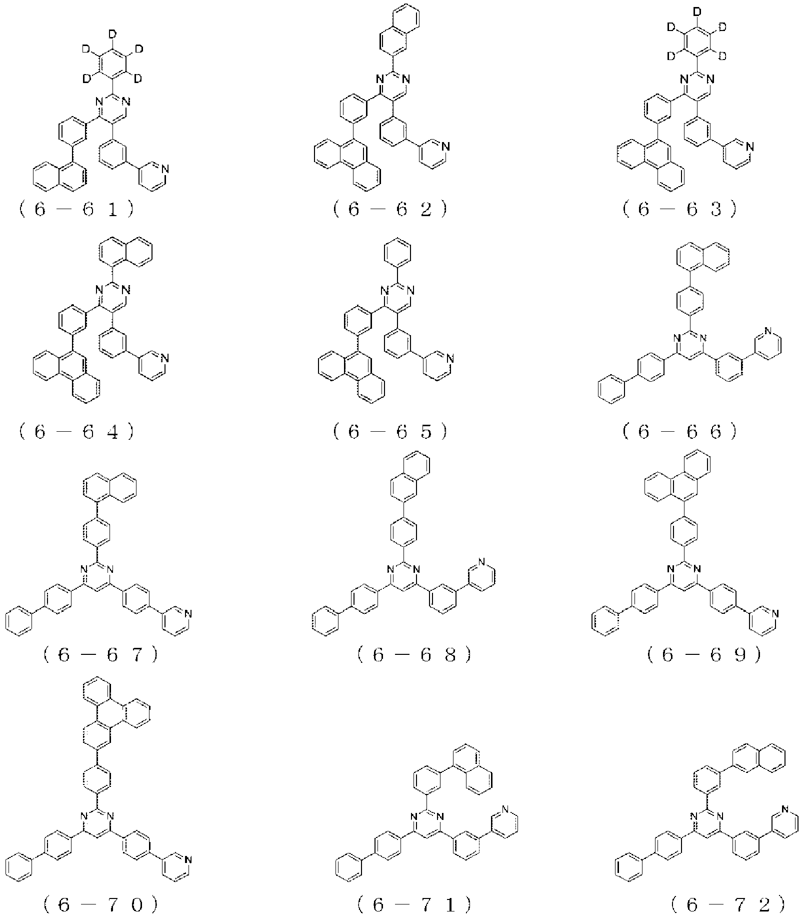

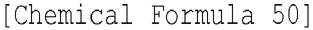

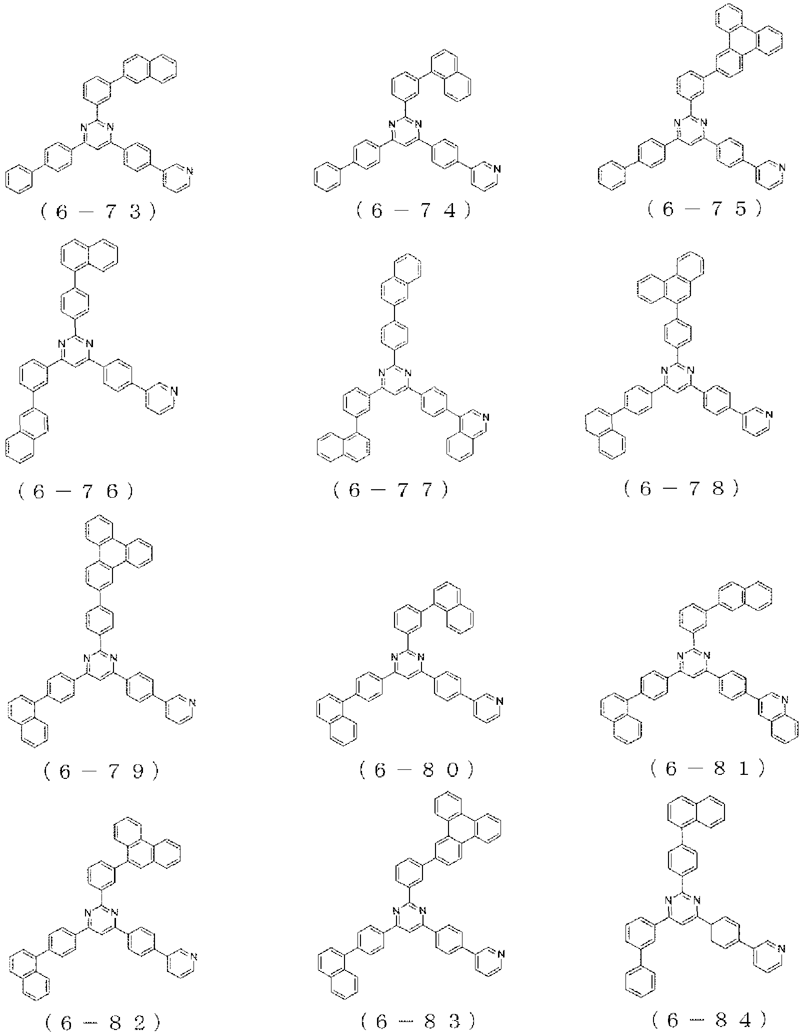

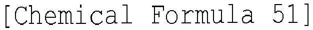

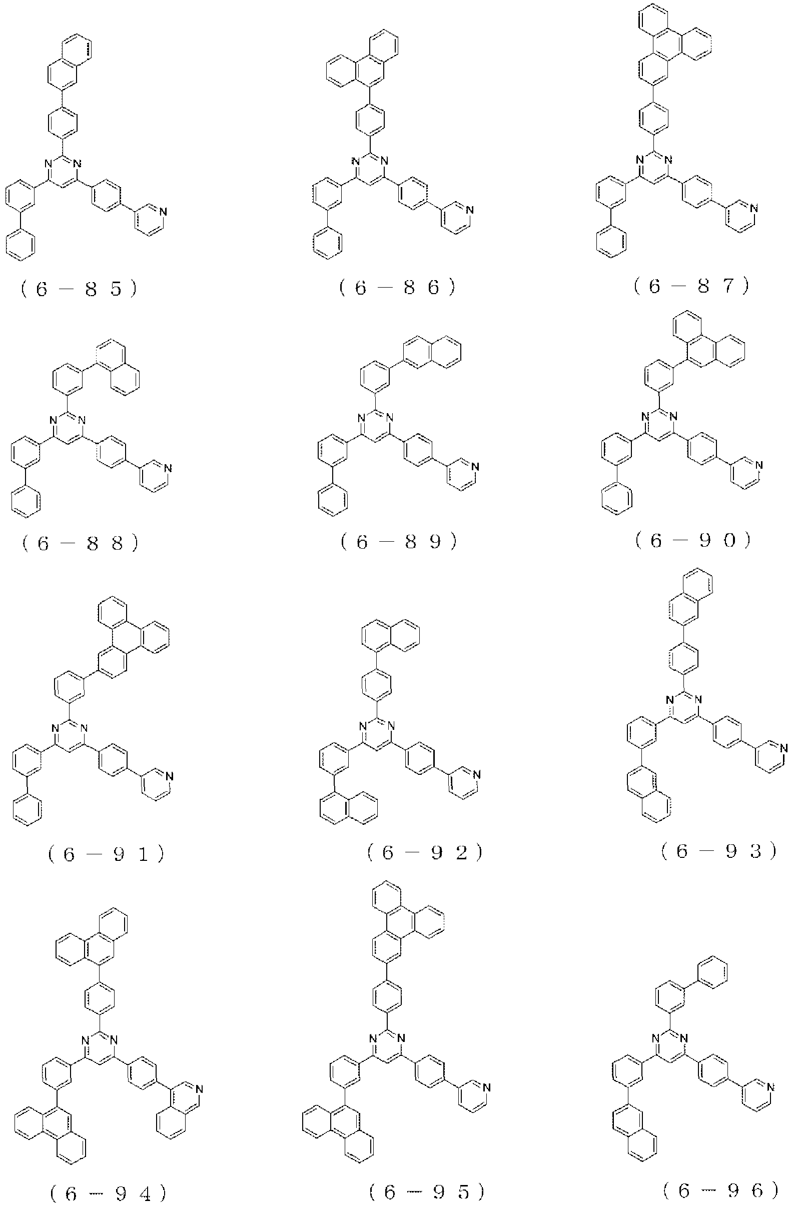

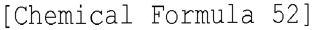

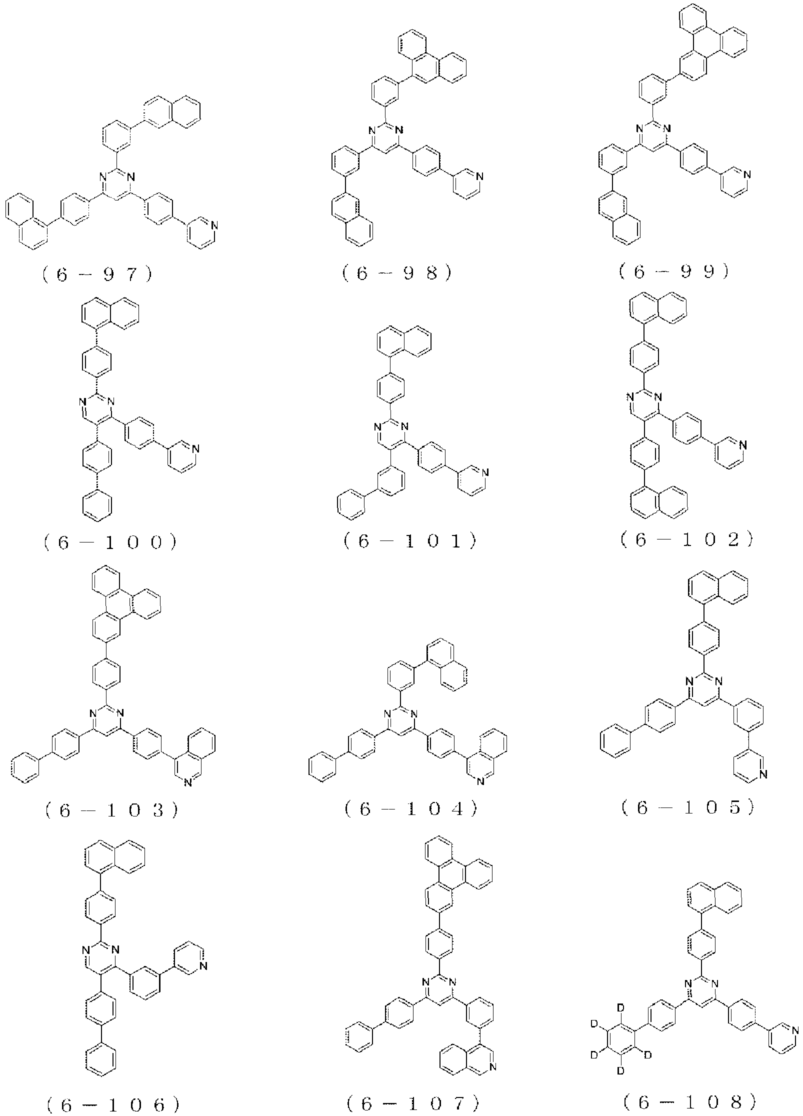

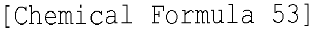

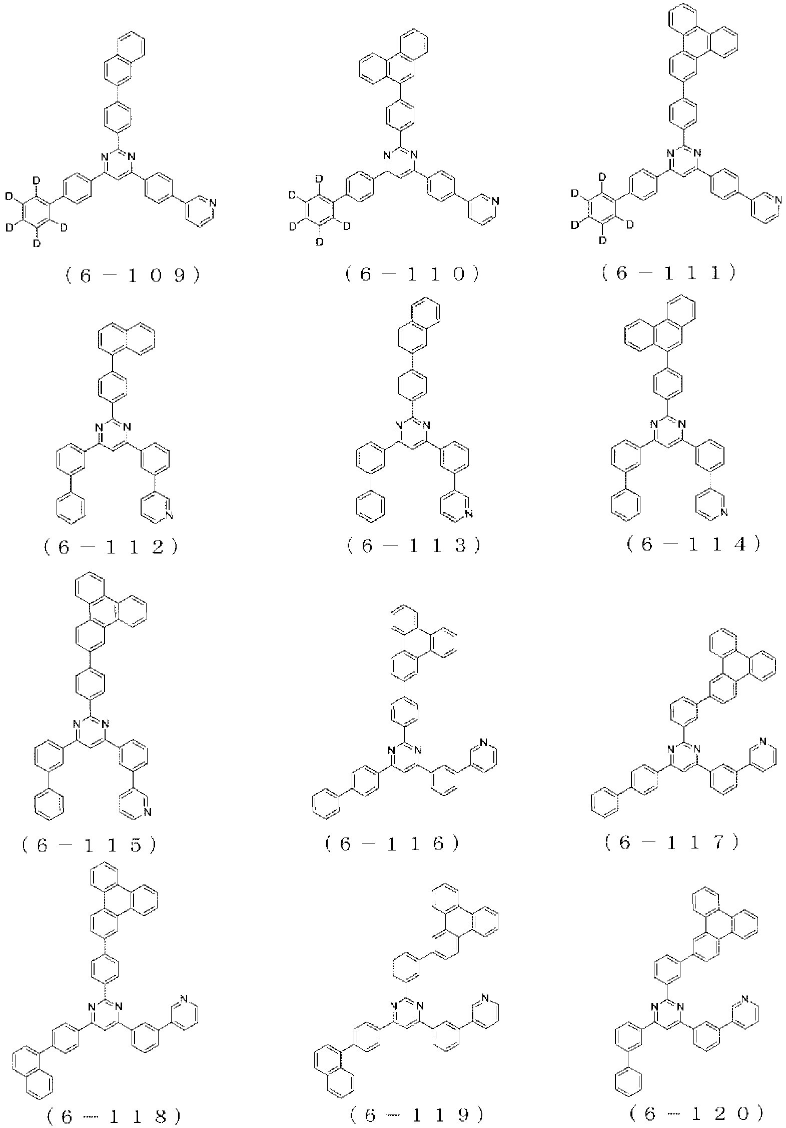

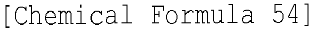

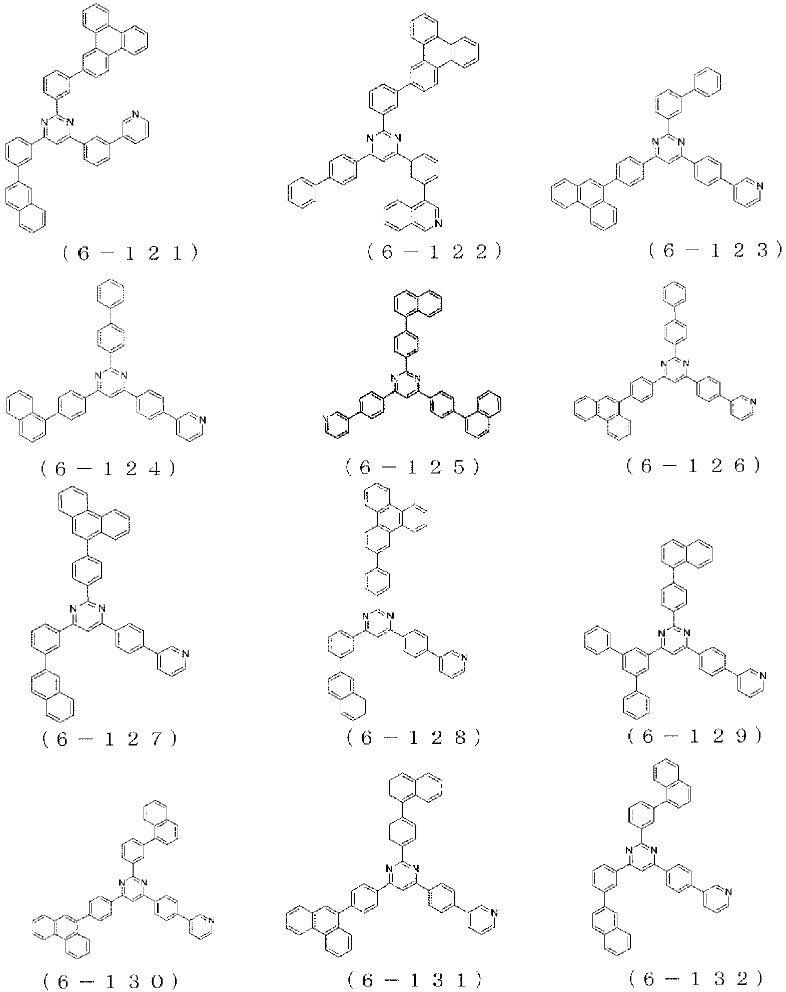

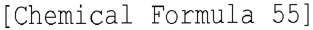

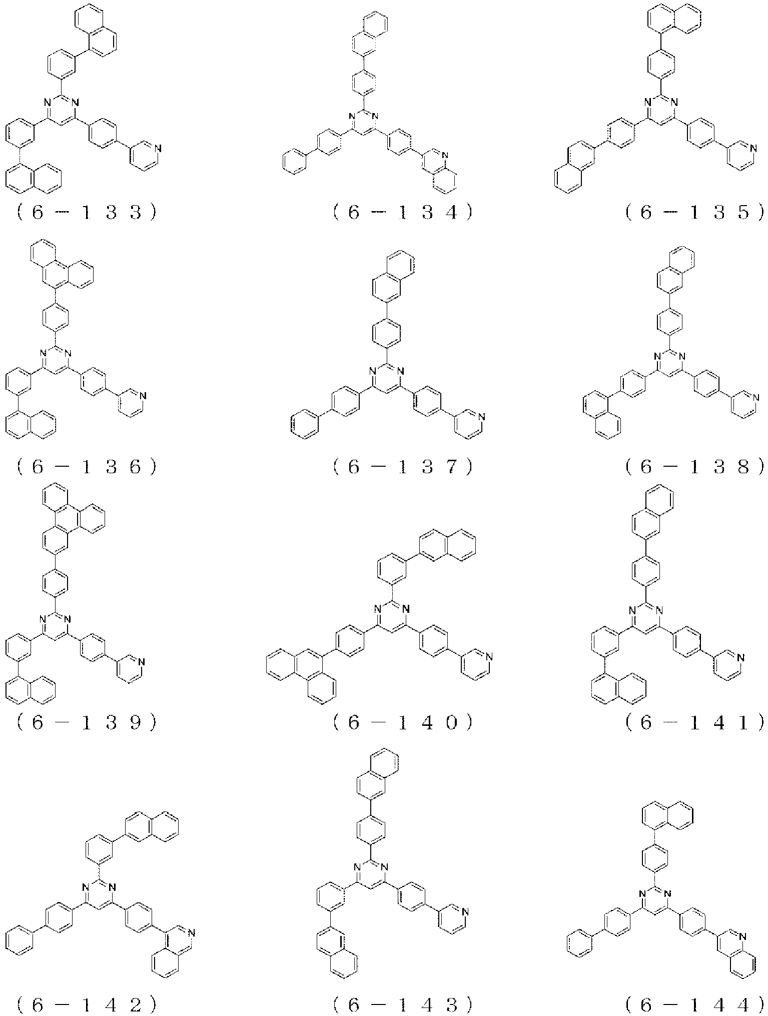

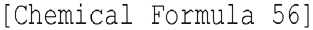

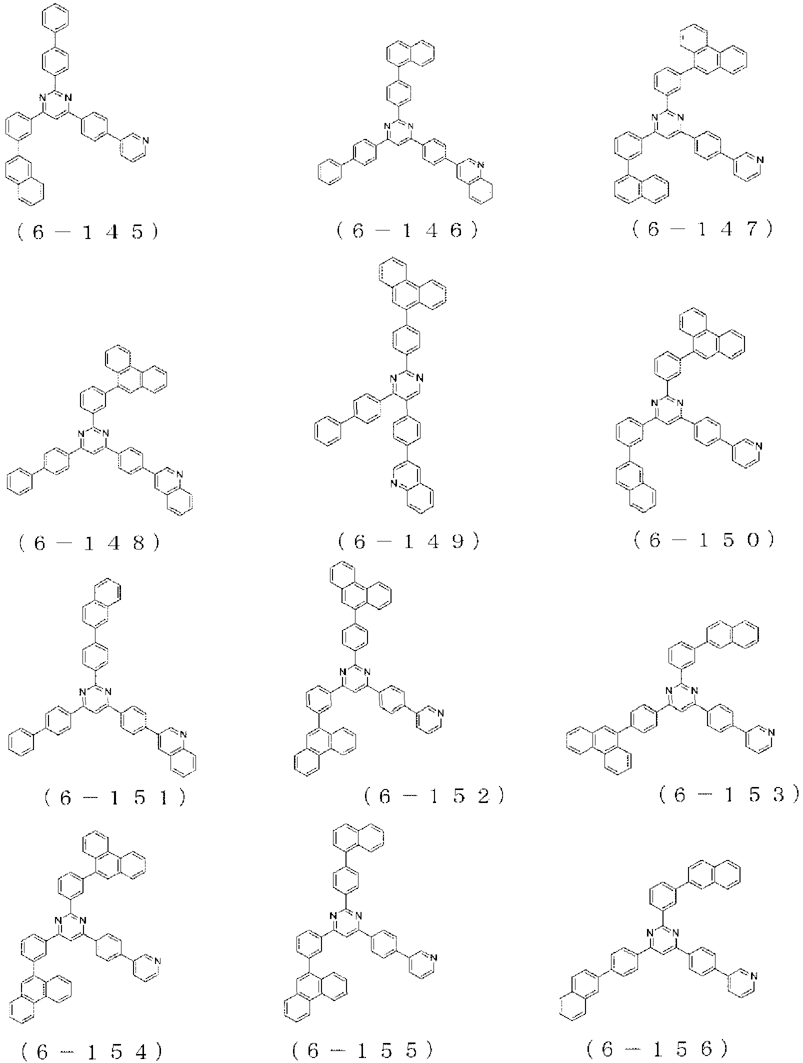

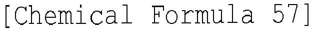

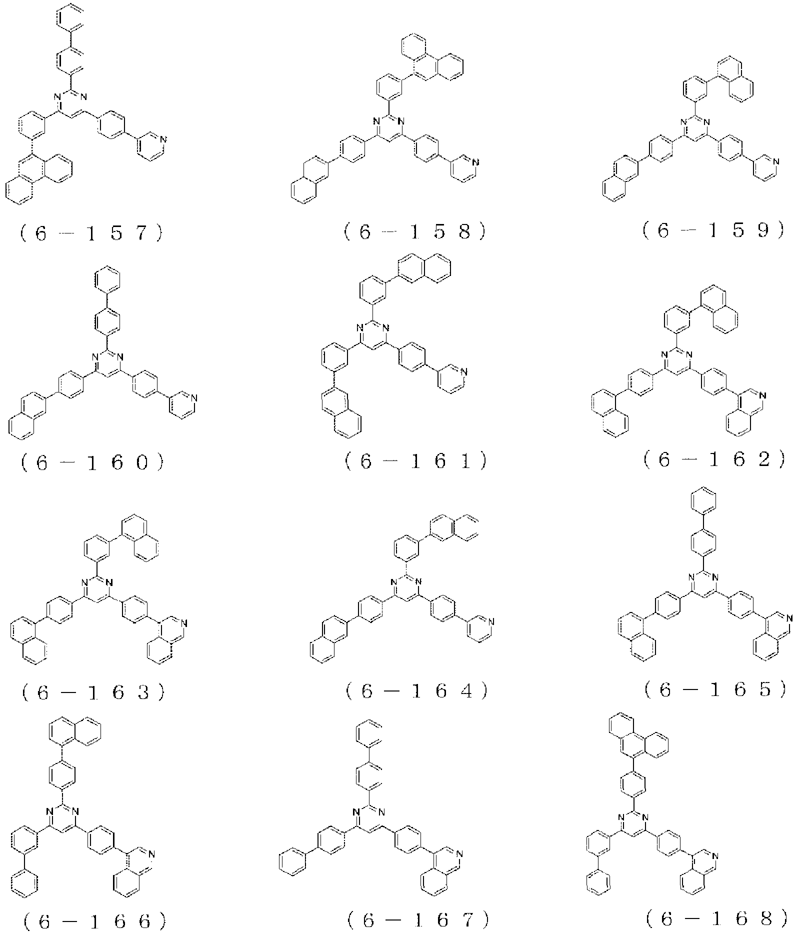

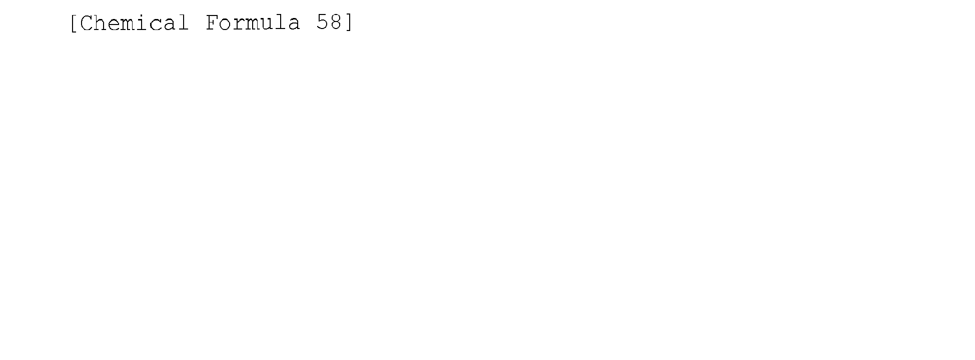

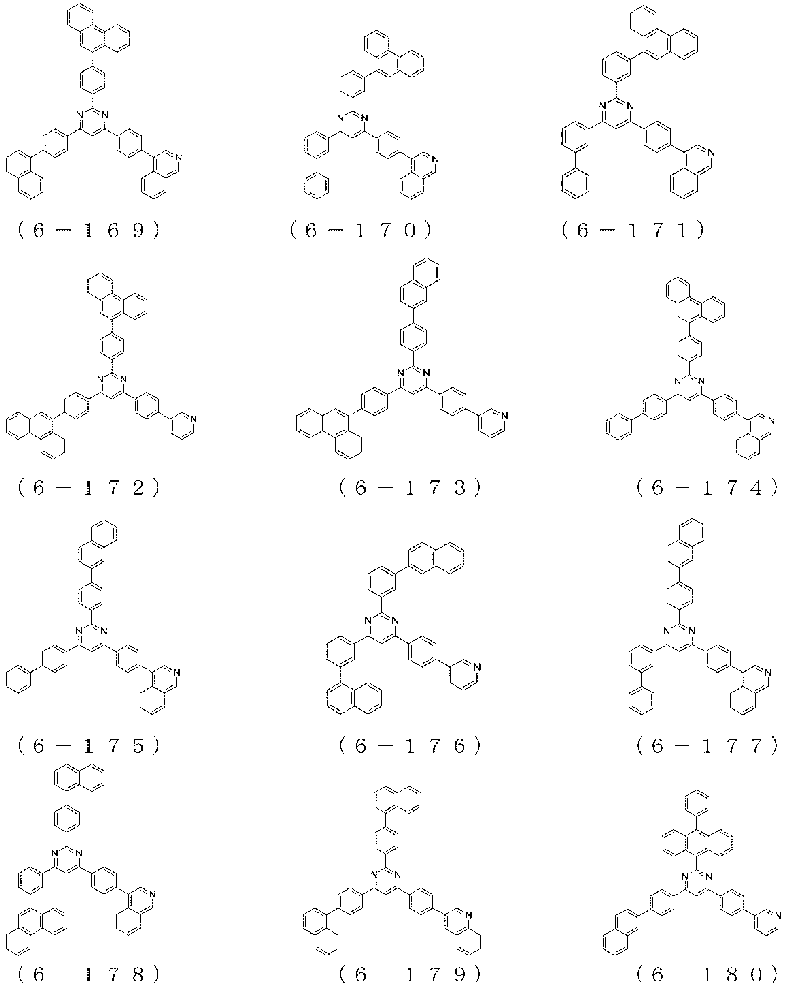

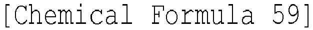

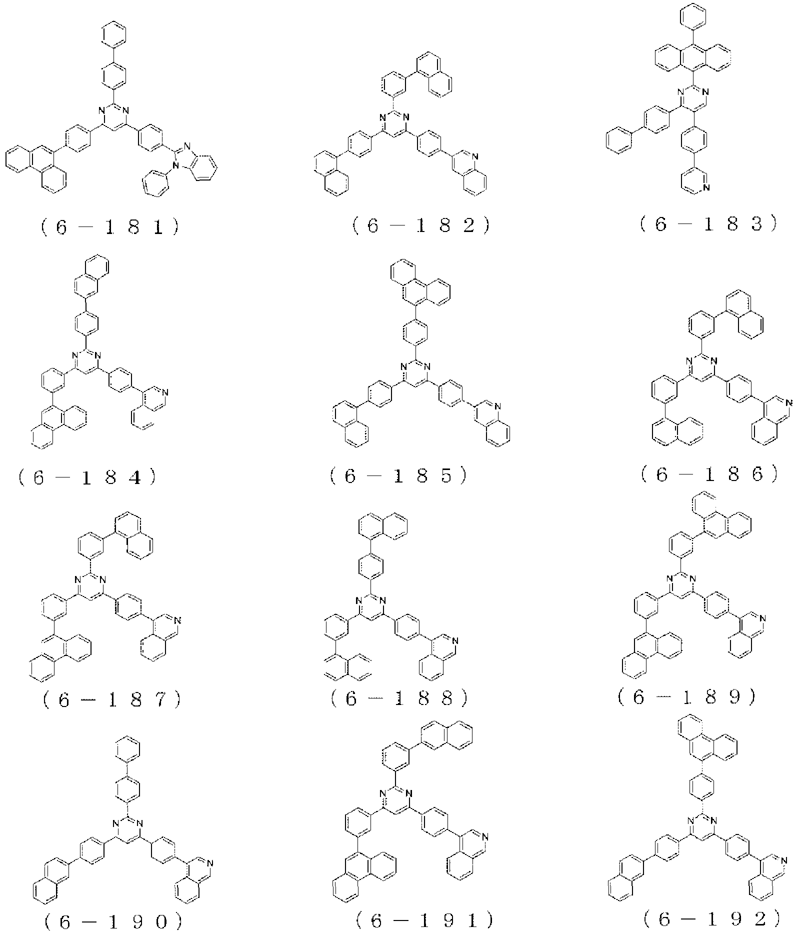

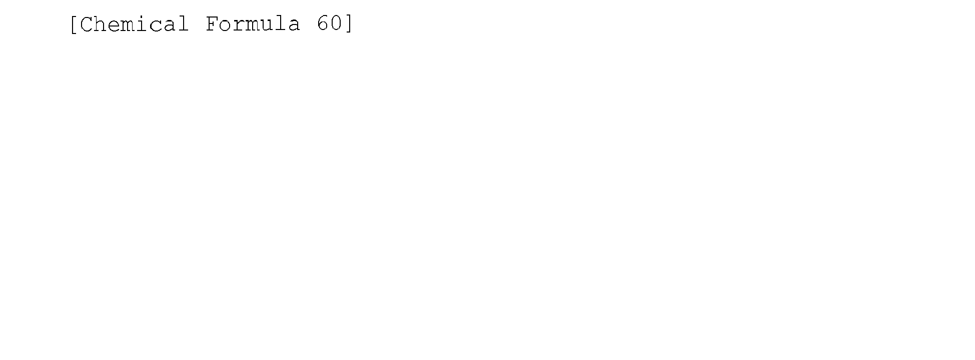

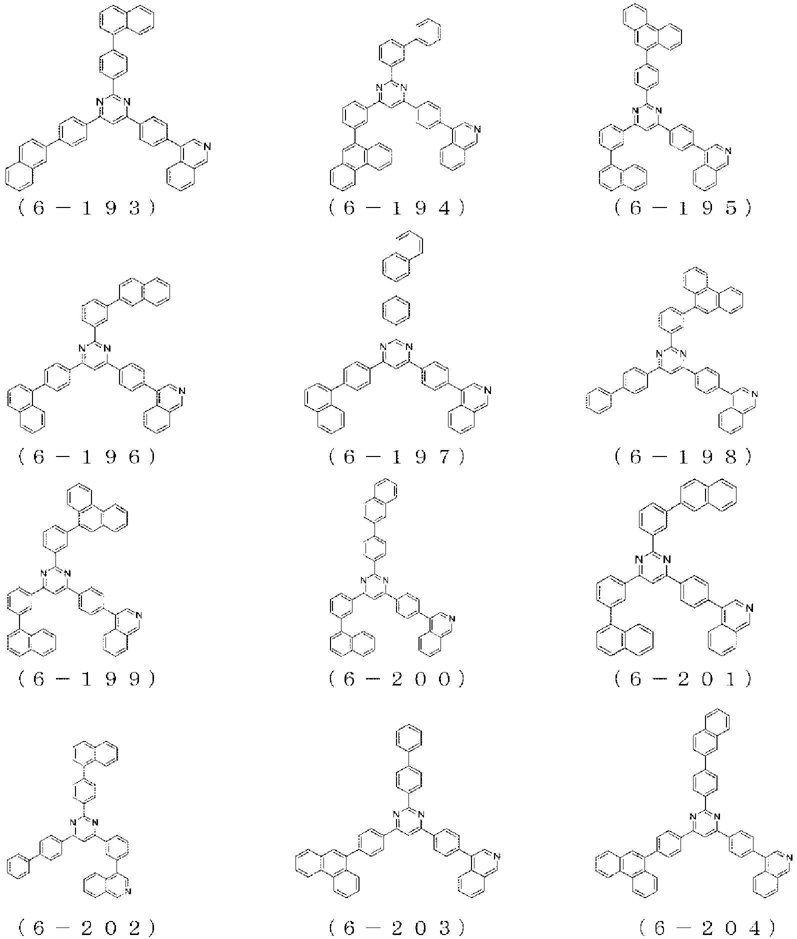

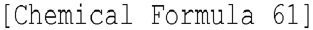

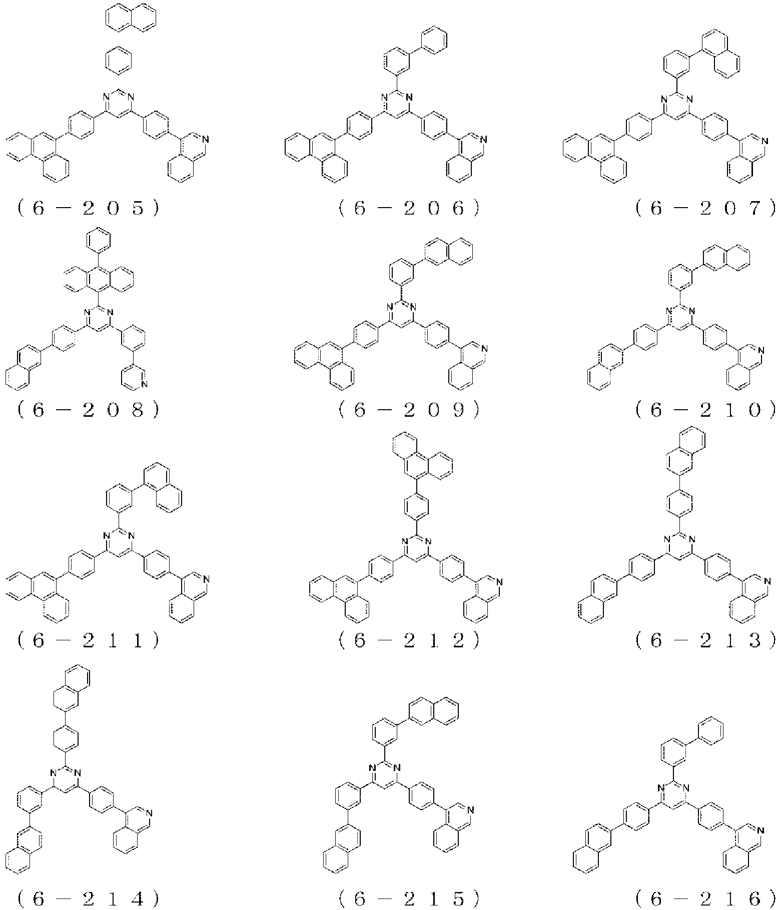

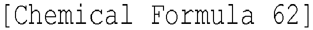

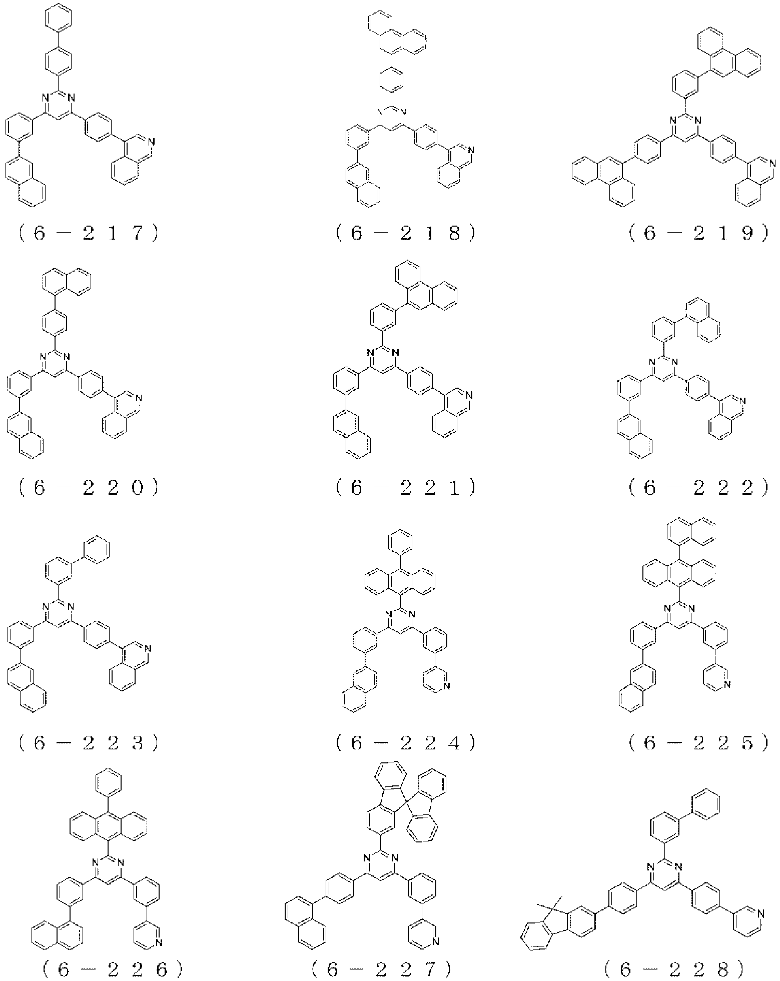

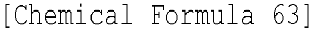

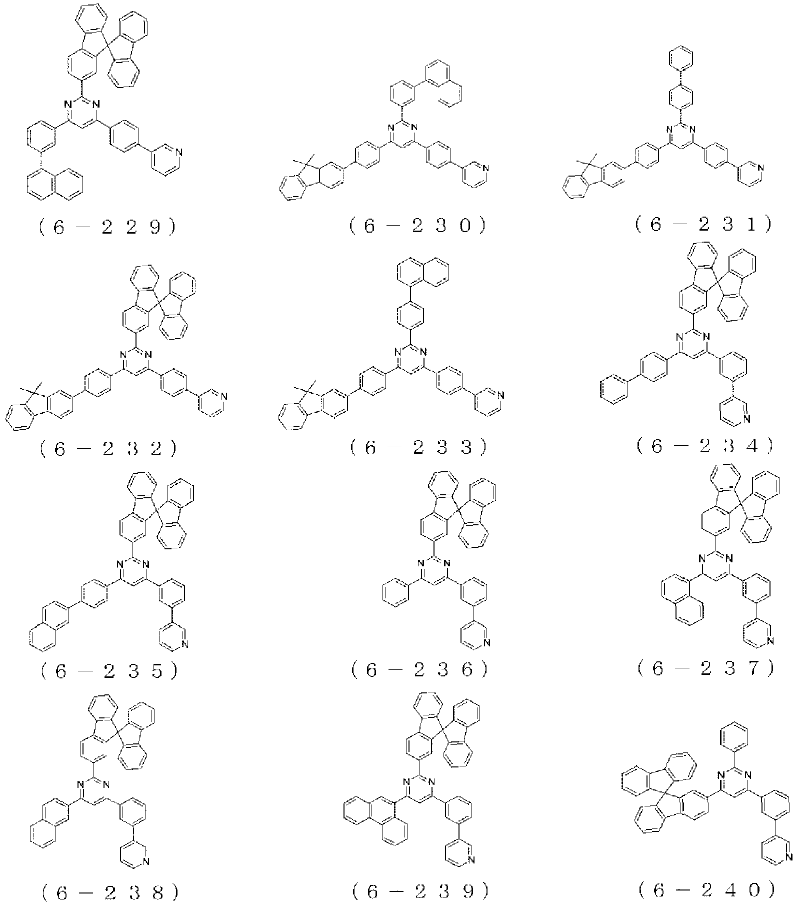

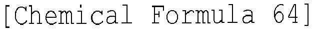

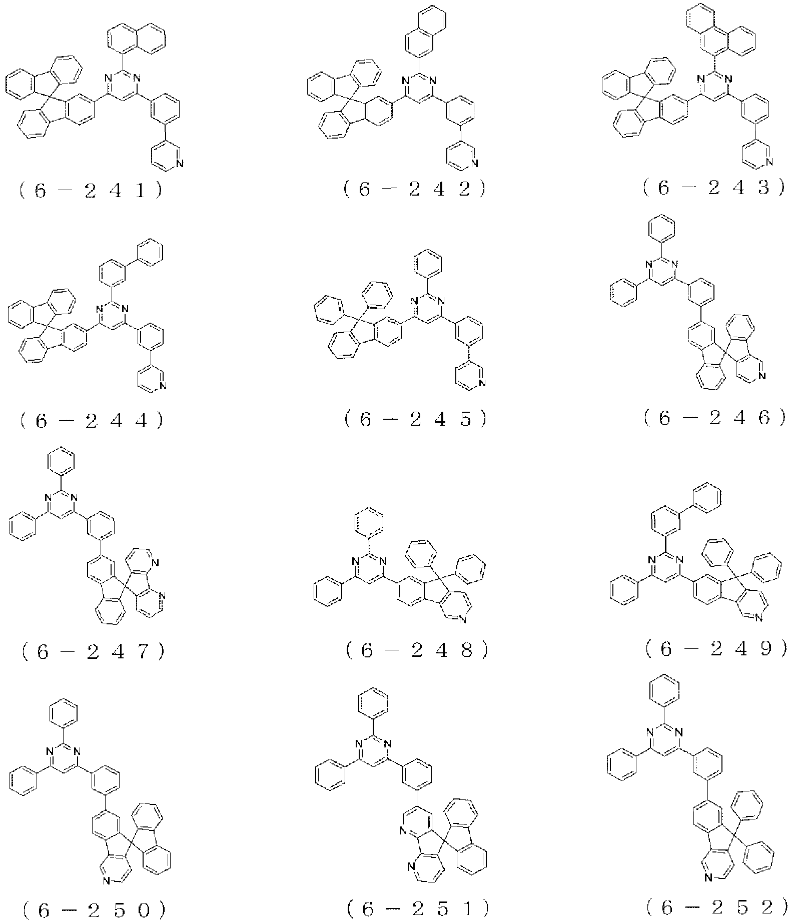

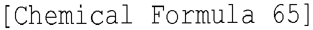

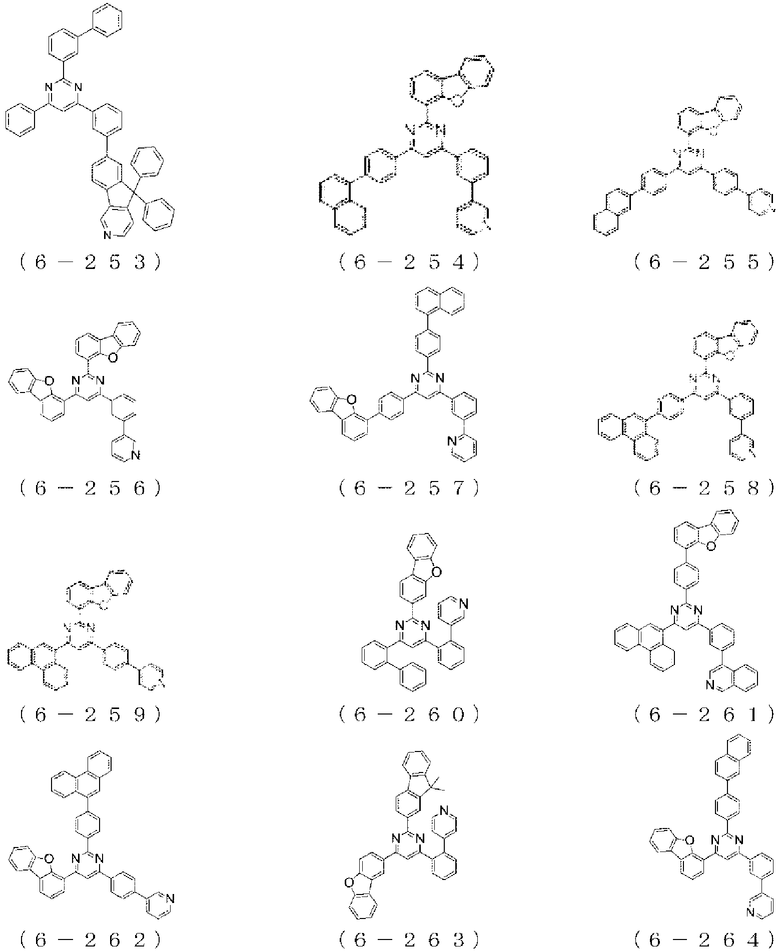

The compounds described above having a pyrimidine ring structure can be synthesized by a known method (refer to Patent Document 13, for example).

The following presents specific examples of preferred compounds among the amine derivatives of the general formula (8), according to the present invention, preferably used in the organic EL device of the present invention and having a condensed ring structure. The present invention, however, is not restricted to these compounds.

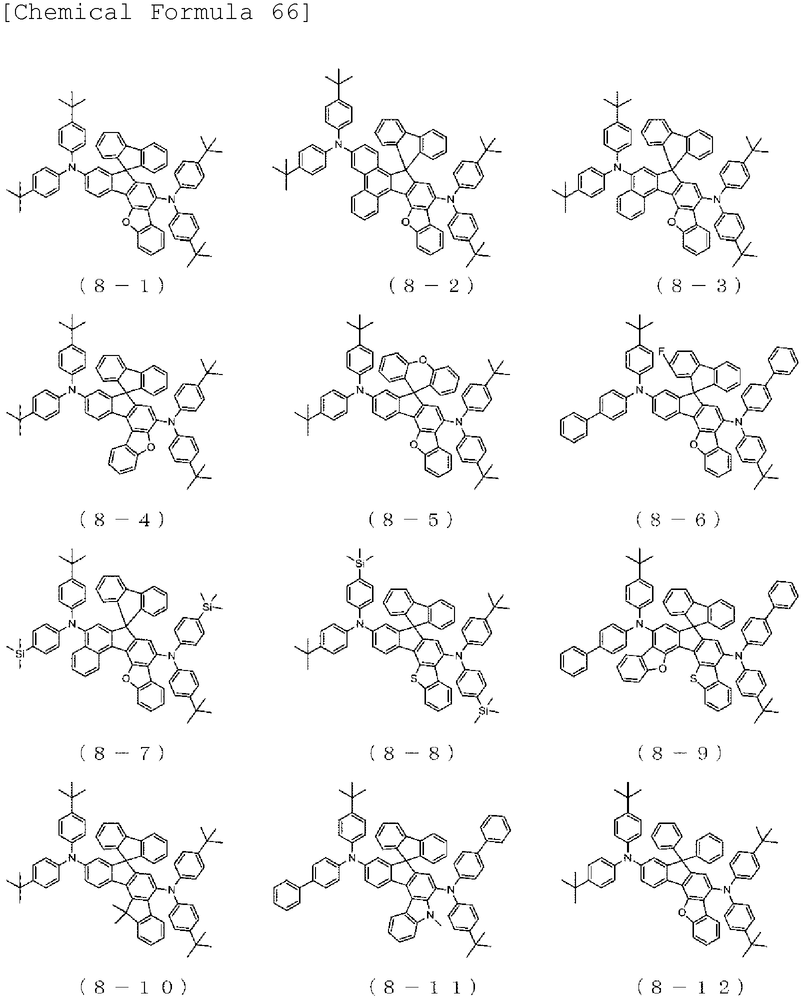

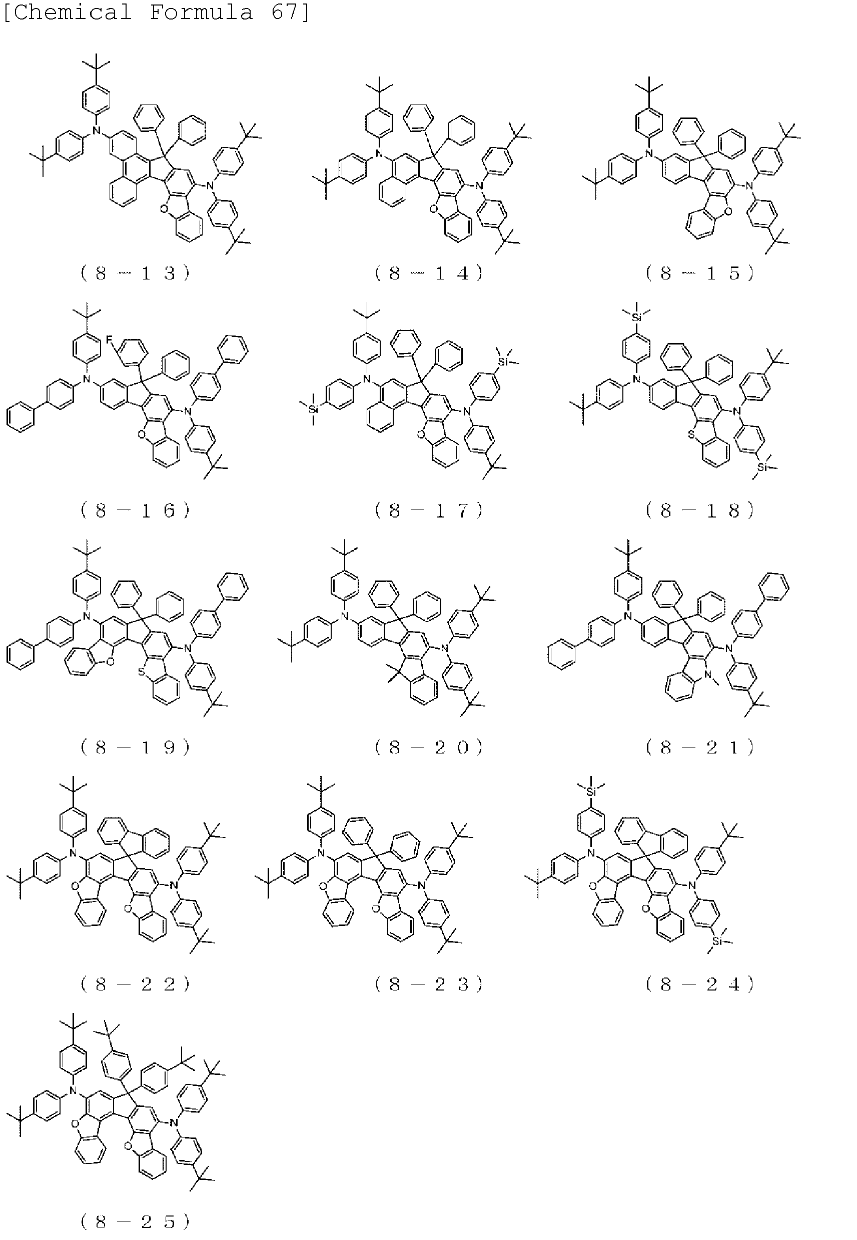

The arylamine compounds of the general formula (1), according to the present invention, were purified by methods such as column chromatography, adsorption using, for example, a silica gel, activated carbon, or activated clay, recrystallization or crystallization using a solvent, and a sublimation purification method. The compounds were identified by an NMR analysis. A melting point, a glass transition point (Tg), and a work function were measured as material property values. The melting point can be used as an index of vapor deposition, the glass transition point (Tg) as an index of stability in a thin-film state, and the work function as an index of hole transportability and hole blocking performance.

Other compounds used for the organic EL device of the present invention were purified by methods such as column chromatography, adsorption using, for example, a silica gel, activated carbon, or activated clay, and recrystallization or crystallization using a solvent, and finally purified by sublimation.

The melting point and the glass transition point (Tg) were measured by a high-sensitive differential scanning calorimeter (DSC3100SA produced by Bruker AXS) using powder.

For the measurement of the work function, a 100 nm-thick thin film was fabricated on an ITO substrate, and an ionization potential measuring device (PYS-202 produced by Sumitomo Heavy Industries, Ltd.) was used.

The organic EL device of the present invention at least has a structure including an anode, a hole injection layer, a hole transport layer, a light emitting layer, an electron transport layer, an electron injection layer, and a cathode successively formed on a substrate, optionally with an electron blocking layer between the hole transport layer and the light emitting layer, and a hole blocking layer between the light emitting layer and the electron transport layer. Some of the organic layers in the multilayer structure may be omitted, or may serve more than one function. For example, a single organic layer may serve as the electron injection layer and the electron transport layer. Further, the organic layers having a same function may have a laminate structure of two or more layers, for example, the hole transport layers may have a laminate structure of two or more layers, the light emitting layers may have a laminate structure of two or more layers, or the electron transport layers may have a laminate structure of two or more layers.

Electrode materials with high work functions such as ITO and gold are used as the anode of the organic EL device of the present invention.

As the hole injection layer of the organic EL device of the present invention, the arylamine compound of the general formula (1), according to the present invention, subjected to p-type doping with an electron acceptor is preferably used.

As a hole injection material that can be mixed with or can be used simultaneously with the arylamine compound of the general formula (1), according to the present invention, material such as starburst-type triphenylamine derivatives and various triphenylamine tetramers; porphyrin compounds as represented by copper phthalocyanine; accepting heterocyclic compounds such as hexacyanoazatriphenylene; coating-type polymer materials, and the like can be used. These materials may be formed into a thin film by a vapor deposition method or other known methods such as a spin coating method and an inkjet method.

According to the present disclosure, the arylamine compound of the general formula (3) and the arylamine compound of the general formula (4) could be used as the hole transport layer of organic EL devices.

The compounds that are not subjected to p-type doping are preferably used.

These may be individually formed into a film, may be used as a single layer formed with another hole transport material mixed, or may be formed as a laminated structure of the individually deposited layers, a laminated structure of the mixed layers, or a laminated structure of the individually deposited layer and the mixed layer. These materials may be formed into a thin-film by a vapor deposition method or other known methods such as a spin coating method and an inkjet method.

As the electron blocking layer of the organic EL device of the present invention, the arylamine compound of the general formula (1), according to the present invention, is preferably used, and in addition, compounds having an electron blocking effect can be used, for example, an arylamine compound having a structure in which four triphenylamine structures in the molecule are joined within a molecule via a single bond or a divalent group that does not contain a heteroatom, an arylamine compound having a structure in which two triphenylamine structures in the molecule are joined within a molecule via a single bond or a divalent group that does not contain a heteroatom, carbazole derivatives such as 4,4',4"-tri(N-carbazolyl)triphenylamine (TCTA), 9,9-bis[4-(carbazol-9-yl)phenyl]fluorene, 1,3-bis(carbazol-9-yl)benzene (mCP), and 2,2-bis(4-carbazol-9-ylphenyl)adamantane (Ad-Cz); and compounds having a triphenylsilyl group and a triarylamine structure, as represented by 9-[4-(carbazol-9-yl)phenyl]-9-[4-(triphenylsilyl)phenyl]-9 H-fluorene. These may be individually formed into a film, may be used as a single layer formed with another hole transport material mixed, or may be formed as a laminated structure of the individually deposited layers, a laminated structure of the mixed layers, or a laminated structure of the individually deposited layer and the mixed layer. These materials may be formed into a thin-film by a vapor deposition method or other known methods such as a spin coating method and an inkjet method.

In the organic EL device of the present invention, it is preferable that the electron blocking layer is not subjected to p-type doping.

In the hole transport layer, the arylamine compound of the general formula (1), according to the present invention, is used.

In the electron blocking layer, the arylamine compound of the general formula (3) and the arylamine compound of the general formula (4) are preferably used, and the arylamine compound of the general formula (1) is particularly preferably used.

The thicknesses of these layers are not particularly limited, as far as the thicknesses are ordinarily used, and may be, for example, 20 to 100 nm for the hole transport layer and 5 to 30 nm for the electron blocking layer.

Examples of material used for the light emitting layer of the organic EL device of the present invention can be various metal complexes, anthracene derivatives, bis(styryl)benzene derivatives, pyrene derivatives, oxazole derivatives, and polyparaphenylene vinylene derivatives, in addition to quinolinol derivative metal complexes such as Alq₃. Further, the light emitting layer may be made of a host material and a dopant material. Examples of the host material can be preferably anthracene derivatives. Other examples of the host material can be thiazole derivatives, benzimidazole derivatives, and polydialkyl fluorene derivatives, in addition to the above light-emitting materials. Examples of the dopant material can be preferably pyrene derivatives, amine derivatives of the general formula (8), according to the present invention, having a condensed ring structure. Other examples of the dopant material can be quinacridone, coumarin, rubrene, perylene, derivatives thereof, benzopyran derivatives, indenophenanthrene derivatives, rhodamine derivatives, and aminostyryl derivatives. These may be individually deposited for film forming, may be used as a single layer deposited mixed with other materials, or may be formed as a laminate of individually deposited layers, a laminate of mixedly deposited layers, or a laminate of the individually deposited layer and the mixedly deposited layer.

Further, the light-emitting material may be a phosphorescent material. Phosphorescent materials as metal complexes of metals such as iridium and platinum may be used. Examples of the phosphorescent materials include green phosphorescent materials such as Ir(ppy)₃, blue phosphorescent materials such as FIrpic and FIr6, and red phosphorescent materials such as Btp₂Ir(acac). Here, carbazole derivatives such as 4,4'-di(N-carbazolyl)biphenyl (CBP), TCTA, and mCP may be used as the hole injecting and transporting host material. Compounds such as p-bis(triphenylsilyl)benzene (UGH2) and 2,2',2"-(1,3,5-phenylene)-tris(1-phenyl-1H-benzimidazole) (TPBI) may be used as the electron transporting host material. In this way, a high-performance organic EL device can be produced.

In order to avoid concentration quenching, the doping of the host material with the phosphorescent light-emitting material should preferably be made by co-evaporation in a range of 1 to 30 weight percent with respect to the whole light emitting layer.

Further, Examples of the light-emitting material may be delayed fluorescent-emitting material such as a CDCB derivative of PIC-TRZ, CC2TA, PXZ-TRZ, 4CzIPN or the like (refer to Non-Patent Document 3, for example).

These materials may be formed into a thin-film by using a vapor deposition method or other known methods such as a spin coating method and an inkjet method.

The hole blocking layer of the organic EL device of the present invention may be formed by using hole blocking compounds such as various rare earth complexes, triazole derivatives, triazine derivatives, and oxadiazole derivatives, in addition to the metal complexes of phenanthroline derivatives such as bathocuproin (BCP), and the metal complexes of quinolinol derivatives such as aluminum(III) bis(2-methyl-8-quinolinate)-4-phenylphenolate (BAlq). These may be individually deposited for film forming, may be used as a single layer deposited mixed with other materials, or may be formed as a laminate of individually deposited layers, a laminate of mixedly deposited layers, or a laminate of the individually deposited layer and the mixedly deposited layer. These materials may be formed into a thin-film by using a vapor deposition method or other known methods such as a spin coating method and an inkjet method.

Material used for the electron transport layer of the organic EL device of the present invention is the compounds of the general formula (5b) having an anthracene ring structure, or the compounds of the general formula (6) having a pyrimidine ring structure. According to the present disclosure, other examples of material can be metal complexes of quinolinol derivatives such as Alq₃ and BAlq, various metal complexes, triazole derivatives, triazine derivatives, oxadiazole derivatives, thiadiazole derivatives, carbodiimide derivatives, quinoxaline derivatives, phenanthroline derivatives, and silole derivatives. These may be individually deposited for film forming, may be used as a single layer deposited mixed with other materials, or may be formed as a laminate of individually deposited layers, a laminate of mixedly deposited layers, or a laminate of the individually deposited layer and the mixedly deposited layer. These materials may be formed into a thin-film by using a vapor deposition method or other known methods such as a spin coating method and an inkjet method.

Examples of material used for the electron injection layer of the organic EL device of the present invention can be alkali metal salts such as lithium fluoride and cesium fluoride; alkaline earth metal salts such as magnesium fluoride; and metal oxides such as aluminum oxide. However, the electron injection layer may be omitted in the preferred selection of the electron transport layer and the cathode.

The cathode of the organic EL device of the present invention may be made of an electrode material with a low work function such as aluminum, or an alloy of an electrode material with an even lower work function such as a magnesium-silver alloy, a magnesium-indium alloy, or an aluminum-magnesium alloy.

The following describes an embodiment of the present invention in more detail based on Examples. The present invention, however, is not restricted to the following Examples.

### Example 1

### <Synthesis of 4,4"-bis{(biphenyl-4-yl)-phenylamino}-1,1':4',1"-terphen yl (Compound 1-1)>

(Biphenyl-4-yl)-phenylamine (39.5 g), 4,4"-diiodo-1,1':4',1"-terphenyl (32.4 g), a copper powder (0.42 g), potassium carbonate (27.8 g), 3,5-di-tert-butylsalicylic acid (1.69 g), sodium bisulfite (2.09 g), dodecylbenzene (32 ml), and toluene (50 ml) were added into a reaction vessel and heated up to 210°C while removing the toluene by distillation. After the obtained product was stirred for 30 hours, the product was cooled, and toluene (50 ml) and methanol (100 ml) were added. A precipitated solid was collected by filtration and washed with a methanol/water (5/1, v/v) mixed solution (500 ml). The solid was heated after adding 1,2-dichlorobenzene (350 ml), and insoluble matter was removed by filtration. After the filtrate was left to cool, methanol (400 ml) was added, and a precipitated crude product was collected by filtration. The crude product was washed under reflux with methanol (500 ml) to obtain a gray powder of 4,4"-bis{(biphenyl-4-yl)-phenylamino}-1,1':4',1"-terphen yl (Compound 1-1; 45.8 g; yield 91%).

The structure of the obtained gray powder was identified by NMR.

¹H-NMR (CDCl₃) detected 40 hydrogen signals, as follows.

δ (ppm) = 7.68-7.63 (4H), 7.62-7.48 (12H), 7.45 (4H), 7.38-7.10 (20H).

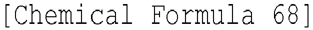

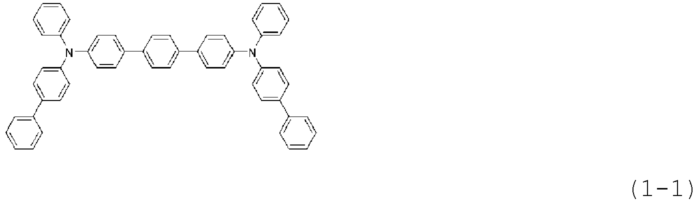

### Example 2

### <Synthesis of 4,4"-bis{(biphenyl-4-yl)-4-tolylamino}-1,1':4',1"-terphe nyl (Compound 1-10)>

(Biphenyl-4-yl)-4-tolylamine (16.7 g), 4,4"-diiodo-1,1':4',1"-terphenyl (12.9g), a copper powder (0.17 g), potassium carbonate (11.2 g), 3,5-di-tert-butylsalicylic acid (0.71 g), sodium bisulfite (0.89g), dodecylbenzene (20ml), and toluene (20ml) were added into a reaction vessel and heated up to 210°C while removing the toluene by distillation. The obtained product was stirred for 28 hours, and after the product was cooled, toluene (150 ml) was added, and insoluble matter was removed by filtration. Methanol (100 ml) was added, and a precipitated crude product was collected by filtration. Recrystallization of the crude product using a toluene/methanol mixed solvent was repeated three times to obtain a yellowish white powder of 4,4"-bis{(biphenyl-4-yl)-4-tolylamino}-1,1':4',1"-terphe nyl (Compound 1-10; 12.3 g; yield 61%).

The structure of the obtained yellowish white powder was identified by NMR.

¹H-NMR (CDCl₃) detected 44 hydrogen signals, as follows.

δ (ppm) = 7.68-7.62 (4H), 7.61-7.41 (16H), 7.38-7.08 (18H), 2.38 (6H).

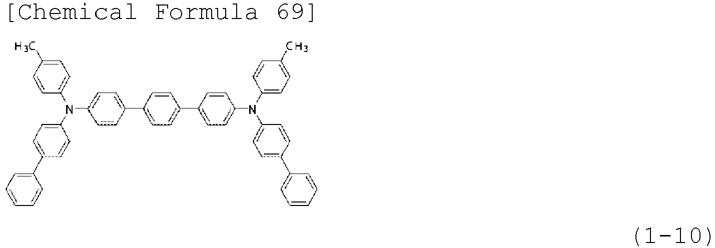

### Example 3

### <Synthesis of 4,4"-bis{(biphenyl-4-yl)-(phenyl-d₅)amino-1,1':4',1"-te rphenyl (Compound 1-14)>

(Biphenyl-4-yl)-(phenyl-d₅)amine (25.3 g), 4,4"-diiodo-1,1':4',1"-terphenyl (20.3g), a copper powder (0.30 g), potassium carbonate (17.5 g), 3,5-di-tert-butylsalicylic acid (1.05 g), sodium bisulfite (1.31g), dodecylbenzene (20ml), and toluene (30ml) were added into a reaction vessel and heated up to 210°C while removing the toluene by distillation. After the obtained product was stirred for 23 hours, the product was cooled, and toluene (30 ml) and methanol (60 ml) were added. A precipitated solid was collected by filtration and washed with a methanol/water (1/5, v/v) mixed solution (180 ml) followed by washing with methanol (90 ml). An obtained gray powder was heated after adding 1,2-dichlorobenzene (210ml), and insoluble matter was removed by filtration. After the filtrate was left to cool, methanol (210 ml) was added, and a precipitated crude product was collected by filtration. The crude product was washed under reflux with methanol (210 ml) to obtain a gray powder of 4,4"-bis{(biphenyl-4-yl)-(phenyl-d₅)amino}-1,1':4',1"-te rphenyl (Compound 1-14; 29.3 g; yield 96%).

The structure of the obtained gray powder was identified by NMR.

¹H-NMR (THF-ds) detected 30 hydrogen signals, as follows.

δ (ppm) =7.69 (4H), 7.65-7.52 (12H), 7.39 (4H), 7.28 (2H), 7.20-7.14 (8H).

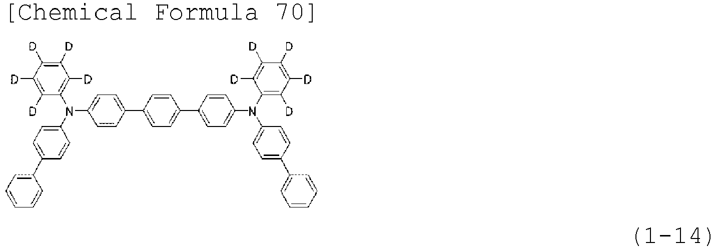

### Example 4

### <Synthesis of 4,4"-bis{(naphthalen-1-yl)-phenylamino}-1,1':4',1"-terph enyl (Compound 1-2)>

(Naphthalen-1-yl)-phenylamine (40.0 g), 4,4"-diiodo-1,1':4',1"-terphenyl (43.7g), a copper powder (0.53 g), potassium carbonate (34.4 g), 3,5-di-tert-butylsalicylic acid (2.08 g), sodium bisulfite (2.60g), dodecylbenzene (40ml), and xylene (40ml) were added into a reaction vessel and heated up to 210°C while removing the xylene by distillation. After the obtained product was stirred for 35 hours, the product was cooled. Toluene (100 ml) was added, and a precipitated solid was collected by filtration. 1,2-dichlorobenzene (210 ml) was added to the obtained solid, and the solid was dissolved under heat, and after silica gel (30 g) was added, insoluble matter was removed by filtration. After the filtrate was left to cool, a precipitated crude product was collected by filtration. The crude product was washed under reflux with methanol to obtain a pale yellow powder of 4,4"-bis{(naphthalen-1-yl)-phenylamino}-1,1':4',1"-terph enyl (Compound 1-2; 21.9 g; yield 40%).

The structure of the obtained pale yellow powder was identified by NMR.

¹H-NMR (THF-ds) detected 36 hydrogen signals, as follows.

δ (ppm) = 7.98-7.88 (4H), 7.80 (2H), 7.60 (4H), 7.52-7.40 (8H), 7.36 (4H), 7.18 (4H), 7.08-7.01 (8H), 6.93(2H).

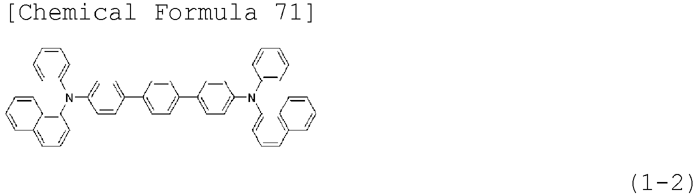

### Example 5

### <Synthesis of 4,4"-bis{(naphthalen-2-yl)-phenylamino}-1,1':4',1"-terph enyl (Compound 1-6)>

(Naphthalen-2-yl)-phenylamine (50.0 g), 4,4"-diiodo-1,1':4',1"-terphenyl (50.0 g), tert-butoxy sodium (23.9 g), and xylene (500 ml) were added into a reaction vessel and aerated with nitrogen gas for 1 hour under ultrasonic irradiation. Palladium acetate (0.47 g) and a toluene solution (2.96 ml) containing 50% (w/v) tri-tert-butylphosphine were added, and the mixture was heated up to 120°C and stirred for 15 hours. After the mixture was left to cool, the mixture was concentrated under reduced pressure, and methanol (300 ml) was added. A precipitated solid was collected by filtration and dissolved under heat after adding 1,2-dichlorobenzene (300 ml). After silica gel (140 g) was added, insoluble matter was removed by filtration. The filtrate was concentrated under reduced pressure, and after the product was purified by recrystallization with 1,2-dichlorobenzene (250 ml), the purified product was washed under reflux with methanol to obtain a white powder of 4,4"-bis{(naphthalen-2-yl)-phenylamino}-1,1':4',1"-terph enyl (Compound 1-6; 51.0 g; yield 74%).

The structure of the obtained white powder was identified by NMR.

¹H-NMR (THF-ds) detected 36 hydrogen signals, as follows.

δ (ppm) = 7.77 (4H), 7.70 (4H), 7.64-7.58 (6H), 7.48 (2H), 7.40-7.21 (10H), 7.21-7.12 (8H), 7.04 (2H).

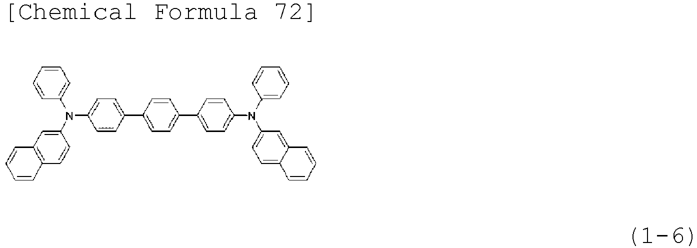

### Example 6

### <Synthesis of 4,4"-bis[{(biphenyl-2',3',4',5',6'-d₅)-4-yl}-phenylamino] -1,1':4',1"-terphenyl (Compound 1-21)>

{(Biphenyl-2',3',4',5',6'-d₅)-4-yl}-phenylamine (24.8 g), 4,4"-diiodo-1,1':4',1"-terphenyl (19.9 g), a copper powder (0.26 g), potassium carbonate (17.2 g), 3,5-di-tert-butylsalicylic acid (2.06 g), sodium bisulfite (1.30 g), and dodecylbenzene (20 ml) were added into a reaction vessel and heated up to 215°C. After the obtained product was stirred for 21 hours, the product was cooled, and toluene (30 ml) and methanol (60 ml) were added. A precipitated solid was collected by filtration and washed with a methanol/water (1/5, v/v) mixed solution. After adding 1,2-dichlorobenzene (300 ml) to the obtained solid, the solid was heated, and insoluble matter was removed by filtration. After the filtrate was left to cool, methanol (300 ml) was added, and a precipitate was collected by filtration to obtain a yellow powder of 4,4"-bis[{(biphenyl-2',3',4',5',6'-d₅)-4-yl}-phenylamino] -1,1':4',1"-terphenyl (Compound 1-21; 25.5 g; yield 85%).

The structure of the obtained yellow powder was identified by NMR.

¹H-NMR (THF-ds) detected 30 hydrogen signals, as follows.

δ (ppm) = 7.69 (4H), 7.65-7.52 (8H), 7.28 (4H), 7.20-7.12 (10H), 7.03 (4H).

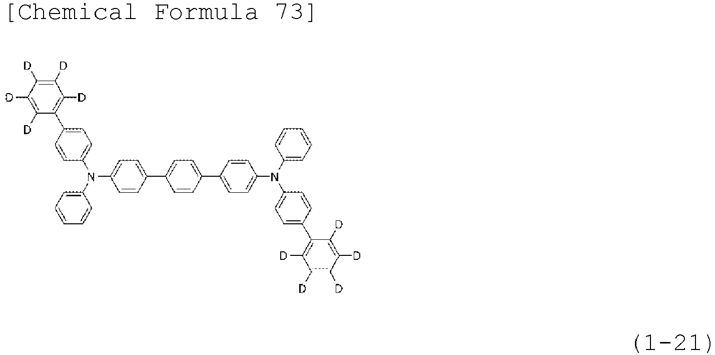

### Example 7

### <Synthesis of 4,4"-bis{(biphenyl-3-yl)-(biphenyl-4-yl)amino}-1,1':4',1"-terphenyl (Compound 1-22)>

(Biphenyl-3-yl)-(biphenyl-4-yl)amine (16.1 g), 4,4"-diiodo-1,1':4',1"-terphenyl (11.0 g), a copper powder (0.29 g), potassium carbonate (9.46 g), 3,5-di-tert-butylsalicylic acid (1.14 g), sodium bisulfite (0.71 g), and dodecylbenzene (22 ml) were added into a reaction vessel and heated up to 220°C. After the obtained product was stirred for 34 hours, the product was cooled, and toluene and heptane were added. A precipitated solid was collected by filtration and dissolved under heat after adding 1,2-dichlorobenzene (200 ml). After silica gel (50 g) was added, insoluble matter was removed by filtration. After the filtrate was concentrated under reduced pressure, toluene and acetone were added. A precipitated solid was collected by filtration, and the precipitated solid was crystallized with 1,2-dichloromethane followed by crystallization with acetone, and further crystallized with 1,2-dichloromethane followed by crystallization with methanol to obtain a pale yellow powder of 4,4"-bis{ (biphenyl-3-yl)-(biphenyl-4-yl)amino}-1,1':4',1"-terphenyl (Compound 1-22; 25.5 g; yield 77%).

The structure of the obtained pale yellow powder was identified by NMR.

¹H-NMR (THF-ds) detected 48 hydrogen signals, as follows.

δ (ppm) = 7.71 (4H), 7.67-7.50 (16H), 7.47 (4H), 7.43-7.20 (20H), 7.12 (4H).

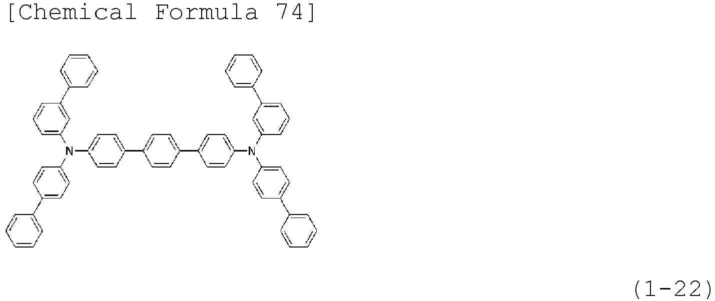

### Example 8

### <Synthesis of 4,4"-bis{(phenanthren-9-yl)-phenylamino}-1,1':4',1"-terp henyl (Compound 1-3)>

(Phenanthren-9-yl)-phenylamine (16.9 g), 4,4"-diiodo-1,1':4',1"-terphenyl (12.6 g), a copper powder (0.16 g), potassium carbonate (10.9 g), 3,5-di-tert-butylsalicylic acid (0.65 g), sodium bisulfite (0.83 g), and dodecylbenzene (13 ml) were added into a reaction vessel and heated up to 210°C. After the obtained product was stirred for 23 hours, the product was cooled, and toluene (26 ml) and methanol (26 ml) were added. A precipitated solid was collected by filtration and washed with a methanol/water (1/5, v/v) mixed solution (120 ml). The precipitated solid was crystallized with 1,2-dichlorobenzene followed by crystallization with methanol to obtain a white powder of 4,4"-bis{(phenanthren-9-yl)-phenylamino}-1,1':4',1"-terp henyl (Compound 1-3; 9.38 g; yield 47%).

The structure of the obtained yellow powder was identified by NMR.

¹H-NMR (THF-ds) detected 40 hydrogen signals, as follows.

δ (ppm) = 8.88-8.73 (4H), 8.09 (2H), 7.71 (2H), 7.68-7.41 (18H), 7.21-7.10 (12H), 6.92 (2H).

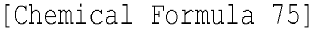

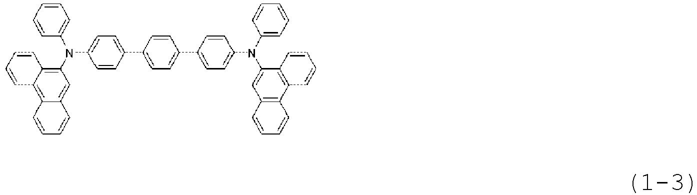

### Example 9

### <Synthesis of 4,4"-bis{(biphenyl-3-yl)-phenylamino}-1,1':4',1"-terphen yl (Compound 1-5)>

(Biphenyl-3-yl)-phenylamine (12.7 g), 4,4"-diiodo-1,1':4',1"-terphenyl (11.3 g), a copper powder (0.30 g), potassium carbonate (9.72 g), 3,5-di-tert-butylsalicylic acid (1.17 g), sodium bisulfite (0.73 g), and dodecylbenzene (23 ml) were added into a reaction vessel and heated up to 220°C. After the obtained product was stirred for 21 hours, the product was cooled, and after 1,2-dichlorobenzene (250 ml) and silica (30 g) were added, insoluble matter was removed by filtration. After the filtrate was concentrated under reduced pressure, heptane was added. A precipitated solid was collected by filtration, and the precipitated solid was crystallized with a 1,2-dichlorobenzene/heptane mixed solvent and further crystallized with a 1,2-dichlorobenzene/methanol mixed solvent to obtain a pale brown powder of 4,4"-bis{(biphenyl-3-yl)-phenylamino}-1,1':4',1"-terphen yl (Compound 1-5; 10.8 g; yield 64%).

The structure of the obtained pale brown powder was identified by NMR.

¹H-NMR (THF-ds) detected 40 hydrogen signals, as follows.

δ (ppm) = 7.69 (4H), 7.60 (4H), 7.52 (4H), 7.42-7.21 (16H), 7.20-7.13 (8H), 7.10-7.00 (4H).

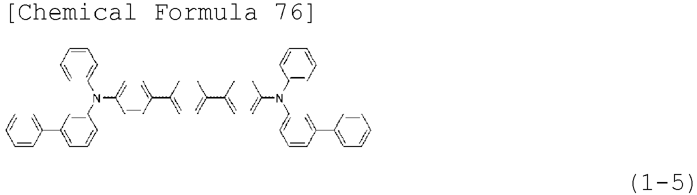

### Example 10

### <Synthesis of 4,4"-bis{(triphenylen-2-yl)-phenylamino}-1,1':4',1"-terp henyl (Compound 1-23)>

(Triphenylen-2-yl)-phenylamine (11.9 g), 4,4"'-diiodo-1,1':4',1"-terphenyl (8.55 g), tert-butoxy sodium (4.09 g), and xylene (86 ml) were added into a reaction vessel and aerated with nitrogen gas for 40 minutes under ultrasonic irradiation. Palladium acetate (0.08 g) and a toluene solution (0.55 ml) containing 50% (w/v) tri-tert-butylphosphine were added, and the mixture was heated up to 100°C. After the mixture was stirred for 7 hours, the mixture was cooled. Methanol (80 ml) was added, and a precipitated solid was collected by filtration. 1,2-dichlorobenzene (300 ml) was added to the obtained solid, and the solid was heated, and after silica gel (45 g) was added, insoluble matter was removed by filtration. The filtrate was concentrated under reduced pressure, and after purified by recrystallization with 1,2-dichlorobenzene, the purified product was washed under reflux with methanol to obtain a pale yellowish green powder of 4,4"-bis{(triphenylen-2-yl)-phenylamino}-1,1':4',1"-terp henyl (Compound 1-23; 11.4 g; yield 74%).

The structure of the obtained pale yellowish green powder was identified by NMR.

¹H-NMR (THF-ds) detected 44 hydrogen signals, as follows.

δ (ppm) = 8.72-8.62 (8H), 8.45 (2H), 8.36 (2H), 7.75 (4H), 7.70-7.21 (26H), 7.09 (2H).

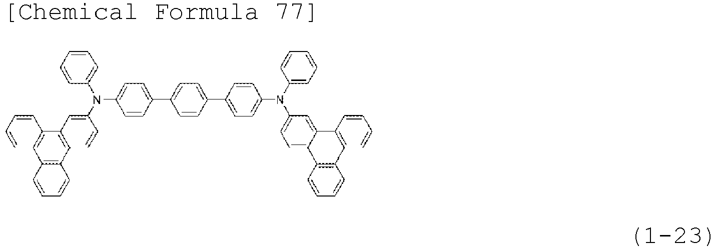

### Example 11

### <Synthesis of 4,4"-bis{di(naphthalen-2-yl)amino}-1,1':4',1"-terphenyl (Compound 1-24)>

Di(naphthalen-2-yl)amine (12.2 g), 4,4"-diiodo-1,1':4',1"-terphenyl (9.49 g), a copper powder (0.14 g), potassium carbonate (8.2 g), 3,5-di-tert-butylsalicylic acid (0.51 g), sodium bisulfite (0.69 g), dodecylbenzene (15 ml), and toluene (20 ml) were added into a reaction vessel and heated up to 210°C while removing the toluene by distillation. After the obtained product was stirred for 28 hours, the product was cooled, and 1,2-dichlorobenzene (20 ml) and methanol (20 ml) were added. A precipitated solid was collected by filtration and washed with a methanol/water (1/4, v/v) mixed solution (200 ml). Then, the solid was dissolved under heat after adding 1,2-dichlorobenzene (100 ml), and after silica gel was added, insoluble matter was removed by filtration. After the filtrate was left to cool, methanol (250 ml) was added, and a precipitated solid was collected by filtration. The precipitated solid was crystallized with a 1,2-dichlorobenzene/methanol mixed solvent followed by washing under reflux with methanol to obtain a yellowish white powder of 4,4"-bis{di(naphthalen-2-yl)amino}-1,1':4',1"-terphenyl (Compound 1-24; 10.5 g; yield 70%).

The structure of the obtained yellowish white powder was identified by NMR.

¹H-NMR (THF-ds) detected 40 hydrogen signals, as follows.

δ (ppm) = 7.82-7.75 (6H), 7.72 (4H), 7.68-7.60 (8H), 7.56 (4H), 7.40-7.30 (14H), 7.24 (4H).

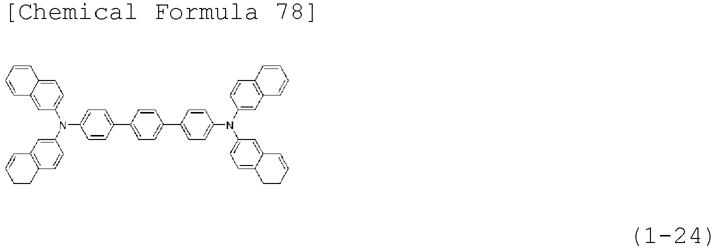

### Example 12

### <Synthesis of 4,4"-bis[{4-(naphthalen-2-yl)phenyl}-phenylamino]-1,1':4' ,1"-terphenyl (Compound 1-25)>

{4-(Naphthalen-2-yl)phenyl}-phenylamine (16.6 g), 4,4"-diiodo-1,1':4',1"-terphenyl (11.8 g), a copper powder (0.18 g), potassium carbonate (10.5 g), 3,5-di-tert-butylsalicylic acid (0.61 g), sodium bisulfite (0.83 g), dodecylbenzene (15 ml), and toluene (20 ml) were added into a reaction vessel and heated up to 210°C while removing the toluene by distillation. After the obtained product was stirred for 19 hours, the product was cooled, and toluene (20 ml) and methanol (20 ml) were added. A precipitated solid was collected by filtration, washed with a methanol/water (1/4, v/v) mixed solution (180 ml), and further washed with methanol (100 ml). An obtained brownish yellow powder was heated after adding 1,2-dichlorobenzene (175 ml), and insoluble matter was removed by filtration. After the filtrate was left to cool, methanol (200 ml) was added, and a precipitated solid was collected by filtration. The precipitated solid was crystallized with a 1,2-dichlorobenzene/methanol mixed solvent followed by washing under reflux with methanol to obtain a brownish white powder of 4,4"-bis[{4-(naphthalen-2-yl)phenyl}-phenylamino]-1,1':4' ,1"-terphenyl (Compound 1-25; 11.9 g; yield 53%).

The structure of the obtained brownish white powder was identified by NMR.

¹H-NMR (THF-ds) detected 44 hydrogen signals, as follows.

δ (ppm) = 8.10 (2H), 7.93-7.78 (8H), 7.76-7.70 (8H), 7.62 (4H), 7.44 (4H), 7.30 (4H), 7.25-7.16 (12H), 7.05 (2H).

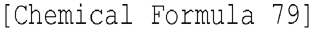

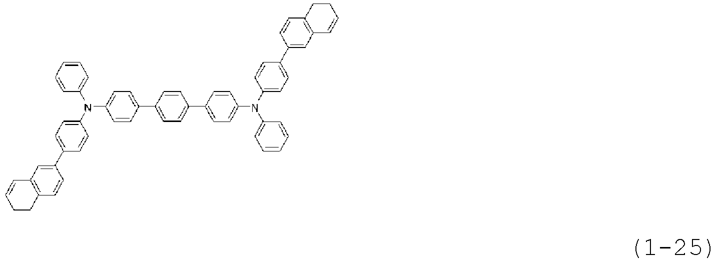

### Example 13

### <Synthesis of 4-{ (biphenyl-4-yl)-phenylamino}-4"-[{4-(1-phenyl-indol-4-yl)phenyl}-phenylamino]-1,1':4',1"'-terphenyl (Compound 1-26)>

(4'-Bromo-1,1'-biphenyl-4-yl)-{4-(1-phenyl-indol-4-y l)phenyl}-phenylamine (7.25 g), {4-(4,4,5,5-tetramethyl-1,3,2-dioxabororan-2-yl)phenyl}-(1 ,1'-biphenyl-4-yl)-phenylamine (5.76 g), a 2 M potassium carbonate aqueous solution (12.3 ml), toluene (80 ml), and ethanol (20 ml) were added into a reaction vessel and aerated with nitrogen gas for 40 minutes under ultrasonic irradiation. After adding tetrakistriphenylphosphinepalladium (0.43 g), the mixture was heated and refluxed for 7 hours while being stirred. After the mixture was left to cool, water (50 ml) and toluene (100 ml) were added, and insoluble matter was removed by filtration. An organic layer was collected by liquid separation, then dried over anhydrous magnesium sulfate and concentrated under reduced pressure to obtain a crude product. After the crude product was purified by column chromatography (support: silica gel, eluent: toluene/heptane), the purified product was crystallized with THF followed by crystallization with methanol to obtain a pale yellow powder of 4-{ (biphenyl-4-yl)-phenylamino}-4"-[{4-(1-phenyl-indol-4-yl)phenyl}-phenylamino]-1,1':4',1"'-terphenyl (Compound 1-26; 6.80 g; yield 67%).

The structure of the obtained pale yellow powder was identified by NMR.

¹H-NMR (THF-ds) detected 45 hydrogen signals, as follows.

δ (ppm) = 7.70 (4H), 7.68-7.50 (16H), 7.42-7.11 (23H), 7.05 (1H), 6.88 (1H).

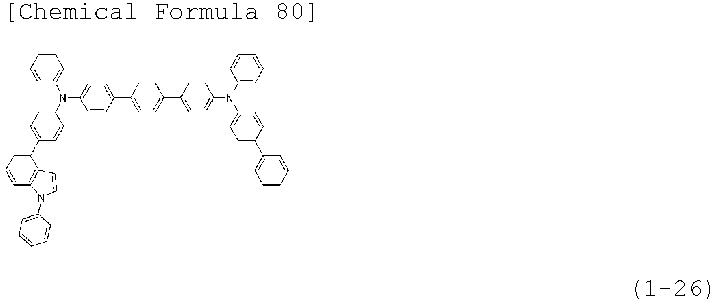

### Example 14

### <Synthesis of 4,4"-bis{(biphenyl-4-yl)-phenylamino}-1,1':3',1"-terphen yl (Compound 1-27)>

3-Bromoiodobenzene (8.83 g), (biphenyl-4-yl)-{4-(4,4,5,5-tetramethyl-[1,3,2]dioxaborola n-2-yl)phenyl}-phenylamine (30.5 g), potassium carbonate (13.0 g), water (30 ml), toluene (300 ml), and ethanol (75 ml) were added into a nitrogen-substituted reaction vessel and aerated with nitrogen gas under ultrasonic irradiation for 30 minutes. The mixture was heated after adding tetrakis(triphenylphosphine) palladium (1.1 g), and stirred at 80°C for 16 hours. The mixture was cooled to a room temperature, and methanol (300 ml) was added. A precipitated solid was collected by filtration, and the solid was dissolved under heat after adding 1,2-dichlorobenzene (270 ml). Silica gel (16 g) was added, and the mixture was stirred for 30 minutes. After insoluble matter was removed by filtration, a crude product precipitated by adding methanol (300 ml) was collected by filtration. The crude product was washed under reflux with methanol (200 ml) to obtain a white powder of 4,4"-bis{(biphenyl-4-yl)-phenylamino}-1,1':3',1"-terphen yl (Compound 1-27; 14.3 g; yield 71%).

The structure of the obtained white powder was identified by NMR.

¹H-NMR (CDCl₃) detected 40 hydrogen signals, as follows.

δ (ppm) = 7.87 (1H), 7.64-7.50 (12H), 7.48-7.32 (6H), 7.31-6.98 (21H).

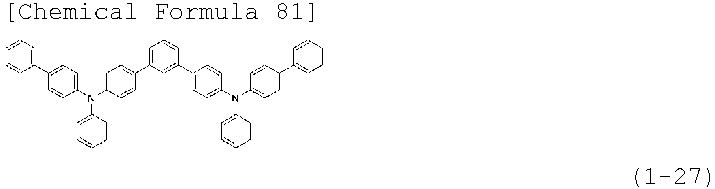

### Example 15

### <Synthesis of 4,4"-bis{(biphenyl-4-yl)-(phenyl-d₅)amino}-1,1':3',1"-te rphenyl (Compound 1-28)>

1,3-dibromobenzene (6.51 g), (biphenyl-4-yl)-{4-(4,4,5,5-tetramethyl-[1,3,2]dioxaborola n-2-yl)phenyl}-(phenyl-d₅)amine (26.9 g), potassium carbonate (11.4 g), water (50 ml), toluene (200 ml), and ethanol (50 ml) were added into a nitrogen-substituted reaction vessel and aerated with nitrogen gas under ultrasonic irradiation for 30 minutes. The mixture was heated after adding tetrakis(triphenylphosphine)palladium (0.95 g), and stirred at 70°C for 12 hours. The mixture was cooled to a room temperature, and methanol (200 ml) was added. A precipitated solid was collected by filtration, and the solid was dissolved under heat after adding 1,2-dichlorobenzene (400 ml). Silica gel (20 g) was added, and the mixture was stirred for 30 minutes. After insoluble matter was removed by filtration, a precipitate formed by adding methanol (500 ml) was collected by filtration. The precipitate was dissolved by adding 1,2-dichlorobenzene (100ml), and a crude product precipitated by adding toluene (100 ml) and methanol (100 ml) was collected by filtration. The crude product was washed under reflux with methanol (250 ml) to obtain a white powder of 4,4"-bis{(biphenyl-4-yl)-(phenyl-d₅)amino}-1,1':3',1"-te rphenyl (Compound 1-28; 18.3 g; yield 91%).

The structure of the obtained white powder was identified by NMR.

¹H-NMR (CDCl₃) detected 30 hydrogen signals, as follows.

δ (ppm) = 7.87 (1H), 7.64-7.32 (18H), 7.31-6.98 (11H).

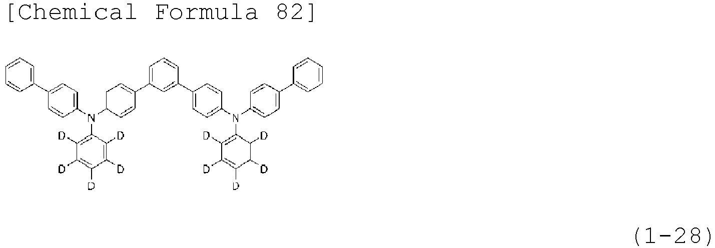

### Example 16

### <Synthesis of 4,4"-bis{(naphthalen-1-yl)-phenylamino}-1,1':3',1"-terph enyl (Compound 1-29)>

The reaction was carried out under the same conditions as those of Example 15, except that (biphenyl-4-yl)-14-(4,4,5,5-tetramethyl-[1,3,2]dioxaborola n-2-yl)phenyl}-(phenyl-d₅)amine was replaced with (naphthalen-1-yl)-{4-(4,4,5,5-tetramethyl-[1,3,2]dioxaboro lan-2-yl)phenyl}-phenylamine. As a result, a white powder of 4,4"-bis{(naphthalen-1-yl)-phenylamino}-1,1':3',1"-terph enyl (Compound 1-29; 8.8 g; yield 59%) was obtained.

The structure of the obtained white powder was identified by NMR.

¹H-NMR (CDCl₃) detected 36 hydrogen signals, as follows.

δ (ppm) = 7.99 (2H), 7.92 (2H), 7.81 (2H), 7.72 (1H), 7.57-6.92 (29H).

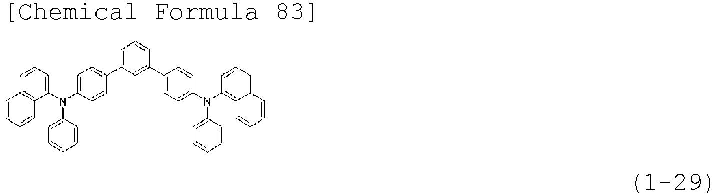

### Example 17

### <Synthesis of 4,4"-bis[{4-(dibenzofuran-4-yl)phenyl}-phenylamino]-1,1': 3',1"-terphenyl (Compound 1-32)>

The reaction was carried out under the same conditions as those of Example 15, except that (biphenyl-4-yl)-14-(4,4,5,5-tetramethyl-[1,3,2]dioxaborola n-2-yl)phenyl}-(phenyl-d₅)amine was replaced with {4-(dibenzofuran-4-yl)phenyl}-{4-(4,4,5,5-tetramethyl-[1,3 ,2]dioxaborolan-2-yl)phenyl}-phenylamine. As a result, a white powder of 4,4"-bis[{4-(dibenzofuran-4-yl)phenyl}-phenylamino]-1,1': 3',1"-terphenyl (Compound 1-32; 6.8 g; yield 86%) was obtained.

The structure of the obtained white powder was identified by NMR.

¹H-NMR (CDCl₃) detected 44 hydrogen signals, as follows.

δ (ppm) = 8.01 (2H), 7.97-7.82 (8H), 7.67-7.24 (34H).

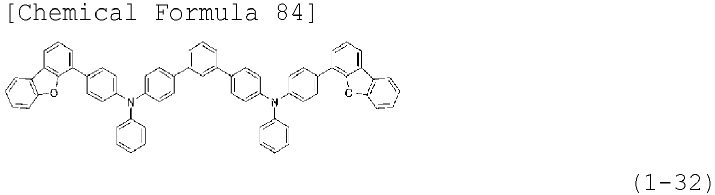

### Example 18

### <Synthesis of 2,4"-bis{(biphenyl-4-yl)-phenylamino}-1,1':4',1"-terphen yl (Compound 1-50)>

4-Bromo-4'-{ (biphenyl-4-yl)-phenylamino}-biphenyl (16.8 g), (biphenyl-4-yl)-{2-(4,4,5,5-tetramethyl-[1,3,2]dioxaborola n-2-yl)phenyl}-phenylamine (19.0 g), potassium carbonate (7.4 g), water (26 ml), toluene (200 ml), and ethanol (50 ml) were added into a nitrogen-substituted reaction vessel and aerated with nitrogen gas under ultrasonic irradiation for 30 minutes. After adding tetrakis(triphenylphosphine) palladium (0.87 g), the mixture was heated and refluxed for 20 hours while being stirred. After the mixture was cooled to a room temperature, an organic layer was collected by liquid separation, then dried over anhydrous magnesium sulfate and concentrated to obtain a crude product. After the crude product was purified by column chromatography (support: silica gel, eluent: heptane/toluene), the purified product was crystallized with an ethyl acetate/methanol mixed solvent to obtain a white powder of 2,4"-bis{(biphenyl-4-yl)-phenylamino}-1,1':4',1"-terphen yl (Compound 1-50; 20.8 g; yield 82%).

The structure of the obtained white powder was identified by NMR.

¹H-NMR (CDCl₃) detected 40 hydrogen signals, as follows.

δ (ppm) = 7.61 (2H), 7.56-6.83 (38H).

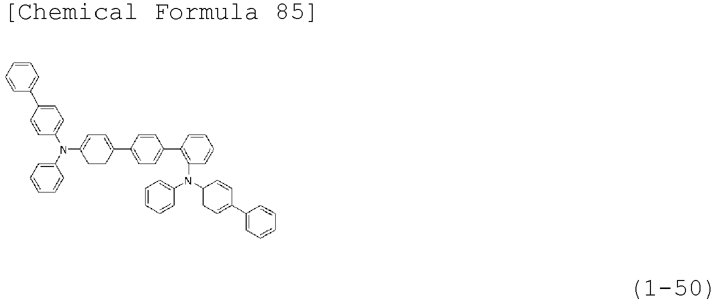

### Example 19

### <Synthesis of 4,4"-bis{(triphenylen-2-yl)-phenylamino}-1,1':3',1"-terp henyl (Compound 1-51)>

4,4"-Dibromo-1,1':3',1"-terphenyl (8.2 g), (triphenylen-2-yl)-phenylamine (15.4 g), tert-butoxy sodium (5.1 g), and toluene (180 ml) were added into a nitrogen-substituted reaction vessel and aerated with nitrogen gas under ultrasonic irradiation for 30 minutes. Palladium acetate (0.11 g) and a toluene solution (0.31 ml) containing 50% (w/v) tri-tert-butylphosphine were added, and the mixture was heated and refluxed for 5 hours while being stirred.

The mixture was cooled to a room temperature and subjected to an extraction procedure using 1,2-dichlorobenzene and then to purification by adsorption with a silica gel, followed by crystallization with a 1,2-dichlorobenzene/methanol mixed solvent to obtain a yellowish white powder of 4,4"-bis{(triphenylen-2-yl)-phenylamino}-1,1':3',1"-terp henyl (Compound 1-51; 11.67 g; yield 64%).

The structure of the obtained yellowish white powder was identified by NMR.

¹H-NMR (CDCl₃) detected 44 hydrogen signals, as follows.

δ (ppm) = 8.67 (4H), 8.57 (4H), 8.41 (2H), 8.36 (2H), 7.88 (1H), 7.70-7.10 (31H).

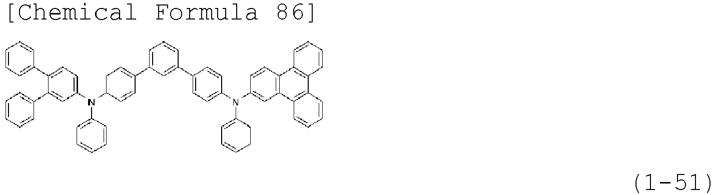

### Example 20

### <Synthesis of 4,4"-bis{(phenanthren-9-yl)-phenylamino}-1,1':3',1"-terp henyl (Compound 1-52)>

The reaction was carried out under the same conditions as those of Example 19, except that (triphenylen-2-yl)-phenylamine was replaced with (phenanthren-9-yl)-phenylamine. As a result, a yellowish white powder of 4,4"-bis{(phenanthren-9-yl)-phenylamino}-1,1':3',1"-terp henyl (Compound 1-52; 8.0 g; yield 50%) was obtained.

The structure of the obtained yellowish white powder was identified by NMR.

¹H-NMR (CDCl₃) detected 40 hydrogen signals, as follows.

δ (ppm) = 8.81-8.71 (4H), 8.10 (2H), 7.83-7.39 (20H), 7.29-6.97 (14H).

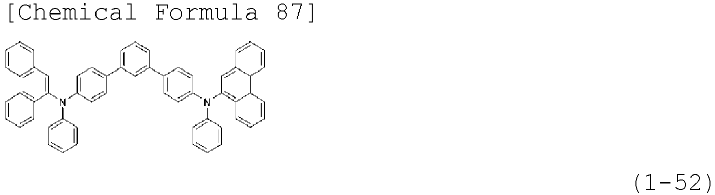

### Example 21

### <Synthesis of 4-{bis(biphenyl-4-yl)amino}-2"-{(biphenyl-4-yl)-phenylami no}-1,1':4',1"'-terphenyl (Compound 1-53)>

2-{(biphenyl-4-yl)-phenylamino}-4"-bromo-1,1':4',1' '-terphenyl (12.1 g), bis(biphenyl-4-yl)amine (8.0 g), tris(dibenzylideneacetone)palladium (0.6 g), tri-tert-butylphosphine (0.22 g), and tert-butoxy sodium (6.3 g) were added into a nitrogen-substituted reaction vessel, heated and refluxed for 3 hours while being stirred. After the mixture was cooled to a room temperature, methanol (600 ml) was added, and a precipitated crude product was collected by filtration. The crude product was dissolved in toluene, and after insoluble matter was removed by filtration, purification by crystallization with methanol was carried out. Then, recrystallization with a THF/methanol mixed solvent was carried out to obtain a white powder of 4-{bis(biphenyl-4-yl)amino}-2"-{(biphenyl-4-yl)-phenylami no}-1,1':4',1"-terphenyl (Compound 1-53; 15 g; yield 87%).

The structure of the obtained white powder was identified by NMR.

¹H-NMR (CDCl₃) detected 44 hydrogen signals, as follows.

δ (ppm) = 7.62 (4H), 7.58-6.91 (38H), 6.87 (2H).

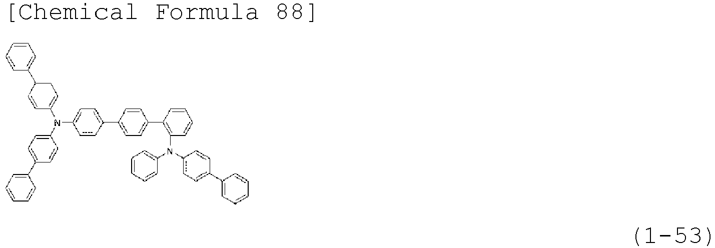

### Example 22

### <Synthesis of 4,4"-bis{(naphthalen-1-yl)-(phenyl-d₅)amino}-1,1':3',1"-terphenyl (Compound 1-54)>

The reaction was carried out under the same conditions as those of Example 15, except that (biphenyl-4-yl)-14-(4,4,5,5-tetramethyl-[1,3,2]dioxaborola n-2-yl)phenyl}-(phenyl-d₅)amine was replaced with (naphthalen-1-yl)-14-(4,4,5,5-tetramethyl-[1,3,2]dioxaboro lan-2-yl)phenyl(phenyl-d₅)amine. As a result, a white powder of 4,4"-bis{(naphthalen-1-yl)-(phenyl-d₅)amino}-1,1':3',1"-terphenyl (Compound 1-54; 5.2 g; yield 30%) was obtained.

The structure of the obtained white powder was identified by NMR.

¹H-NMR (CDCl₃) detected 26 hydrogen signals, as follows.

δ (ppm) = 7.99 (2H), 7.92 (2H), 7.81 (2H), 7.72 (1H), 7.55-7.36 (15H), 7.13-7.07 (4H).

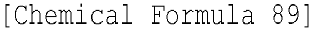

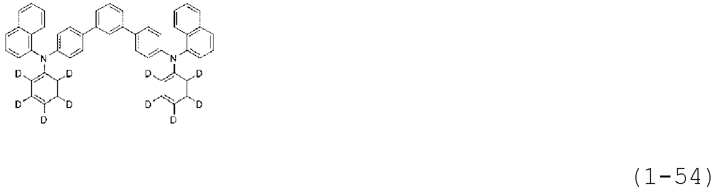

### Example 23

### <Synthesis of 2-{bis(biphenyl-4-yl)amino}-4"-{ (biphenyl-4-yl)-phenylami no}-1,1':4',1"-terphenyl (Compound 1-56)>

The reaction was carried out under the same conditions as those of Example 18, except that (biphenyl-4-yl)-{2-(4,4,5,5-tetramethyl-[1,3,2]dioxaborola n-2-yl)phenyl}-phenylamine was replaced with bis(biphenyl-4-yl)-{2-(4,4,5,5-tetramethyl-[1,3,2]dioxabor olan-2-yl)phenyl}amine. As a result, a white powder of 2-{bis(biphenyl-4-yl)amino}-4"'-{(biphenyl-4-yl)-phenylami no}-1,1':4',1"-terphenyl (Compound 1-56; 15.7 g; yield 94%) was obtained.

The structure of the obtained white powder was identified by NMR.

¹H-NMR (CDCl₃) detected 44 hydrogen signals, as follows.

δ (ppm) = 7.60 (2H), 7.56-6.97 (42H).

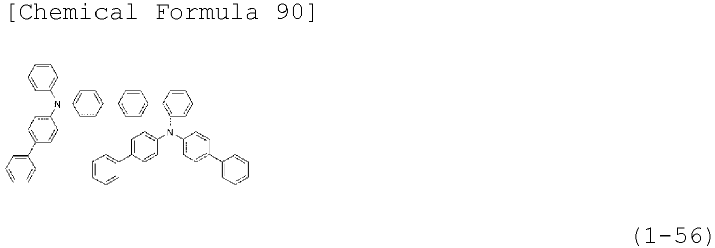

### Example 24

### <Synthesis of 2,4"-bis{bis(biphenyl-4-yl)amino}-1,1':4',1"-terphenyl (Compound 1-57)>

The reaction was carried out under the same conditions as those of Example 18, except that 4-bromo-4'-{(biphenyl-4-yl)-phenylamino}-biphenyl was replaced with 4-bromo-4'-{bis(biphenyl-4-yl)amino}-biphenyl, and (biphenyl-4-yl)-{2-(4,4,5,5-tetramethyl-[1,3,2]dioxaborola n-2-yl)phenyl}-phenylamine was replaced with 2-{bis(biphenyl-4-yl)amino}phenylboronic acid. As a result, a white powder of 2,4"-bis{bis(biphenyl-4-yl)amino}-1,1':4',1"-terphenyl (Compound 1-57; 12 g; yield 76%) was obtained.

The structure of the obtained white powder was identified by NMR.

¹H-NMR (CDCl₃) detected 48 hydrogen signals, as follows.

δ (ppm) = 7.65-6.98 (48H).

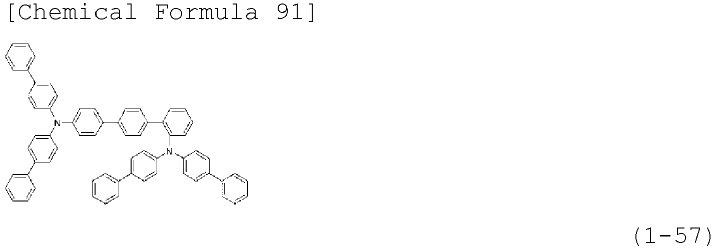

### Example 25

### <Synthesis of 4,4"-bis{(biphenyl-4-yl)-(naphthalen-1-yl)amino}-1,1':3', 1"-terphenyl (Compound 1-59)>

The reaction was carried out under the same conditions as those of Example 19, except that (triphenylen-2-yl)-phenylamine was replaced with (biphenyl-4-yl)-(naphthalen-1-yl)amine. As a result, a white powder of 4,4"-bis{(biphenyl-4-yl)-(naphthalen-1-yl)amino}-1,1':3', 1"-terphenyl (Compound 1-59; 6.4 g; yield 36%) was obtained.

The structure of the obtained white powder was identified by NMR.

¹H-NMR (CDCl₃) detected 44 hydrogen signals, as follows.

δ (ppm) = 8.02 (2H), 7.94 (2H), 7.84 (2H), 7.76 (1H), 7.62-7.38 (27H), 7.33 (2H), 7.19-7.13 (8H).

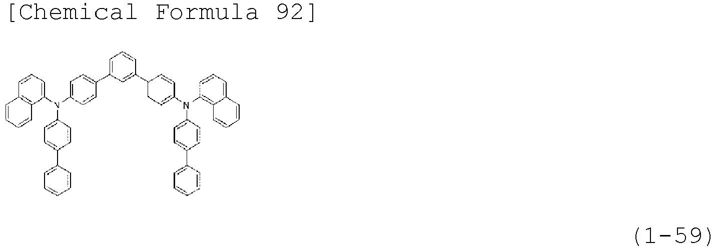

### Example 26

### <Synthesis of 4,4"'-bis{(9,9-dimethyl-9H-fluoren-2-yl)-phenylamino}-1,1' :3',1"-terphenyl (Compound 1-60)>

The reaction was carried out under the same conditions as those of Example 19, except that (triphenylen-2-yl)-phenylamine was replaced with (9,9-dimethyl-9H-fluoren-2-yl)-phenylamine. As a result, a white powder of 4,4"-bis{(9,9-dimethyl-9H-fluoren-2-yl)-phenylamino}-1,1' :3',1"-terphenyl (Compound 1-60; 14.6 g; yield 80%) was obtained.

The structure of the obtained white powder was identified by NMR.

¹H-NMR (CDCl₃) detected 48 hydrogen signals, as follows.

δ (ppm) = 7.84 (1H), 7.70-7.03 (35H), 1.48 (12H).

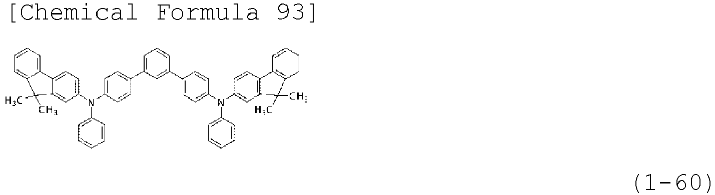

### Example 27

### <Synthesis of 2-{bis(biphenyl-4-yl)amino}-4"-{(naphthalen-1-yl)-phenyla mino}-1,1':4',1"-terphenyl (Compound 1-62)>

The reaction was carried out under the same conditions as those of Example 18, except that 4-bromo-4'-{(biphenyl-4-yl)-phenylamino}-biphenyl was replaced with 4-bromo-4'-{(naphthalen-1-yl)-phenylamino}-biphenyl, and (biphenyl-4-yl)-{2-(4,4,5,5-tetramethyl-[1,3,2]dioxaborola n-2-yl)phenyl}-phenylamine was replaced with 2-{bis(biphenyl-4-yl)amino}phenylboronic acid. As a result, a white powder of 2-{bis(biphenyl-4-yl)amino}-4"-{(naphthalen-1-yl)-phenyla mino}-1,1':4',1"-terphenyl (Compound 1-62; 12.8 g; yield 75%) was obtained.

The structure of the obtained white powder was identified by NMR.

¹H-NMR (CDCl₃) detected 42 hydrogen signals, as follows.

δ (ppm) = 7.99 (2H), 7.93 (2H), 7.81 (2H), 7.57-6.96 (36H) .

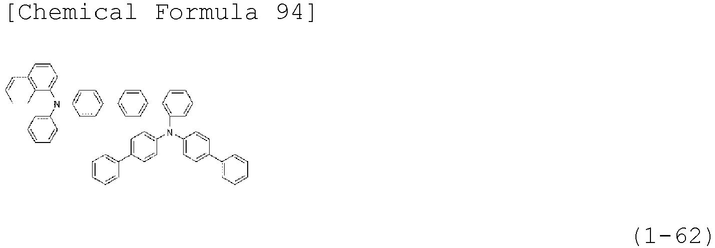

### Example 28

### <Synthesis of 2-{(biphenyl-4-yl)-phenylamino}-4"-{(9,9-dimethyl-9H-fluo ren-2-yl)-phenylamino}-1,1':4',1"-terphenyl (Compound 1-63)>

The reaction was carried out under the same conditions as those of Example 18, except that 4-bromo-4'-{(biphenyl-4-yl)-phenylamino}-biphenyl was replaced with 4-bromo-4'-{(9,9-dimethyl-9H-fluoren-2-yl)-phenylamino}-bi phenyl. As a result, a white powder of 2-{(biphenyl-4-yl)-phenylamino}-4"-{(9,9-dimethyl-9H-fluo ren-2-yl)-phenylamino}-1,1':4',1"-terphenyl (Compound 1-63; 11.7 g; yield 73%) was obtained.

The structure of the obtained white powder was identified by NMR.

¹H-NMR (CDCl₃) detected 44 hydrogen signals, as follows.

δ (ppm) = 7.68 (1H), 7.64-6.84 (37H), 1.48 (6H).

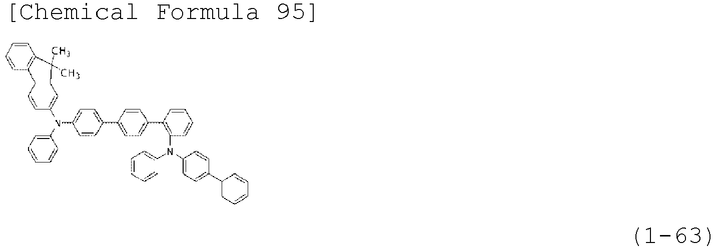

### Example 29

### <Synthesis of 4,4"-bis{(biphenyl-4-yl)-(naphthalen-1-yl)amino}-1,1':2', 1"-terphenyl (Compound 1-67)>

The reaction was carried out under the same conditions as those of Example 19, except that 4,4"-dibromo-1,1':3',1"-terphenyl was replaced with 4,4"-dibromo-1,1':2',1"-terphenyl, and (triphenylen-2-yl)-phenylamine was replaced with (biphenyl-4-yl)-(naphthalen-1-yl)amine. As a result, a white powder of 4,4"-bis{(biphenyl-4-yl)-(naphthalen-1-yl)amino}-1,1':2', 1"-terphenyl (Compound 1-67; 5.0 g; yield 30%) was obtained.

The structure of the obtained white powder was identified by NMR.

¹H-NMR (CDCl₃) detected 44 hydrogen signals, as follows.

δ (ppm) = 7.93-7.84 (4H), 7.79 (2H), 7.60-7.26 (24H), 7.25-6.92 (14H).

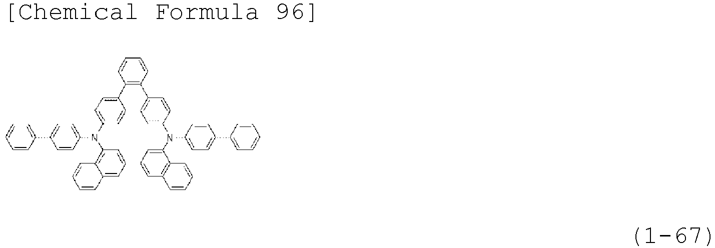

### Example 30

### <Synthesis of 4,4"-bis[{4-(naphthalen-1-yl)phenyl}-phenylamino]-1,1':2' ,1"-terphenyl (Compound 1-68)>

The reaction was carried out under the same conditions as those of Example 19, except that 4,4"-dibromo-1,1':3',1"-terphenyl was replaced with 4,4"'-dibromo-1,1':2',1"-terphenyl, and (triphenylen-2-yl)-phenylamine was replaced with {4-(naphthalen-1-yl)phenyl}-phenylamine. As a result, a white powder of 4,4"-bis[{4-(naphthalen-1-yl)phenyl}-phenylamino]-1,1':2' ,1"-terphenyl (Compound 1-68; 7.3 g; yield 43%) was obtained.

The structure of the obtained white powder was identified by NMR.

¹H-NMR (CDCl₃) detected 44 hydrogen signals, as follows.

δ (ppm) = 8.01 (2H), 7.91 (2H), 7.84 (2H), 7.53-6.98 (38H) .

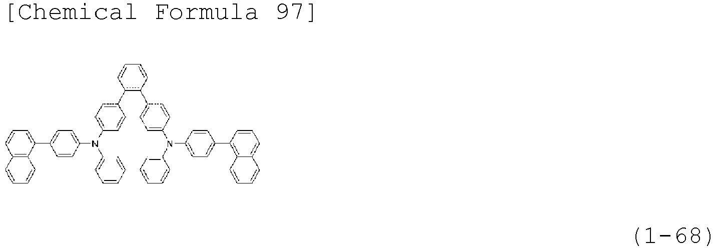

### Example 31

### <Synthesis of 2,2"-bis[{4-(naphthalen-1-yl)phenyl}-phenylamino]-1,1':3' ,1"-terphenyl (Compound 1-69)>

The reaction was carried out under the same conditions as those of Example 14, except that 3-bromoiodobenzene was replaced with 1,3-diiodobenzene, and (biphenyl-4-yl)-{4-(4,4,5,5-tetramethyl-[1,3,2]dioxaborola n-2-yl)phenyl}-phenylamine was replaced with 2-[{4-(naphthalen-1-yl)phenyl}-phenylamino]-phenylboronic acid. As a result, a white powder of 2,2"-bis[{4-(naphthalen-1-yl)phenyl}-phenylamino]-1,1':3' ,1"-terphenyl (Compound 1-69; 7.3 g; yield 43%) was obtained.

The structure of the obtained white powder was identified by NMR.

¹H-NMR (CDCl₃) detected 44 hydrogen signals, as follows.

δ (ppm) = 7.94-6.85 (44H).

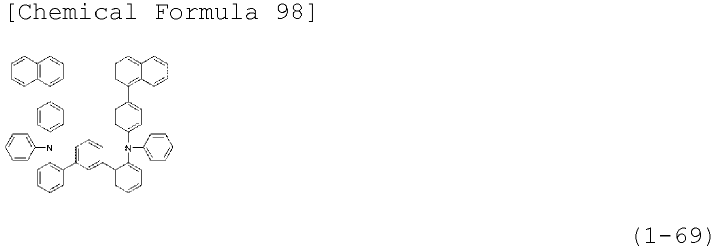

### Example 32

### <Synthesis of 4,4"-bis[{4-(naphthalen-1-yl)phenyl}-phenylamino]-1,1':3' ,1"-terphenyl (Compound 1-71)>

The reaction was carried out under the same conditions as those of Example 19, except that (triphenylen-2-yl)-phenylamine was replaced with {4-(naphthalen-1-yl)phenyl}-phenylamine. As a result, a white powder of 4,4"-bis[{4-(naphthalen-1-yl)phenyl}-phenylamino]-1,1':3' ,1"-terphenyl (Compound 1-71; 16.7 g; yield 79%) was obtained.

The structure of the obtained white powder was identified by NMR.

¹H-NMR (CDCl₃) detected 44 hydrogen signals, as follows.

δ (ppm) = 8.08 (2H), 7.94 (2H), 7.90-7.80 (3H), 7.65-7.00 (37H) .

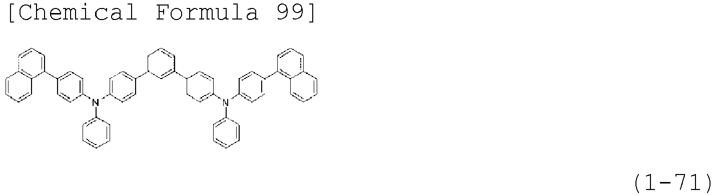

### Example 33

### <Synthesis of 2,2"-bis{(9,9-dimethyl-9H-fluoren-2-yl)-phenylamino}-1,1' :4',1"-terphenyl (Compound 1-75)>

The reaction was carried out under the same conditions as those of Example 15, except that 1,3-dibromobenzene was replaced with 1,4-dibromobenzene, and (biphenyl-4-yl)-{4-(4,4,5,5-tetramethyl-[1,3,2]dioxaborola n-2-yl)phenyl}-(phenyl-d₅)amine was replaced with 2-{ (9,9-dimethyl-9H-fluoren-2-yl)-phenylamino}-phenylboron ic acid. As a result, a white powder of 2,2"'-bis{ (9,9-dimethyl-9H-fluoren-2-yl)-phenylamino}-1,1' :4',1"-terphenyl (Compound 1-75; 13.7 g; yield 76%) was obtained.

The structure of the obtained white powder was identified by NMR.

¹H-NMR (THF-ds) detected 48 hydrogen signals, as follows.

δ (ppm) = 7.53 (2H), 7.35-6.81 (30H), 6.76 (2H), 6.67 (2H), 1.29 (12H).

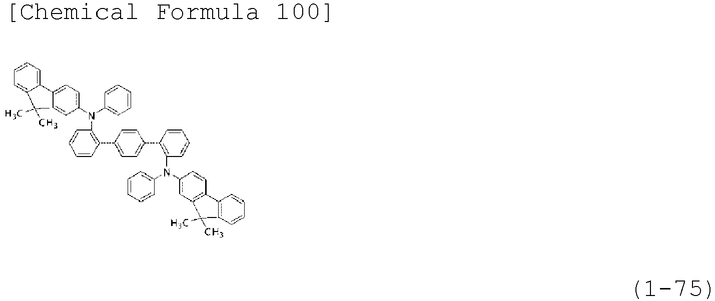

### Example 34

### <Synthesis of 2,2"-bis{bis(biphenyl-4-yl)amino}-1,1':4',1"-terphenyl (Compound 1-76)>

The reaction was carried out under the same conditions as those of Example 15, except that 1,3-dibromobenzene was replaced with 1,4-dibromobenzene, and (biphenyl-4-yl)-14-(4,4,5,5-tetramethyl-[1,3,2]dioxaborola n-2-yl)phenyl}-(phenyl-d₅)amine was replaced with 2-{bis(biphenyl-4-yl)amino}-phenylboronic acid. As a result, a white powder of 2,2"-bis{bis(biphenyl-4-yl)amino}-1,1':4',1"-terphenyl (Compound 1-76; 15.7 g; yield 78%) was obtained.

The structure of the obtained white powder was identified by NMR.

¹H-NMR (THF-ds) detected 48 hydrogen signals, as follows.

δ (ppm) = 7.51-7.45 (8H), 7.33-7.18 (28H), 7.00 (4H), 6.90-6.82 (8H).

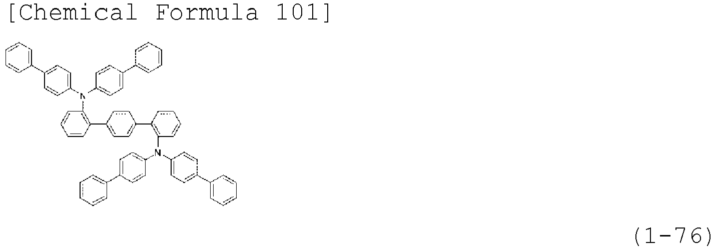

### Example 35

### <Synthesis of 2-{(9,9-dimethyl-9H-fluoren-2-yl)-phenylamino}-2"-[{4-(na phthalen-1-yl)phenyl}-phenylamino]-1,1':4',1"-terphenyl (Compound 1-81)>

The reaction was carried out under the same conditions as those of Example 18, except that 4-bromo-4'-{(biphenyl-4-yl)-phenylamino}-biphenyl was replaced with 4-bromo-2'-{4-(naphthalen-1-yl)phenyl}-phenylamino}-biphen yl, and (biphenyl-4-yl)-{2-(4,4,5,5-tetramethyl-[1,3,2]dioxaborola n-2-yl)phenyl}-phenylamine was replaced with 2-{ (9,9-dimethyl-9H-fluoren-2-yl)-phenylamino}-phenylboron ic acid. As a result, a white powder of 2-{(9,9-dimethyl-9H-fluoren-2-yl)-phenylamino}-2"-[{4-(na phthalen-1-yl)phenyl}-phenylamino]-1,1':4',1"-terphenyl (Compound 1-81; 7.3 g; yield 48%) was obtained.

The structure of the obtained white powder was identified by NMR.

¹H-NMR (THF-ds) detected 46 hydrogen signals, as follows.

δ (ppm) = 7.89-7.76 (3H), 7.55-6.69 (37H), 1.29 (6H).

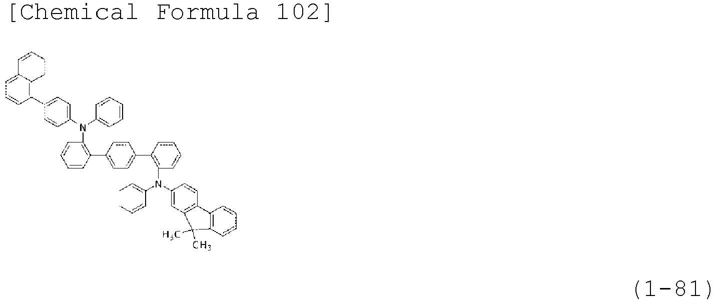

### Example 36

### <Synthesis of 4,4"-bis{N-phenyl-N-(2-phenyl-biphenyl-4-yl)amino}-1,1';4 ',1"-terphenyl (Compound 1-103)>

4,4"-diiodo-1,1';4',1"-terphenyl (13.0 g), N-phenyl-N-(2-phenyl-biphenyl-4-yl)amine (20.0 g), copper powder (0.18 g), potassium carbonate (11.3 g), 3,5-di-tert-butylsalicylic acid (0.7 g), sodium bisulfite (0.86 g), and dodecylbenzene (30 mL) were added into a nitrogen-substituted reaction vessel, and heated and stirred for 24 hours at 210°C. After cooling, xylene (30 mL) and methanol (60 mL) were added, and then a solid matter was collected by filtration. Toluene (250 mL) and silica gel (20 g) were added to the solid matter, and after stirring while heating to 90°C, insoluble matters were removed by hot filtration. After concentration, a crude product deposited by adding ethyl acetate and methanol was collected, and subjected to recrystallization from chlorobenzene and reflux washing with methanol, so as to obtain 16.9 g of white powder of 4,4"-bis{N-phenyl-N-(2-phenyl-biphenyl-4-yl)amino}-1,1';4 ',1"-terphenyl (Compound 1-103) (yield: 72%).

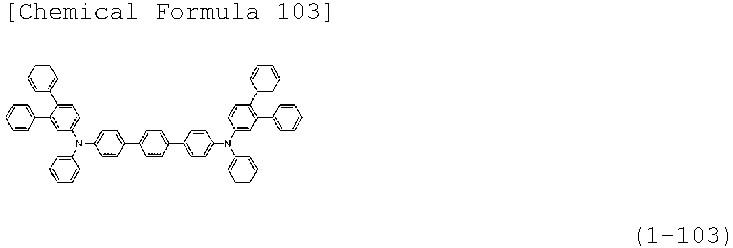

The structure of the obtained white powder was identified by NMR.

¹H-NMR (CDCl₃) detected 48 hydrogen signals, as follows.

δ (ppm) = 7.68(4H), 7.62-7.55(4H), 7.39-7.06(40H).

### Example 37

### <Synthesis of 4,4"'-bis{N-phenyl-N-(2-phenyl-biphenyl-4-yl)amino}-1,1';2 ',1"-terphenyl (Compound 1-104)>

The reaction was carried out under the same conditions as those of Example 19, except that 4,4"-dibromo-1,1':3',1"-terphenyl was replaced with 4,4"-dibromo-1,1':2',1"'-terphenyl, and (triphenylen-2-yl)phenylamine was replaced with N-phenyl-N-(2-phenyl-biphenyl-4-yl)amine. As a result, 4.3 g of white powder of 4,4"-bis{N-phenyl-N-(2-phenyl-biphenyl-4-yl)amino}-1,1';2 ',1"-terphenyl (Compound 1-104) (yield: 42%) was obtained.

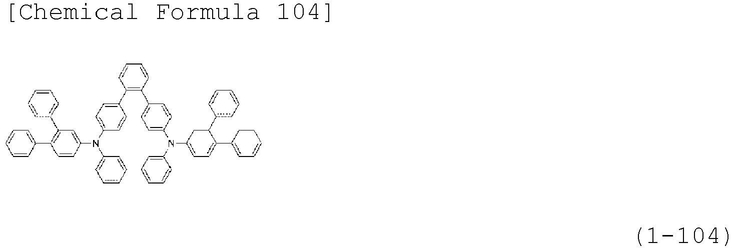

The structure of the obtained white powder was identified by NMR.

¹H-NMR (CDCl₃) detected 48 hydrogen signals, as follows.

δ (ppm) = 7.50-7.39(4H), 7.31-6.97(44H).

### Example 38

### <Synthesis of 4,4"-bis{N-phenyl-N-(2-phenyl-biphenyl-4-yl)amino}-1,1';3 ',1"-terphenyl (Compound 1-105)>

The reaction was carried out under the same conditions as those of Example 19, except that (triphenylen-2-yl)phenylamine was replaced with N-phenyl-N-(2-phenyl-biphenyl-4-yl)amine. As a result, 7.7 g of white powder of 4,4"-bis{N-phenyl-N-(2-phenyl-biphenyl-4-yl)amino}-1,1';3 ',1"-terphenyl (Compound 1-105) (yield: 53%) was obtained.

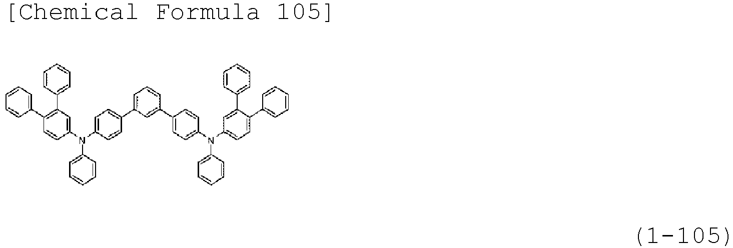

The structure of the obtained pale yellow powder was identified by NMR.

¹H-NMR (CDCl₃) detected 48 hydrogen signals, as follows.

δ (ppm) = 7.81(2H), 7.61-7.48(14H), 7.39-7.06(32H).

### Example 39

The melting points and the glass transition points of the arylamine compounds of the general formula (1), according to the present invention, were measured using a high-sensitive differential scanning calorimeter (DSC3100SA produced by Bruker AXS).

| | Melting point | Glass transition point |
|---|---|---|
| Compound of Example 1 | 263°C | 111°C |
| Compound of Example 2 | 210°C | 113°C |
| Compound of Example 3 | 265°C | 111°C |
| Compound of Example 4 | 279°C | 107°C |
| Compound of Example 5 | 266°C | 104°C |
| Compound of Example 6 | 263°C | 111°C |
| Compound of Example 7 | 262°C | 117°C |
| Compound of Example 8 | 303°C | 149°C |
| Compound of Example 10 | 365°C | 163°C |
| Compound of Example 11 | 289°C | 138°C |
| Compound of Example 13 | No melting point observed | 125°C |
| Compound of Example 14 | 252°C | 108°C |
| Compound of Example 15 | 252°C | 108°C |
| Compound of Example 16 | No melting point observed | 106°C |
| Compound of Example 17 | No melting point observed | 135°C |
| Compound of Example 18 | No melting point observed | 107°C |
| Compound of Example 19 | 323°C | 159°C |
| Compound of Example 20 | 290°C | 146°C |
| Compound of Example 21 | No melting point observed | 119°C |
| Compound of Example 22 | No melting point observed | 106°C |
| Compound of Example 23 | No melting point observed | 118°C |
| Compound of Example 24 | No melting point observed | 133°C |
| Compound of Example 25 | No melting point observed | 136°C |
| Compound of Example 26 | 286°C | 124°C |
| Compound of Example 27 | No melting point observed | 117°C |
| Compound of Example 28 | 218°C | 114°C |
| Compound of Example 29 | No melting point observed | 127°C |
| Compound of Example 31 | No melting point observed | 110°C |
| Compound of Example 32 | No melting point observed | 122°C |
| Compound of Example 33 | 269°C | 117°C |
| Compound of Example 34 | 277°C | 122°C |
| Compound of Example 35 | No melting point observed | 117°C |
| Compound of Example 36 | 249°C | 124°C |
| Compound of Example 37 | No melting point observed | 115°C |
| Compound of Example 38 | No melting point observed | 122°C |

The arylamine compounds of the general formula (1), according to the present invention, have glass transition points of 100°C or higher, demonstrating that the compounds have a stable thin-film state.

### Example 40

A 100 nm-thick vapor-deposited film was fabricated on an ITO substrate using the arylamine compounds of the general formula (1), according to the present invention, and a work function was measured using an ionization potential measuring device (PYS-202 produced by Sumitomo Heavy Industries, Ltd.).

| | Work function |
|---|---|
| Compound of Example 1 | 5.65 eV |
| Compound of Example 3 | 5.65 eV |
| Compound of Example 4 | 5.67 eV |
| Compound of Example 5 | 5.66 eV |
| Compound of Example 6 | 5.69 eV |
| Compound of Example 7 | 5.63 eV |
| Compound of Example 8 | 5.70 eV |
| Compound of Example 9 | 5.72 eV |
| Compound of Example 10 | 5.62 eV |
| Compound of Example 11 | 5.61 eV |
| Compound of Example 12 | 5.62 eV |
| Compound of Example 13 | 5.67 eV |
| Compound of Example 14 | 5.75 eV |
| Compound of Example 15 | 5.75 eV |
| Compound of Example 16 | 5.79 eV |
| Compound of Example 17 | 5.68 eV |
| Compound of Example 18 | 5.76 eV |
| Compound of Example 19 | 5.70 eV |
| Compound of Example 20 | 5.79 eV |
| Compound of Example 21 | 5.71 eV |
| Compound of Example 22 | 5.79 eV |
| Compound of Example 23 | 5.72 eV |
| Compound of Example 24 | 5.70 eV |
| Compound of Example 25 | 5.71 eV |
| Compound of Example 26 | 5.65 eV |
| Compound of Example 27 | 5.70 eV |
| Compound of Example 28 | 5.67 eV |
| Compound of Example 29 | 5.69 eV |
| Compound of Example 30 | 5.75 eV |
| Compound of Example 31 | 5.84 eV |
| Compound of Example 32 | 5.76 eV |
| Compound of Example 33 | 5.72 eV |
| Compound of Example 34 | 5.67 eV |
| Compound of Example 35 | 5.76 eV |
| Compound of Example 36 | 5.67 eV |
| Compound of Example 37 | 5.75 eV |
| Compound of Example 38 | 5.76 eV |

As the results show, the arylamine compounds of the general formula (1), according to the present invention, have desirable energy levels compared to the work function 5.4 eV of common hole transport materials such as NPD and TPD, and thus possess desirable hole transportability.

### Example 41

### <Synthesis of N5',N5',N9',N9'-tetrakis{4-(tert-butyl)phenyl}spiro(fluore ne-9,7'-fluoreno[4,3-b]benzofuran)-5',9'-diamine (Compound 8-1)>

5',9'-dibromospiro(fluorene-9,7'-fluoreno[4,3-b]benz ofuran) (5.0 g), bis{4-(tert-butyl)phenyl}amine (6.0 g), palladium acetate (0.08 g), sodium tert-butoxide (3.4 g), tri-tert-butylphosphine (0.07 g), and toluene (60 mL) were added into a nitrogen-substituted reaction vessel, and heated and refluxed for 2 hours while being stirred. After the mixture was cooled to a room temperature, dichloromethane and water were added, and an organic layer was collected by liquid separation. The organic layer was concentrated and then purified by column chromatography to obtain 3.1 g of powder of N5',N5',N9',N9'-tetrakis{4-(tert-butyl)phenyl}spiro(fluore ne-9,7'-fluoreno[4,3-b]benzofuran)-5',9'-diamine (Compound 8-1) (yield: 36%).

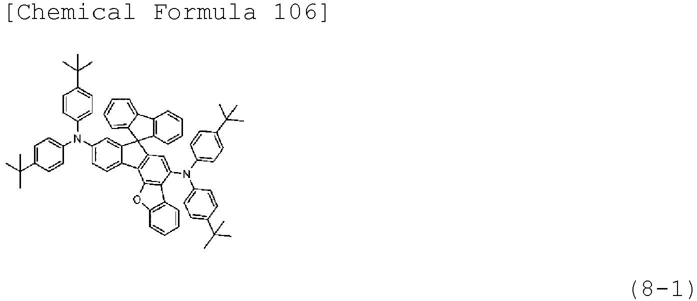

### Example 42

### <Synthesis of N2,N2,N7,N7-tetrakis{4-(tert-butyl)phenyl}spiro(dibenzo[5, 6:7,8]fluoreno[4,3-b]benzofuran-5,9'-fluorene)-2,7-diamine (Compound 8-2)>

The reaction was carried out under the same conditions as those of Example 41, except that 5',9'-dibromospiro(fluorene-9,7'-fluoreno[4,3-b]benzofuran ) was replaced with 2,7-dibromospiro(dibenzo[5,6:7,8]fluoreno[4,3-b]benzofuran -5,9'-fluorene). As a result, 2.5 g of powder of N2,N2,N7,N7-tetrakis{4-(tert-butyl)phenyl}spiro(dibenzo[5, 6:7,8]fluoreno[4,3-b]benzofuran-5,9'-fluorene)-2,7-diamine (Compound 8-2) (yield: 31%) was obtained.

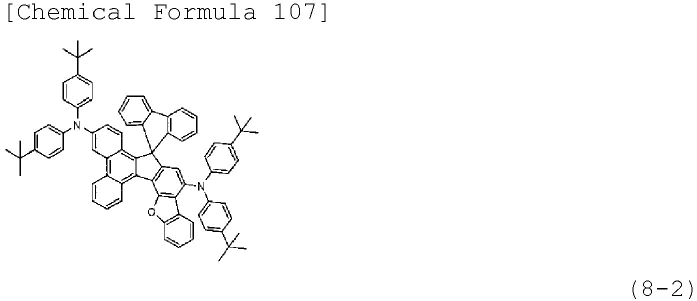

### Example 43

### <Synthesis of N5,N5,N9,N9-tetrakis{4-(tert-butyl)phenyl}spiro(benzo[5,6] fluoreno[4,3-b]benzofuran-7,9'-fluorene)-5,9-diamine (Compound 8-3)>

The reaction was carried out under the same conditions as those of Example 41, except that 5',9'-dibromospiro(fluorene-9,7'-fluoreno[4,3-b]benzofuran ) was replaced with 5,9-dibromospiro(benzo[5,6]fluoreno[4,3-b]benzofuran-7,9'-fluorene). As a result, 3.0 g of powder of N5,N5,N9,N9-tetrakis{4-(tert-butyl)phenyl}spiro(benzo[5,6] fluoreno[4,3-b]benzofuran-7,9'-fluorene)-5,9-diamine (Compound 8-3) (yield: 36%) was obtained.

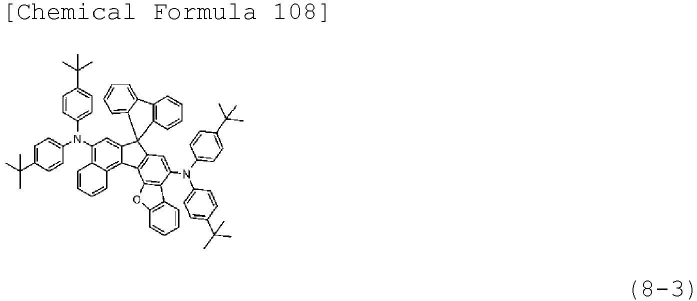

### Example 44

### <Synthesis of N6',N6',N10',N10'-tetrakis{4-(tert-butyl)phenyl}spiro(fluo rene-9,8'-fluoreno[4,3-b]benzofuran)-6',10'-diamine (Compound 8-4)>

The reaction was carried out under the same conditions as those of Example 41, except that 5',9'-dibromospiro(fluorene-9,7'-fluoreno[4,3-b]benzofuran ) was replaced with 6',10'-dibromospiro(fluorene-9,8'-fluoreno[4,3-b]benzofura n). As a result, 2.5 g of powder of N6',N6',N10',N10'-tetrakis{4-(tert-butyl)phenyl}spiro(fluo rene-9,8'-fluoreno[4,3-b]benzofuran)-6',10'-diamine (Compound 8-4) (yield: 34%) was obtained.

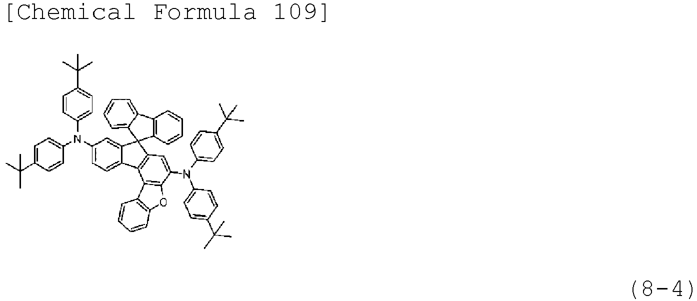

### Example 45

### <Synthesis of N5,N5,N9,N9-tetrakis{4-(tert-butyl)phenyl}spiro(fluoreno[4 ,3-b]benzofuran-7,9'-xanthene)-5,9-diamine (Compound 8-5)>

The reaction was carried out under the same conditions as those of Example 41, except that 5',9'-dibromospiro(fluorene-9,7'-fluoreno[4,3-b]benzofuran ) was replaced with 5,9-dibromospiro(fluoreno[4,3-b]benzofuran-7,9'-xanthene). As a result, 2.4 g of powder of N5,N5,N9,N9-tetrakis{4-(tert-butyl)phenyl}spiro(fluoreno[4 ,3-b]benzofuran-7,9'-xanthene)-5,9-diamine (Compound 8-5) (yield: 28%) was obtained.

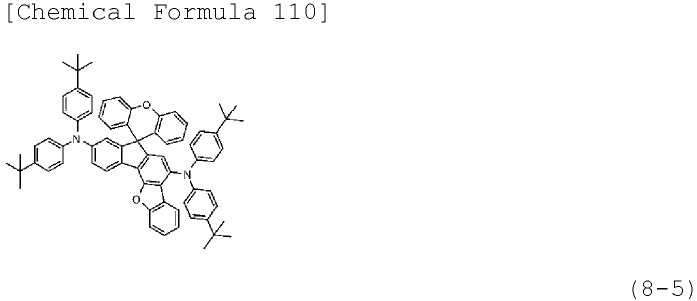

### Example 46

### <Synthesis of N5',N9'-bis(biphenyl-4-yl)-N5',N9'-bis{4-(tert-butyl)pheny 1}-2-fluorospiro(fluorene-9,7'-fluoreno[4,3-b]benzofuran)-5',9'-diamine (Compound 8-6)>

The reaction was carried out under the same conditions as those of Example 41, except that 5',9'-dibromospiro(fluorene-9,7'-fluoreno[4,3-b]benzofuran ) was replaced with 5',9'-dibromo-2-fluorospiro(fluorene-9,7'-fluoreno[4,3-b]b enzofuran), and bis{4-(tert-butyl)phenyl}amine was replaced with (biphenyl-4-yl)-{4-(tert-butyl)phenyl}amine. As a result 2.4 g of powder of N5',N9'-bis(biphenyl-4-yl)-N5',N9'-bis{4-(tert-butyl)pheny 1}-2-fluorospiro(fluorene-9,7'-fluoreno[4,3-b]benzofuran)-5',9'-diamine (Compound 8-6) (yield: 28%) was obtained.

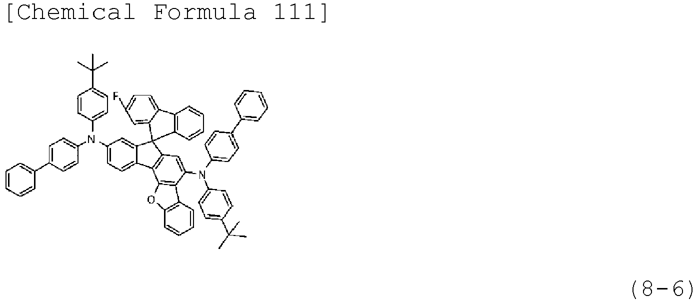

### Example 47

### <Synthesis of N5,N9-bis{4-(tert-butyl)phenyl}-N5,N9-bis{4-(trimethylsily l)phenyl}spiro(benzo[5,6]fluoreno[4,3-b]benzofuran-7,9'-fl uorene)-5,9-diamine (Compound 8-7)>

The reaction was carried out under the same conditions as those of Example 41, except that 5',9'-dibromospiro(fluorene-9,7'-fluoreno[4,3-b]benzofuran ) was replaced with 5,9-dibromospiro(benzo[5,6]fluoreno[4,3-b]benzofuran-7,9'-fluorene), and bis{4-(tert-butyl)phenyl}amine was replaced with {4-(tert-butyl)phenyl}-{4-(trimethylsilyl)phenyl}amine. As a result, 3.0 g of powder of N5,N9-bis{4-(tert-butyl)phenyl}-N5,N9-bis{4-(trimethylsily l)phenyl}spiro(benzo[5,6]fluoreno[4,3-b]benzofuran-7,9'-fl uorene)-5,9-diamine (Compound 8-7) (yield: 35%) was obtained.

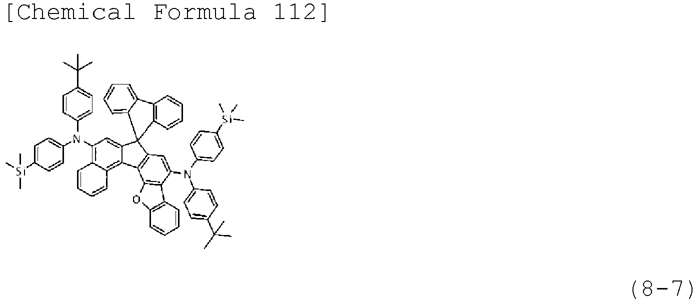

### Example 48

### <Synthesis of N5',N9'-bis{4-(tert-butyl)phenyl}-N5',N9'-bis{4-(trimethyl silyl)phenyl}spiro(fluorene-9,7'-fluoreno[4,3-b]benzothiop hene)-5',9'-diamine (Compound 8-8)>

The reaction was carried out under the same conditions as those of Example 41, except that 5',9'-dibromospiro(fluorene-9,7'-fluoreno[4,3-b]benzofuran ) was replaced with 5',9'-dibromospiro(fluorene-9,7'-fluoreno[4,3-b]benzothiop hene), and bis{4-(tert-butyl)phenyl}amine was replaced with {4-(tert-butyl)phenyl}-{4-(trimethylsilyl)phenyl}amine. As a result, 3.2 g of powder of N5',N9'-bis{4-(tert-butyl)phenyl}-N5',N9'-bis{4-(trimethyl silyl)phenyl}spiro(fluorene-9,7'-fluoreno[4,3-b]benzothiop hene)-5',9'-diamine (Compound 8-8) (yield: 37%) was obtained.

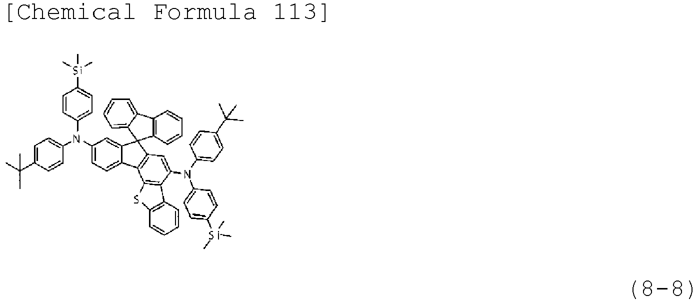

### Example 49

### <Synthesis of N5,N9-bis(biphenyl-4-yl)-N5,N9-bis{4-(tert-butyl)phenyl}sp iro(benzo[4',5']thieno[2',3':5,6]fluoreno[4,3-b]benzofuran -7,9'-fluorene)-5,9-diamine (Compound 8-9)>

The reaction was carried out under the same conditions as those of Example 41, except that 5',9'-dibromospiro(fluorene-9,7'-fluoreno[4,3-b]benzofuran ) was replaced with 5,9-dibromospiro(benzo[4',5']thieno[2',3':5,6]fluoreno[4,3 -b]benzofuran-7,9'-fluorene), and bis{4-(tert-butyl)phenyl}amine was replaced with {4-(tert-butyl)phenyl}-{biphenyl-4-yl}amine. As a result, 2.8 g of powder of N5,N9-bis(biphenyl-4-yl)-N5,N9-bis{4-(tert-butyl)phenyl}sp iro(benzo[4',5']thieno[2',3':5,6]fluoreno[4,3-b]benzofuran -7,9'-fluorene)-5,9-diamine (Compound 8-9) (yield: 34%) was obtained.

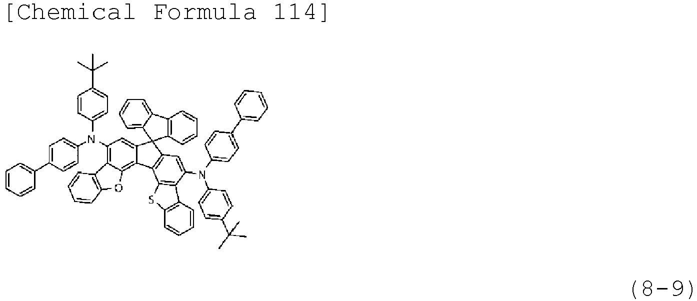

### Example 50

### <Synthesis of N5',N5',N9',N9'-tetrakis{4-(tert-butyl)phenyl}-12',12'-dim ethyl-12'H-spiro(fluorene-9,7'-indeno[1,2-a]fluorene)-5',9 '-diamine (Compound 8-10)>

The reaction was carried out under the same conditions as those of Example 41, except that 5',9'-dibromospiro(fluorene-9,7'-fluoreno[4,3-b]benzofuran ) was replaced with 5',9'-dibromo-12',12'-dimethyl-12'H-spiro(fluorene-9,7'-in deno[1,2-a]fluorene). As a result, 1.8 g of powder of N5',N5',N9',N9'-tetrakis{4-(tert-butyl)phenyl}-12',12'-dim ethyl-12'H-spiro(fluorene-9,7'-indeno[1,2-a]fluorene)-5',9 '-diamine (Compound 8-10) (yield: 49%) was obtained.

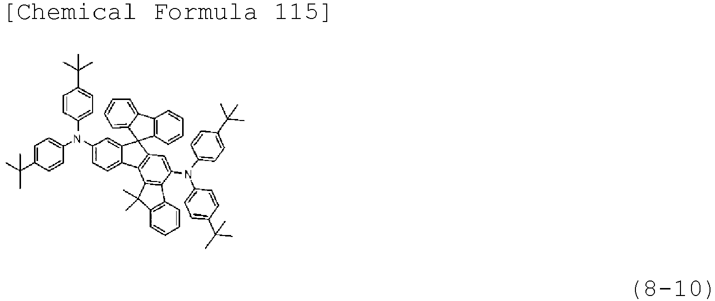

### Example 51

### <Synthesis of N6',N10'-bis(biphenyl-4-yl)-N6',N10'-bis{4-(tert-butyl)phe nyl}-5'-methyl-5'H-spiro(fluorene-9,8'-indeno[2,1-c]carbaz ole)-6',10'-diamine (Compound 8-11)>

The reaction was carried out under the same conditions as those of Example 41, except that 5',9'-dibromospiro(fluorene-9,7'-fluoreno[4,3-b]benzofuran ) was replaced with 6',10'-dibromo-5'-methyl-5'H-spiro(fluorene-9,8'-indeno[2, 1-c]carbazole), and bis{4-(tert-butyl)phenyl}amine was replaced with {4-(tert-butyl)phenyl}-{biphenyl-4-yl}amine. As a result, 2.3 g of powder of N6',N10'-bis(biphenyl-4-yl)-N6',N10'-bis{4-(tert-butyl)phe nyl}-5'-methyl-5'H-spiro(fluorene-9,8'-indeno[2,1-c]carbaz ole)-6',10'-diamine (Compound 8-11) (yield: 41%) was obtained.

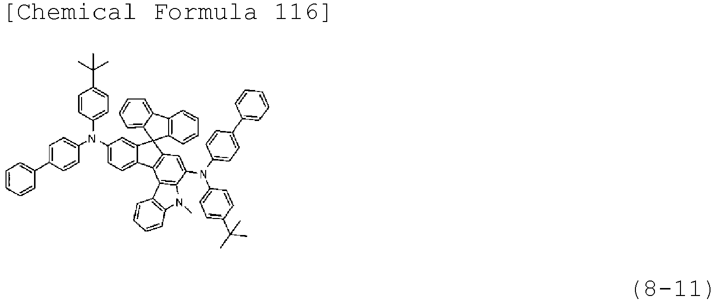

### Example 52

The organic EL device, as shown in FIG. 1, was fabricated by vapor-depositing a hole injection layer 3, a hole transport layer 4, a light emitting layer 5, an electron transport layer 6, an electron injection layer 7, and a cathode (aluminum electrode) 8 in this order on a glass substrate 1 on which an ITO electrode was formed as a transparent anode 2 beforehand.

Specifically, the glass substrate 1 having ITO having a film thickness of 150 nm formed thereon was subjected to ultrasonic washing in isopropyl alcohol for 20 minutes and then dried for 10 minutes on a hot plate heated to 200°C. Thereafter, after performing an UV ozone treatment for 15 minutes, the glass substrate with ITO was installed in a vacuum vapor deposition apparatus, and the pressure was reduced to 0.001 Pa or lower. Subsequently, as the hole injection layer 3 covering the transparent anode 2, an electron acceptor (Acceptor-1) of the structural formula below and Compound (1-1) of Example 1 were formed in a film thickness of 30 nm by dual vapor deposition at a vapor deposition rate ratio of Acceptor-1/Compound (1-1) = 3/97. As the hole transport layer 4 on the hole injection layer 3, Compound 1-1 of Example 1 was formed in a film thickness of 40 nm. As the light emitting layer 5 on the hole transport layer 4, Compound EMD-1 of the structural formula below and Compound EMH-1 of the structural formula below were formed in a film thickness of 20 nm by dual vapor deposition at a vapor deposition rate ratio of EMD-1/EMH-1 = 5/95. As the electron transport layer 6 on the light emitting layer 5, Compound (5b-1) having an anthracene ring structure of the structural formula below and Compound ETM-1 of the structural formula below were formed in a film thickness of 30 nm by dual vapor deposition at a vapor deposition rate ratio of Compound (5b-1)/ETM-1 = 50/50. As the electron injection layer 7 on the electron transport layer 6, lithium fluoride was formed in a film thickness of 1 nm. Finally, aluminum was vapor-deposited in a thickness of 100 nm to form the cathode 8. The characteristics of the thus fabricated organic EL device were measured in the atmosphere at an ordinary temperature. Table 1 summarizes the results of the measurement of emission characteristics performed by applying a direct current voltage to the fabricated organic EL device.

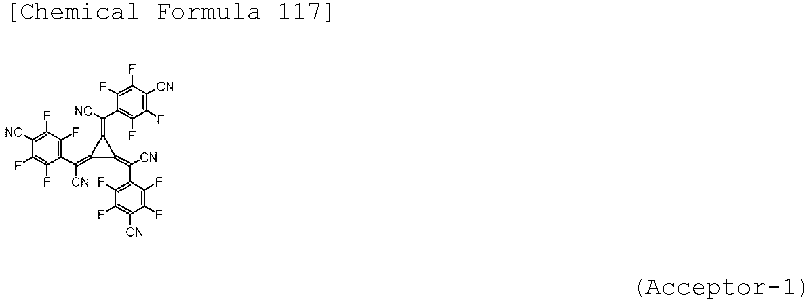

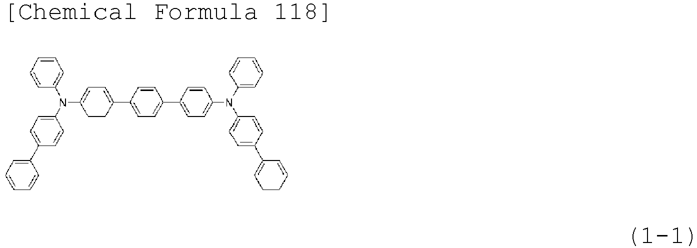

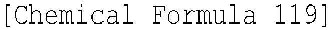

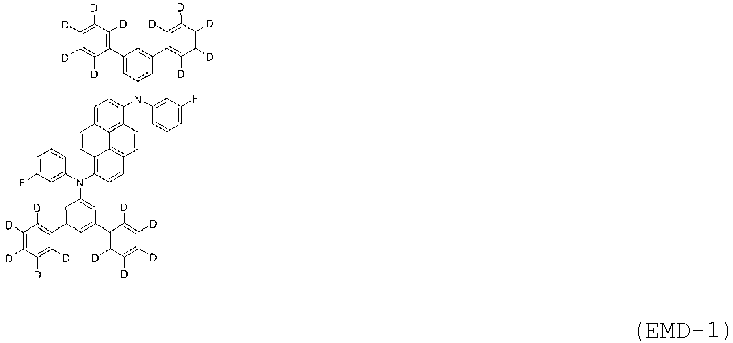

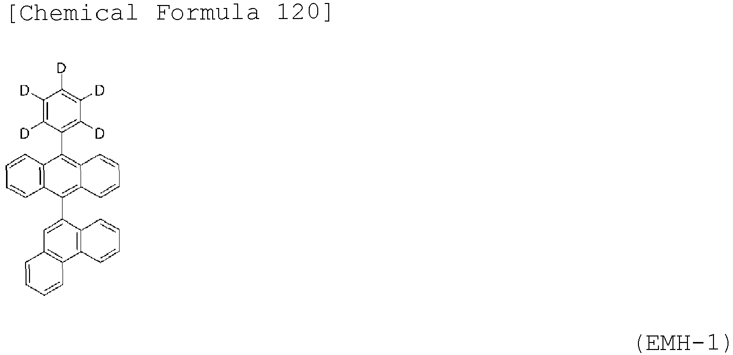

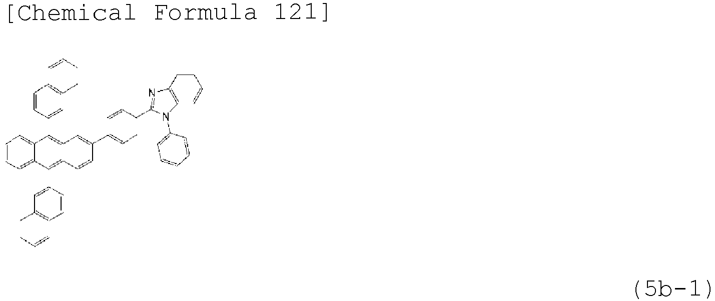

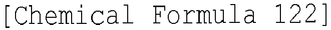

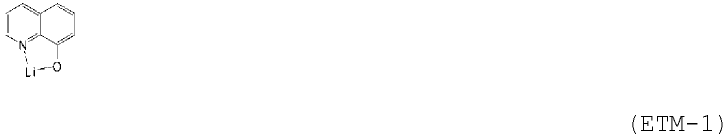

### Example 53

An organic EL device was fabricated under the same conditions used in Example 52, except that Compound (6-125) having a pyrimidine ring structure was used as the material of the electron transport layer 6 instead of Compound (5b-1) having an anthracene ring structure, and Compound (6-125) and Compound ETM-1 of the above structural formula were formed in a film thickness of 30 nm by dual vapor deposition at a vapor deposition rate ratio of Compound (6-125) /ETM-1 = 50/50. The characteristics of the thus fabricated organic EL device were measured in the atmosphere at an ordinary temperature. Table 1 summarizes the results of the measurement of emission characteristics performed by applying a direct current voltage to the fabricated organic EL device.

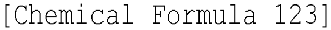

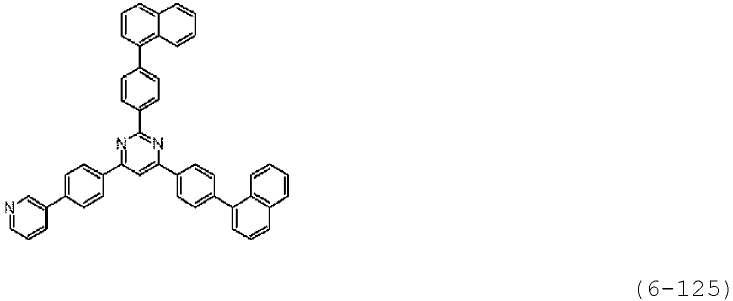

### Example 54

An organic EL device was fabricated under the same conditions used in Example 52, except that the amine derivative (8-1) having a condensed ring structure was used as the material of the light emitting layer 5 instead of Compound EMD-1 of the above structural formula, and the amine derivative (8-1) having a condensed ring structure and Compound EMH-1 of the above structural formula were formed in a film thickness of 25 nm by dual vapor deposition at a vapor deposition rate ratio of amine derivative (8-1)/EMH-1 = 5/95. The characteristics of the thus fabricated organic EL device were measured in the atmosphere at an ordinary temperature. Table 1 summarizes the results of the measurement of emission characteristics performed by applying a direct current voltage to the fabricated organic EL device.

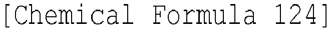

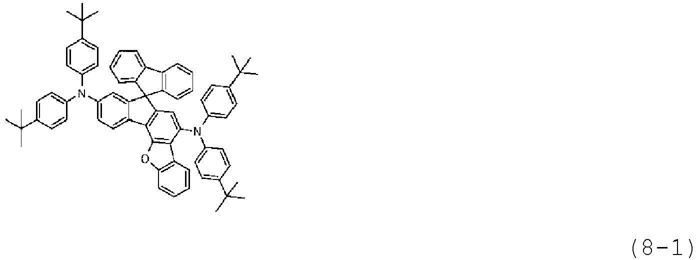

### Example 55

An organic EL device was fabricated under the same conditions used in Example 53, except that the amine derivative (8-1) having a condensed ring structure was used as the material of the light emitting layer 5 instead of Compound EMD-1 of the above structural formula, and the amine derivative (8-1) having a condensed ring structure and Compound EMH-1 of the above structural formula were formed in a film thickness of 25 nm by dual vapor deposition at a vapor deposition rate ratio of amine derivative (8-1)/EMH-1 = 5/95. The characteristics of the thus fabricated organic EL device were measured in the atmosphere at an ordinary temperature. Table 1 summarizes the results of the measurement of emission characteristics performed by applying a direct current voltage to the fabricated organic EL device.

### Example 56

An organic EL device was fabricated under the same conditions used in Example 52, except that Compound (1-2) of Example 4 was used as the material of the hole injection layer 3 instead of Compound (1-1) of Example 1, and the electron acceptor (Acceptor-1) of the above structural formula and Compound (1-2) of Example 4 were formed in a film thickness of 30 nm by dual vapor deposition at a vapor deposition rate ratio of Acceptor-1/Compound (1-2) = 3/97, and Compound (1-2) of Example 4 was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

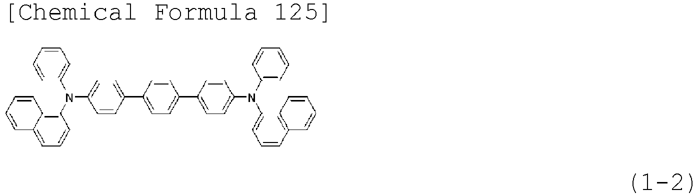

### Example 57

An organic EL device was fabricated under the same conditions used in Example 53, except that Compound (1-2) of Example 4 was used as the material of the hole injection layer 3 instead of Compound (1-1) of Example 1, and the electron acceptor (Acceptor-1) of the above structural formula and Compound (1-2) of Example 4 were formed in a film thickness of 30 nm by dual vapor deposition at a vapor deposition rate ratio of Acceptor-1/Compound (1-2) = 3/97, and Compound (1-2) of Example 4 was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

### Example 58

An organic EL device was fabricated under the same conditions used in Example 54, except that Compound (1-2) of Example 4 was used as the material of the hole injection layer 3 instead of Compound (1-1) of Example 1, and the electron acceptor (Acceptor-1) of the above structural formula and Compound (1-2) of Example 4 were formed in a film thickness of 30 nm by dual vapor deposition at a vapor deposition rate ratio of Acceptor-1/Compound (1-2) = 3/97, and Compound (1-2) of Example 4 was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

### Example 59

An organic EL device was fabricated under the same conditions used in Example 55, except that Compound (1-2) of Example 4 was used as the material of the hole injection layer 3 instead of Compound (1-1) of Example 1, and the electron acceptor (Acceptor-1) of the above structural formula and Compound (1-2) of Example 4 were formed in a film thickness of 30 nm by dual vapor deposition at a vapor deposition rate ratio of Acceptor-1/Compound (1-2) = 3/97, and Compound (1-2) of Example 4 was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 1

For comparison, an organic EL device was fabricated under the same conditions used in Example 52, except that HTM-1 of the structural formula below was used as the material of the hole injection layer 3 instead of Compound (1-1) of Example 1, and the electron acceptor (Acceptor-1) of the above structural formula and HTM-1 of the structural formula below were formed in a film thickness of 30 nm by dual vapor deposition at a vapor deposition rate ratio of Acceptor-1/HTM-1 = 3/97, and HTM-1 of the structural formula below was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

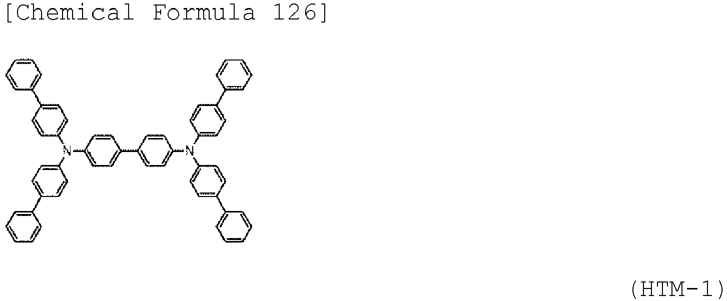

### Comparative Example 2

For comparison, an organic EL device was fabricated under the same conditions used in Example 53, except that HTM-1 of the above structural formula was used as the material of the hole injection layer 3 instead of Compound (1-1) of Example 1, and the electron acceptor (Acceptor-1) of the above structural formula and HTM-1 of the above structural formula were formed in a film thickness of 30 nm by dual vapor deposition at a vapor deposition rate ratio of Acceptor-1/HTM-1 = 3/97, and HTM-1 of the above structural formula was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 3

For comparison, an organic EL device was fabricated under the same conditions used in Example 54, except that HTM-1 of the above structural formula was used as the material of the hole injection layer 3 instead of Compound (1-1) of Example 1, and the electron acceptor (Acceptor-1) of the above structural formula and HTM-1 of the above structural formula were formed in a film thickness of 30 nm by dual vapor deposition at a vapor deposition rate ratio of Acceptor-1/HTM-1 = 3/97, and HTM-1 of the above structural formula was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 4

For comparison, an organic EL device was fabricated under the same conditions used in Example 55, except that HTM-1 of the above structural formula was used as the material of the hole injection layer 3 instead of Compound (1-1) of Example 1, and the electron acceptor (Acceptor-1) of the above structural formula and HTM-1 of the above structural formula were formed in a film thickness of 30 nm by dual vapor deposition at a vapor deposition rate ratio of Acceptor-1/HTM-1 = 3/97, and HTM-1 of the above structural formula was used as the material of the hole transport layer 4 instead of Compound (1-1) of Example 1, and formed in a film thickness of 40 nm. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 5

For comparison, an organic EL device was fabricated under the same conditions used in Example 53, except that the electron acceptor (Acceptor-1) of the above structural formula and Compound (1-1) of Example 1 were used as the material of the hole transport layer 4 instead of Compound (1-1) of Example 1, and the electron acceptor (Acceptor-1) of the above structural formula and Compound (1-1) of Example 1 were formed in a film thickness of 40 nm by dual vapor deposition at a vapor deposition rate ratio of Acceptor-1/Compound (1-1) = 3/97. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 6

For comparison, an organic EL device was fabricated under the same conditions used in Example 55, except that the electron acceptor (Acceptor-1) of the above structural formula and Compound (1-1) of Example 1 were used as the material of the hole transport layer 4 instead of Compound (1-1) of Example 1, and the electron acceptor (Acceptor-1) of the above structural formula and Compound (1-1) of Example 1 were formed in a film thickness of 40 nm by dual vapor deposition at a vapor deposition rate ratio of Acceptor-1/Compound (1-1) = 3/97. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 7

For comparison, an organic EL device was fabricated under the same conditions used in Example 57, except that the electron acceptor (Acceptor-1) of the above structural formula and Compound (1-2) of Example 4 were used as the material of the hole transport layer 4 instead of Compound (1-2) of Example 4, and the electron acceptor (Acceptor-1) of the above structural formula and Compound (1-2) of Example 4 were formed in a film thickness of 40 nm by dual vapor deposition at a vapor deposition rate ratio of Acceptor-1/Compound (1-2) = 3/97. The characteristics of the thus fabricated organic EL device were measured in the atmosphere at an ordinary temperature. Table 1 summarizes the results of the measurement of emission characteristics performed by applying a direct current voltage to the fabricated organic EL device.

### Comparative Example 8

For comparison, an organic EL device was fabricated under the same conditions used in Example 59, except that the electron acceptor (Acceptor-1) of the above structural formula and Compound (1-2) of Example 4 were used as the material of the hole transport layer 4 instead of Compound (1-2) of Example 4, and the electron acceptor (Acceptor-1) of the above structural formula and Compound (1-2) of Example 4 were formed in a film thickness of 40 nm by dual vapor deposition at a vapor deposition rate ratio of Acceptor-1/Compound (1-2) = 3/97. The characteristics of the thus fabricated organic EL device were measured in the atmosphere at an ordinary temperature. Table 1 summarizes the results of the measurement of emission characteristics performed by applying a direct current voltage to the fabricated organic EL device.

Table 1 summarizes the results of the measurement of device lifetime performed with organic EL devices fabricated in Examples 52 to 59 and Comparative Examples 1 to 8. The device lifetime was measured as the time elapsed until the emission luminance of 2,000 cd/m² (initial luminance) at the start of emission was attenuated to 1,900 cd/m² (corresponding to attenuation to 95% with respect to the initial luminance as 100%, 95% attenuation) when carrying out constant current driving.

**[Table 1]**

| | Hole injection layer | Hole transport layer | Light emitting layer | Electron transport layer | Voltage [V] (@10mA/ cm²) | Luminance [cd/m²] (@10mA/cm²) | Current efficiency [cd/A] (@10mA/cm²) | Power efficiency [lm/W] (@10mA/cm²) | Device lifetime (Attenuati on to 95%) |
|---|---|---|---|---|---|---|---|---|---|
| Ex. 52 | Compound 1-1/ Acceptor-1 | Compound 1-1 | EMD-1/ EMH-1 | Compound 5b-1/ ETM-1 | 3.90 | 657 | 6.57 | 5.30 | 116 h |
| Ex. 53 | Compound 1-1/ Acceptor-1 | Compound 1-1 | EMD-1/ EMH-1 | Compound 6-125/ ETM-1 | 3.87 | 719 | 7.20 | 5.85 | 137 h |
| Ex. 54 | Compound 1-1/ Acceptor-1 | Compound 1-1 | Compound 8-1/ EMH-1 | Compound 5b-1/ ETM-1 | 3.82 | 643 | 6.44 | 5.29 | 117 h |
| Ex. 55 | Compound 1-1/ Acceptor-1 | Compound 1-1 | Compound 8-1/ EMH-1 | Compound 6-125/ ETM-1 | 3.85 | 691 | 6.92 | 5.65 | 135 h |
| Ex. 56 | Compound 1-2/ Acceptor-1 | Compound 1-2 | EMD-1/ EMH-1 | Compound 5b-1/ ETM-1 | 3.93 | 626 | 6.27 | 5.01 | 120 h |
| Ex. 57 | Compound 1-2/ Acceptor-1 | Compound 1-2 | EMD-1/ EMH-1 | Compound 6-125/ ETM-1 | 3.89 | 676 | 6.77 | 5.48 | 142 h |
| Ex. 58 | Compound 1-2/ Acceptor-1 | Compound 1-2 | Compound 8-1/ EMH-1 | Compound 5b-1/ ETM-1 | 3.81 | 606 | 6.06 | 4.99 | 143 h |
| Ex. 59 | Compound 1-2/ Acceptor-1 | Compound 1-2 | Compound 8-1/ EMH-1 | Compound 6-125/ ETM-1 | 3.82 | 662 | 6.63 | 5.45 | 128 h |
| Com. Ex. 1 | HTM-1/ Acceptor-1 | HTM-1 | EMD-1/ EMH-1 | Compound 5b-1/ ETM-1 | 3.86 | 502 | 5.03 | 4.10 | 55 h |
| Com. Ex. 2 | HTM-1/ Acceptor-1 | HTM-1 | EMD-1/ EMH-1 | Compound 6-125/ ETM-1 | 3.84 | 543 | 5.44 | 4.45 | 69 h |
| Com. Ex. 3 | HTM-1/ Acceptor-1 | HTM-1 | Compound 8-1/ EMH-1 | Compound 5b-1/ ETM-1 | 3.75 | 483 | 4.84 | 4.07 | 6 h |
| Com. Ex. 4 | HTM-1/ Acceptor-1 | HTM-1 | Compound 8-1/ EMH-1 | Compound 6-125/ ETM-1 | 3.77 | 520 | 5.21 | 4.35 | 58 h |
| Com. Ex. 5 | Compound 1-1/ Acceptor-1 | Compound 1-1/ Acceptor-1 | EMD-1/ EMH-1 | Compound 6-125/ ETM-1 | 3.84 | 55 | 0.55 | 0.45 | 1 h |
| Com. Ex. 6 | Compound 1-1/ Acceptor-1 | Compound 1-1/ Acceptor-1 | Compound 8-1/ EMH-1 | Compound 6-125/ ETM-1 | 3.86 | 62 | 0.62 | 0.50 | 1 h |
| Com. Ex. 7 | Compound 1-2/ Acceptor-1 | Compound 1-2/ Acceptor-1 | EMD-1/ EMH-1 | Compound 6-125/ ETM-1 | 3.91 | 78 | 0.78 | 0.63 | 1 h |
| Com. Ex. 8 | Compound 1-2/ Acceptor-1 | Compound 1-2/ Acceptor-1 | Compound 8-1/ EMH-1 | Compound 6-125/ ETM-1 | 3.91 | 81 | 0.80 | 0.64 | 1 h |

As shown in Table 1, the luminous efficiency upon passing a current with a current density of 10 mA/cm² was 0.55 to 0.80 cd/A for the organic EL devices in Comparative Examples 5 to 8 having the hole transport layer that was also doped with an electron acceptor, whereas was a high efficiency of 4.84 to 5.44 cd/A for the organic EL devices in Comparative Examples 1 to 4 having the hole transport layer that was not doped with an electron acceptor. The luminous efficiency was a further higher efficiency of 6.06 to 7.20 cd/A for the organic EL devices in Examples 52 to 59 using the arylamine derivative of the general formula (1), according to the present invention, in the hole injection layer. The power efficiency was 0.45 to 0.64 lm/W for the organic EL devices in Comparative Examples 5 to 8 having the hole transport layer that was also doped with an electron acceptor, whereas was a high efficiency of 4.07 to 4.45 lm/W for the organic EL devices in Comparative Examples 1 to 4 having the hole transport layer that was not doped with an electron acceptor. The power efficiency was a further higher efficiency of 4.99 to 5.85 lm/W for the organic EL devices in Examples 52 to 59 using the arylamine compound of the general formula (1), according to the present invention, in the hole injection layer. The device lifetime (95% attenuation) was 1 hour for the organic EL devices in Comparative Examples 5 to 8 having the hole transport layer that was also doped with an electron acceptor, whereas was a long lifetime of 6 to 69 hours for the organic EL devices in Comparative Examples 1 to 4 having the hole transport layer that was not doped with an electron acceptor. The device lifetime was 116 to 143 hours, which showed large increase of lifetime, for the organic EL devices in Examples 52 to 59 using the arylamine compound of the general formula (1), according to the present invention, in the hole injection layer.

It has been found that in the organic EL devices of the present invention, holes can be efficiently injected and transported from the electrode to the hole transport layer by selecting the particular arylamine compound (having the particular structure) as the material of the hole injection layer, and subjecting to p-type doping with an electron acceptor, and the carrier balance in the organic EL device can be improved to achieve an organic EL device having a higher luminous efficiency and a longer lifetime than the conventional organic EL devices by selecting the particular arylamine compound (having the particular structure) without p-type doping as the material of the hole transport layer.

### Industrial Applicability

The organic EL devices of the present invention with the combination of the particular arylamine compound (having the particular structure) and the electron acceptor that achieves excellent carrier balance in the organic EL device has an improved luminous efficiency and an improved durability of the organic EL device, and can be applied, for example, to home electric appliances and illuminations.

### Description of Reference Numeral

- 1: Glass substrate
- 2: Transparent anode
- 3: Hole injection layer
- 4: Hole transport layer
- 5: Light emitting layer
- 6: Electron transport layer
- 7: Electron injection layer
- 8: Cathode

## Claims

1. An organic electroluminescent device comprising at least an anode, a hole injection layer, a hole transport layer, a light emitting layer, an electron transport layer, and a cathode, in this order, wherein the hole injection layer includes an arylamine compound represented by the following general formula (1) and an electron acceptor: 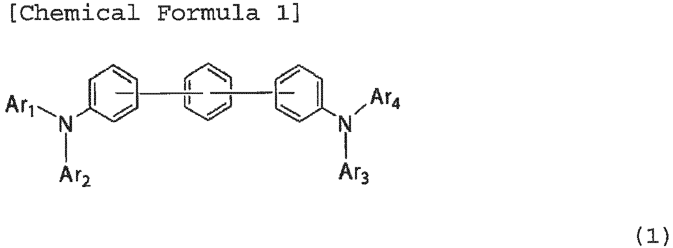 wherein Ar₁ to Ar₄ may be the same or different, and represent a substituted or unsubstituted aromatic hydrocarbon group, a substituted or unsubstituted aromatic heterocyclic group, or a substituted or unsubstituted condensed polycyclic aromatic group,
wherein the substituent in the substituted aromatic hydrocarbon group, the substituted aromatic heterocyclic group, or the substituted condensed polycyclic aromatic group represented by Ar₁ to Ar₄ in the general formula (1) include a deuterium atom; cyano; nitro; halogen atoms; linear or branched alkyls of 1 to 6 carbon atoms; linear or branched alkyloxys of 1 to 6 carbon atoms; alkenyls; aryloxys; arylalkyloxys; aromatic hydrocarbon groups or condensed polycyclic aromatic groups; aromatic heterocyclic groups; arylvinyls; acyls; and silyls,
wherein the hole transport layer consists of an arylamine compound of the general formula (1), and
wherein the electron transport layer includes a compound represented by the following general formula (5b) having an anthracene ring structure or a compound represented by the following general formula (6) having a pyrimidine ring structure: 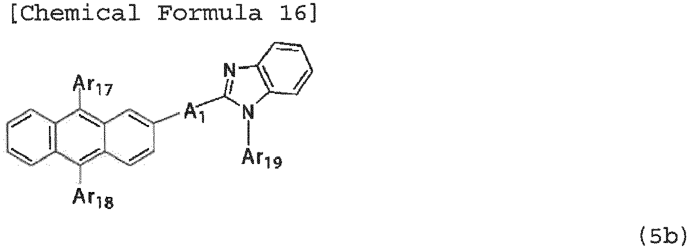
wherein A₁ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond; Ar₁₇, Ar₁₈, and Ar₁₉ may be the same or different, and represent a substituted or unsubstituted aromatic hydrocarbon group, a substituted or unsubstituted aromatic heterocyclic group, or a substituted or unsubstituted condensed polycyclic aromatic group; and 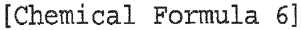 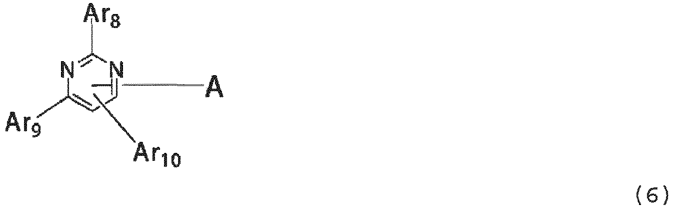 wherein Are represents a substituted or unsubstituted aromatic hydrocarbon group, a substituted or unsubstituted aromatic heterocyclic group, or a substituted or unsubstituted condensed polycyclic aromatic group; Arg and Ar₁₀ may be the same or different, and represent a hydrogen atom, a substituted or unsubstituted aromatic hydrocarbon group, a substituted or unsubstituted aromatic heterocyclic group, or a substituted or unsubstituted condensed polycyclic aromatic group; and A represents a monovalent group represented by the following structural formula (7), where Ar₉ and Ar₁₀ are not simultaneously a hydrogen atom: 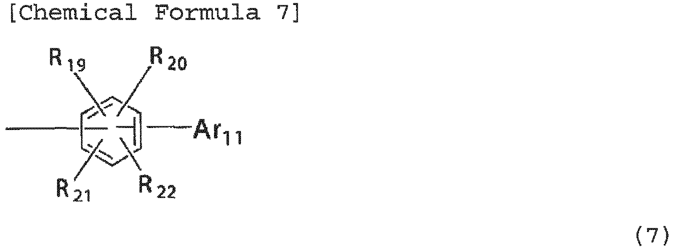
wherein Ar₁₁ represents a substituted or unsubstituted aromatic heterocyclic group; and R₁₉ to R₂₂ may be the same or different, and represent a hydrogen atom, a deuterium atom, a fluorine atom, a chlorine atom, cyano, trifluoromethyl, linear or branched alkyl of 1 to 6 carbon atoms, a substituted or unsubstituted aromatic hydrocarbon group, a substituted or unsubstituted aromatic heterocyclic group, or a substituted or unsubstituted condensed polycyclic aromatic group, where R₁₉ to R₂₂ may bind to Ar₁₁ via a single bond, substituted or unsubstituted methylene, an oxygen atom, or a sulfur atom to form a ring.

2. The organic electroluminescent device according to claim 1, wherein the layers that are adjacent to the light emitting layer do not include an electron acceptor.

3. The organic electroluminescent device according to claim 1 or 2, wherein the electron acceptor is an electron acceptor selected from trisbromophenylamine hexachloroantimony, tetracyanoquinodimethane (TCNQ), 2,3,5,6-tetrafluoro-tetracyano-1,4-benzoquinodimethane (F4TCNQ), and a radialene derivative.

4. The organic electroluminescent device according to any one of claims 1 to 3, wherein the electron acceptor is a radialene derivative represented by the following general formula (2): 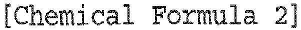 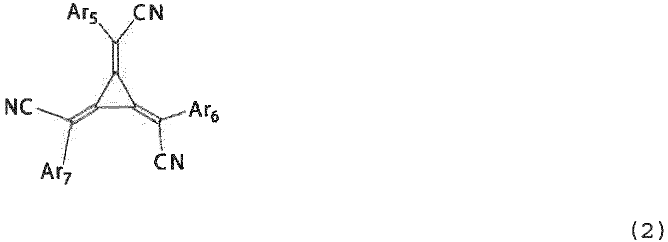 wherein Ar₅ to Ar₇ may be the same or different, and represent an aromatic hydrocarbon group, an aromatic heterocyclic group, or a condensed polycyclic aromatic group, having an electron acceptor group as a substituent.

5. The organic EL device according to any one of claims 1 to 4, wherein the light emitting layer includes a blue light emitting dopant.

6. The organic EL device according to claim 5, wherein the light emitting layer includes a pyrene derivative as the blue light emitting dopant.

7. The organic EL device according to claim 5, wherein the blue light emitting dopant includes a light emitting dopant which is an amine derivative having a condensed ring structure represented by the following general formula (8): [Chemical Formula 8] 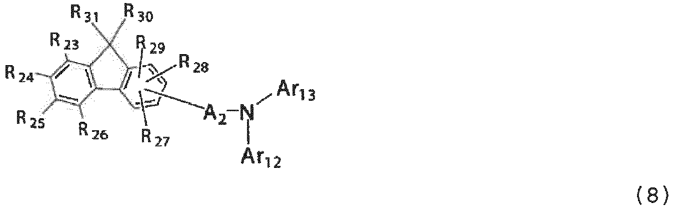 wherein A₂ represents a divalent group of a substituted or unsubstituted aromatic hydrocarbon, a divalent group of a substituted or unsubstituted aromatic heterocyclic ring, a divalent group of substituted or unsubstituted condensed polycyclic aromatics, or a single bond; Ar₁₂ and Ar₁₃ may be the same or different, represent a substituted or unsubstituted aromatic hydrocarbon group, a substituted or unsubstituted aromatic heterocyclic group, or a substituted or unsubstituted condensed polycyclic aromatic group, and may bind to each other via a single bond, substituted or unsubstituted methylene, an oxygen atom, or a sulfur atom to form a ring; R₂₃ to R₂₆ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, substituted or unsubstituted aryloxy, or a disubstituted amino group substituted by groups selected from an aromatic hydrocarbon group, an aromatic heterocyclic group, and a condensed polycyclic aromatic group, where these groups may bind to each other via a single bond, substituted or unsubstituted methylene, an oxygen atom, or a sulfur atom to form a ring, and may bind to the benzene ring binding to R₂₃ to R₂₆ via substituted or unsubstituted methylene, an oxygen atom, a sulfur atom, or a monosubstituted amino group to form a ring; R₂₇ to R₂₉ may be the same or different, and represent a hydrogen atom, a deuterium atom, a fluorine atom, a chlorine atom, cyano, nitro, linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, linear or branched alkyloxy of 1 to 6 carbon atoms that may have a substituent, cycloalkyloxy of 5 to 10 carbon atoms that may have a substituent, a substituted or unsubstituted aromatic hydrocarbon group, a substituted or unsubstituted aromatic heterocyclic group, a substituted or unsubstituted condensed polycyclic aromatic group, or substituted or unsubstituted aryloxy, where these groups may bind to each other via a single bond, substituted or unsubstituted methylene, an oxygen atom, or a sulfur atom to form a ring, and may bind to the benzene ring binding to R₂₇ to R₂₉ via substituted or unsubstituted methylene, an oxygen atom, a sulfur atom, or a monosubstituted amino group to form a ring; and R₃₀ and R₃₁ may be the same or different, and represent linear or branched alkyl of 1 to 6 carbon atoms that may have a substituent, cycloalkyl of 5 to 10 carbon atoms that may have a substituent, linear or branched alkenyl of 2 to 6 carbon atoms that may have a substituent, a substituted or unsubstituted aromatic hydrocarbon group, a substituted or unsubstituted aromatic heterocyclic group, a substituted or unsubstituted condensed polycyclic aromatic group, or a substituted or unsubstituted aryloxy, where these groups may bind to each other via a single bond, substituted or unsubstituted methylene, an oxygen atom, a sulfur atom, or a monosubstituted amino group to form a ring.

8. The organic EL device according to any one of claims 1 to 7, wherein the light emitting layer includes an anthracene derivative.

9. The organic EL device according to claim 8, wherein the light emitting layer includes a host material which is the anthracene derivative.

## Patentansprüche

1. Organische Elektrolumineszenzvorrichtung, umfassend mindestens eine Anode, eine Lochinjektionsschicht, eine Lochtransportschicht, eine lichtemittierende Schicht, eine Elektronentransportschicht und eine Kathode in dieser Reihenfolge, wobei die Lochinjektionsschicht eine durch die folgende allgemeine Formel (1) dargestellte Arylamin-Verbindung und einen Elektronenakzeptor einschließt: 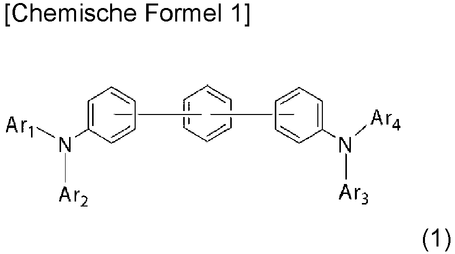
wobei Ar₁ bis Ar₄ gleich oder verschieden sein können und eine substituierte oder unsubstituierte aromatische Kohlenwasserstoffgruppe, eine substituierte oder unsubstituierte aromatische heterocyclische Gruppe oder eine substituierte oder unsubstituierte kondensierte polycyclische aromatische Gruppe darstellen, wobei der Substituent in der substituierten aromatischen Kohlenwasserstoffgruppe, der substituierten aromatischen heterocyclischen Gruppe oder der substituierten kondensierten polycyclischen aromatischen Gruppe, dargestellt durch Ar₁ bis Ar₄ in der allgemeinen Formel (1), ein Deuteriumatom; Cyan; Nitro; Halogenatome; lineare oder verzweigte Alkyle mit 1 bis 6 Kohlenstoffatomen; lineare oder verzweigte Alkyloxy mit 1 bis 6 Kohlenstoffatomen; Alkenyle; Aryloxy; Arylalkyloxy; aromatische Kohlenwasserstoffgruppen oder kondensierte polycyclische aromatische Gruppen; aromatische heterocyclische Gruppen; Arylvinyle; Acyle; und Silyle einschließt,
wobei die Lochtransportschicht aus einer Arylamin-Verbindung der allgemeinen Formel (1) besteht, und
wobei die Elektronentransportschicht eine Verbindung der folgenden allgemeinen Formel (5b) mit einer Anthracen-Ringstruktur oder eine Verbindung der folgenden allgemeinen Formel (6) mit einer Pyrimidin-Ringstruktur einschließt: 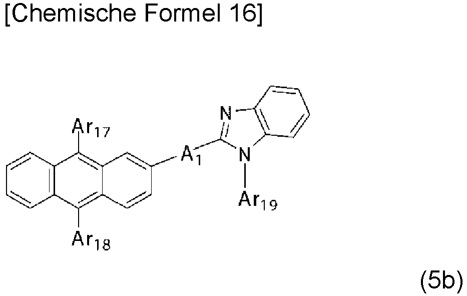
wobei A₁ eine zweiwertige Gruppe eines substituierten oder unsubstituierten aromatischen Kohlenwasserstoffs, eine zweiwertige Gruppe eines substituierten oder unsubstituierten aromatischen heterocyclischen Rings, eine zweiwertige Gruppe von substituierten oder unsubstituierten kondensierten polycyclischen Aromaten oder eine Einfachbindung darstellt; Ar₁₇, Ar₁₈ und Ar₁₉ gleich oder verschieden sein können und eine substituierte oder unsubstituierte aromatische Kohlenwasserstoffgruppe, eine substituierte oder unsubstituierte aromatische heterocyclische Gruppe oder eine substituierte oder unsubstituierte kondensierte polycyclische aromatische Gruppe darstellen; und 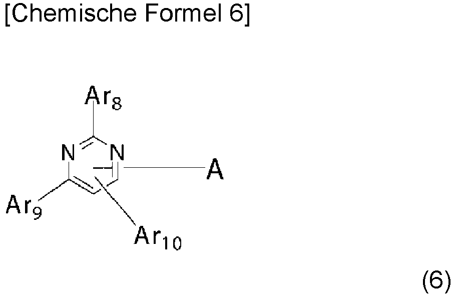
wobei Ar₈ eine substituierte oder unsubstituierte aromatische Kohlenwasserstoffgruppe, eine substituierte oder unsubstituierte aromatische heterocyclische Gruppe oder eine substituierte oder unsubstituierte kondensierte polycyclische aromatische Gruppe darstellt; Ar₉ und Ar₁₀ gleich oder verschieden sein können und ein Wasserstoffatom, eine substituierte oder unsubstituierte aromatische Kohlenwasserstoffgruppe, eine substituierte oder unsubstituierte aromatische heterocyclische Gruppe oder eine substituierte oder unsubstituierte kondensierte polycyclische aromatische Gruppe darstellen; und A eine durch die folgende Strukturformel (7) dargestellte einwertige Gruppe darstellt, wobei Ar₉ und Ar₁₀ nicht gleichzeitig ein Wasserstoffatom sind: 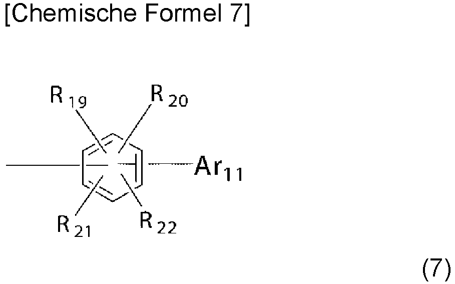
wobei Ar₁₁ eine substituierte oder unsubstituierte aromatische heterocyclische Gruppe darstellt; und R₁₉ bis R₂₂ gleich oder verschieden sein können und ein Wasserstoffatom, ein Deuteriumatom, ein Fluoratom, ein Chloratom, Cyan, Trifluormethyl, lineares oder verzweigtes Alkyl mit 1 bis 6 Kohlenstoffatomen, eine substituierte oder unsubstituierte aromatische Kohlenwasserstoffgruppe, eine substituierte oder unsubstituierte aromatische heterocyclische Gruppe oder eine substituierte oder unsubstituierte kondensierte polycyclische aromatische Gruppe darstellen, wobei R₁₉ bis R₂₂ an Ar₁₁ über eine Einfachbindung, ein substituiertes oder unsubstituiertes Methylen, ein Sauerstoffatom oder ein Schwefelatom gebunden sein können, um einen Ring zu bilden.

2. Organische Elektrolumineszenzvorrichtung nach Anspruch 1, wobei die Schichten, die der lichtemittierenden Schicht benachbart sind, keinen Elektronenakzeptor einschließen.

3. Organische Elektrolumineszenzvorrichtung nach Anspruch 1 oder 2, wobei der Elektronenakzeptor ein Elektronenakzeptor, ausgewählt aus Trisbromphenylamin-Hexachlorantimon, Tetracyanchinodimethan (TCNQ), 2,3,5,6-Tetrafluortetracyan-1,4-benzochinodimethan (F4TCNQ) und einem Radialenderivat, ist.

4. Organische Elektrolumineszenzvorrichtung nach einem der Ansprüche 1 bis 3, wobei der Elektronenakzeptor ein durch die folgende allgemeine Formel (2) dargestelltes Radialenderivat ist: 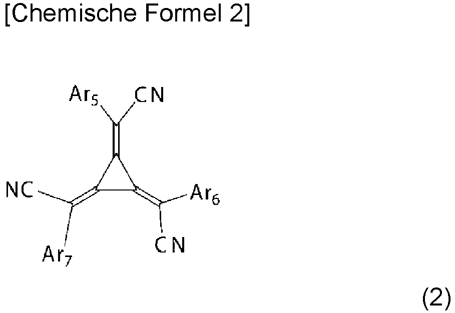 wobei Ar₅ bis Ar₇ gleich oder verschieden sein können und eine aromatische Kohlenwasserstoffgruppe, eine aromatische heterocyclische Gruppe oder eine kondensierte polycyclische aromatische Gruppe mit einer Elektronenakzeptorgruppe als ein Substituent darstellen.

5. Organische EL-Vorrichtung nach einem der Ansprüche 1 bis 4, wobei die lichtemittierende Schicht einen blaues Licht emittierenden Dotierstoff einschließt.

6. Organische EL-Vorrichtung nach Anspruch 5, wobei die lichtemittierende Schicht ein Pyren-Derivat als blaues Licht emittierenden Dotierstoff einschließt.

7. Organische EL-Vorrichtung nach Anspruch 5, wobei der blaues Licht emittierende Dotierstoff einen lichtemittierenden Dotierstoff einschließt, der ein durch die folgende allgemeine Formel (8) dargestelltes Aminderivat mit einer kondensierten Ringstruktur ist: 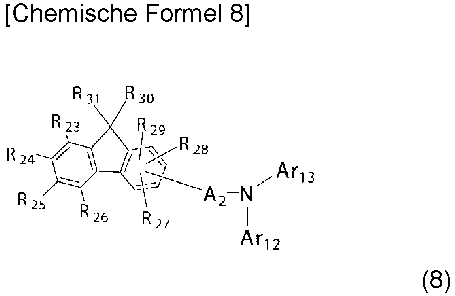 wobei A₂ eine zweiwertige Gruppe eines substituierten oder unsubstituierten aromatischen Kohlenwasserstoffs, eine zweiwertige Gruppe eines substituierten oder unsubstituierten aromatischen heterocyclischen Rings, eine zweiwertige Gruppe von substituierten oder unsubstituierten kondensierten polycyclischen Aromaten oder eine Einfachbindung darstellt; Ar₁₂ und Ar₁₃ gleich oder verschieden sein können, eine substituierte oder unsubstituierte aromatische Kohlenwasserstoffgruppe, eine substituierte oder unsubstituierte aromatische heterocyclische Gruppe oder eine substituierte oder unsubstituierte kondensierte polycyclische aromatische Gruppe darstellen und über eine Einfachbindung, ein substituiertes oder unsubstituiertes Methylen, ein Sauerstoffatom oder ein Schwefelatom aneinander gebunden sein können, um einen Ring zu bilden; R₂₃ bis R₂₆ gleich oder verschieden sein können und ein Wasserstoffatom, ein Deuteriumatom, ein Fluoratom, ein Chloratom, Cyan, Nitro, lineares oder verzweigtes Alkyl mit 1 bis 6 Kohlenstoffatomen, das einen Substituenten aufweisen kann, Cycloalkyl mit 5 bis 10 Kohlenstoffatomen, das einen Substituenten aufweisen kann, lineares oder verzweigtes Alkenyl mit 2 bis 6 Kohlenstoffatomen, das einen Substituenten aufweisen kann, lineares oder verzweigtes Alkyloxy mit 1 bis 6 Kohlenstoffatomen, das einen Substituenten aufweisen kann, Cycloalkyloxy mit 5 bis 10 Kohlenstoffatomen, das einen Substituenten aufweisen kann, eine substituierte oder unsubstituierte aromatische Kohlenwasserstoffgruppe, eine substituierte oder unsubstituierte aromatische heterocyclische Gruppe, eine substituierte oder unsubstituierte kondensierte polycyclische aromatische Gruppe, substituiertes oder unsubstituiertes Aryloxy oder eine disubstituierte Aminogruppe, die mit Gruppen, ausgewählt aus einer aromatischen Kohlenwasserstoffgruppe, einer aromatischen heterocyclischen Gruppe und einer kondensierten polycyclischen aromatischen Gruppe substituiert ist, darstellen, wobei diese Gruppen über eine Einfachbindung, ein substituiertes oder unsubstituiertes Methylen, ein Sauerstoffatom oder ein Schwefelatom miteinander verbunden sein können, um einen Ring zu bilden, und an den Benzolring, der an R₂₃ bis R₂₆ gebunden ist, über ein substituiertes oder unsubstituiertes Methylen, ein Sauerstoffatom, ein Schwefelatom oder eine monosubstituierte Aminogruppe gebunden sein können, um einen Ring zu bilden; R₂₇ bis R₂₉ gleich oder verschieden sein können und ein Wasserstoffatom, ein Deuteriumatom, ein Fluoratom, ein Chloratom, Cyan, Nitro, lineares oder verzweigtes Alkyl mit 1 bis 6 Kohlenstoffatomen, das einen Substituenten aufweisen kann, Cycloalkyl mit 5 bis 10 Kohlenstoffatomen, das einen Substituenten aufweisen kann, lineares oder verzweigtes Alkenyl mit 2 bis 6 Kohlenstoffatomen, das einen Substituenten aufweisen kann, lineares oder verzweigtes Alkyloxy mit 1 bis 6 Kohlenstoffatomen, das einen Substituenten aufweisen kann, Cycloalkyloxy mit 5 bis 10 Kohlenstoffatomen, das einen Substituenten aufweisen kann, eine substituierte oder unsubstituierte aromatische Kohlenwasserstoffgruppe, eine substituierte oder unsubstituierte aromatische heterocyclische Gruppe, eine substituierte oder unsubstituierte kondensierte polycyclische aromatische Gruppe oder substituiertes oder unsubstituiertes Aryloxy darstellen, wobei diese Gruppen über eine Einfachbindung, ein substituiertes oder unsubstituiertes Methylen, ein Sauerstoffatom oder ein Schwefelatom miteinander verbunden sein können, um einen Ring zu bilden, und an den Benzolring, der an R₂₇ bis R₂₉ gebunden ist, über ein substituiertes oder unsubstituiertes Methylen, ein Sauerstoffatom, ein Schwefelatom oder eine monosubstituierte Aminogruppe gebunden sein können, um einen Ring zu bilden; und R₃₀ und R₃₁ gleich oder verschieden sein können und lineares oder verzweigtes Alkyl mit 1 bis 6 Kohlenstoffatomen, das einen Substituenten aufweisen kann, Cycloalkyl mit 5 bis 10 Kohlenstoffatomen, das einen Substituenten aufweisen kann, lineares oder verzweigtes Alkenyl mit 2 bis 6 Kohlenstoffatomen, das einen Substituenten aufweisen kann, eine substituierte oder unsubstituierte aromatische Kohlenwasserstoffgruppe, eine substituierte oder unsubstituierte aromatische heterocyclische Gruppe, eine substituierte oder unsubstituierte kondensierte polycyclische aromatische Gruppe oder substituiertes oder unsubstituiertes Aryloxy darstellen, wobei diese Gruppen über eine Einfachbindung, ein substituiertes oder unsubstituiertes Methylen, ein Sauerstoffatom, ein Schwefelatom oder eine monosubstituierte Aminogruppe miteinander verbunden sein können, um einen Ring zu bilden.

8. Organische EL-Vorrichtung nach einem der Ansprüche 1 bis 7, wobei die lichtemittierende Schicht ein Anthracenderivat einschließt.

9. Organische EL-Vorrichtung nach Anspruch 8, wobei die lichtemittierende Schicht ein Wirtsmaterial einschließt, welches das Anthracenderivat ist.

## Revendications

1. Dispositif électroluminescent organique comprenant au moins une anode, une couche d'injection de trous, une couche de transport de trous, une couche à émission de lumière, une couche de transport d'électrons et une cathode, dans cet ordre, dans lequel la couche d'injection de trous inclut un composé d'arylamine représenté par la formule générale suivante (1) et un électroaccepteur : 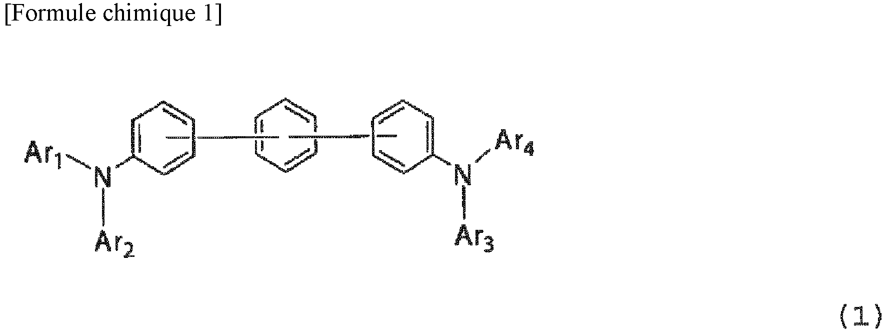
dans laquelle Ar₁ à Ar₄ peuvent être identiques ou différents, et représentent un groupe hydrocarbure aromatique substitué ou non substitué, un groupe hétérocyclique aromatique substitué ou non substitué ou un groupe aromatique polycyclique condensé substitué ou non substitué,
dans laquelle le substituant dans le groupe hydrocarbure aromatique substitué, le groupe hétérocyclique aromatique substitué ou le groupe aromatique polycyclique condensé substitué représenté par Ar₁ à Ar₄ dans la formule générale (1) inclut un atome de deutérium ; cyano ; nitro ; des atomes d'halogène ; des alkyles linéaires ou ramifiés de 1 à 6 atomes de carbone ; des alkyloxys linéaires ou ramifiés de 1 à 6 atomes de carbone ; des alkényles ; des aryloxys ; des arylalkyloxys ; des groupes hydrocarbures aromatiques ou des groupes aromatiques polycycliques condensés ; des groupes hétérocycliques aromatiques ; des arylvinyles ; des acyles ; et des silyles,
dans lequel la couche de transport de trous est constituée d'un composé d'arylamine de la formule générale (1), et
dans lequel la couche de transport d'électrons inclut un composé représenté par la formule générale suivante (5b) ayant une structure cyclique d'anthracène ou un composé représenté par la formule générale suivante (6) ayant une structure cyclique de pyrimidine : 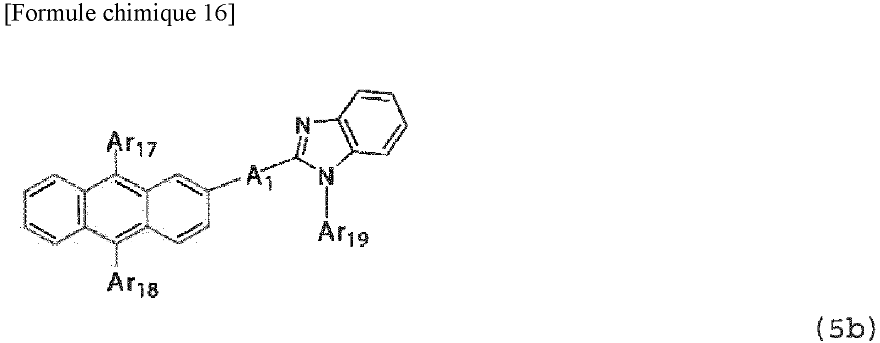
dans laquelle A₁ représente un groupe divalent d'un hydrocarbure aromatique substitué ou non substitué, un groupe divalent d'un anneau hétérocyclique aromatique substitué ou non substitué, un groupe divalent de composés aromatiques polycycliques condensés substitués ou non substitués, ou une liaison simple ; Ar₁₇, Ar₁₈ et Ar₁₉ peuvent être identiques ou différents, et représentent un groupe hydrocarbure aromatique substitué ou non substitué, un groupe hétérocyclique aromatique substitué ou non substitué ou un groupe aromatique polycyclique condensé substitué ou non substitué ; et 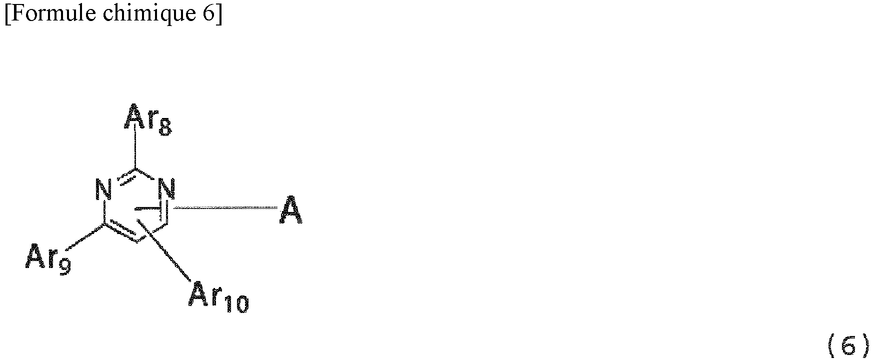
dans laquelle Ar₈ représente un groupe hydrocarbure aromatique substitué ou non substitué, un groupe hétérocyclique aromatique substitué ou non substitué ou un groupe aromatique polycyclique condensé substitué ou non substitué ; Ar₉ et Ar₁₀ peuvent être identiques ou différents, et représentent un atome d'hydrogène, un groupe hydrocarbure aromatique substitué ou non substitué, un groupe hétérocyclique aromatique substitué ou non substitué ou un groupe aromatique polycyclique condensé substitué ou non substitué ; et A représente un groupe monovalent représenté par la formule structurelle suivante (7), où Ar₉ et Ar₁₀ ne sont pas simultanément un atome d'hydrogène : 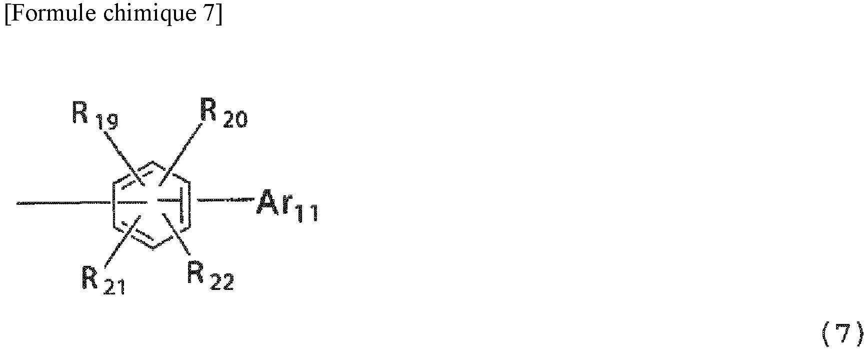
dans laquelle Ar₁₁ représente un groupe hétérocyclique aromatique substitué ou non substitué ; et R₁₉ à R₂₂ peuvent être identiques ou différents, et représentent un atome d'hydrogène, un atome de deutérium, un atome de fluor, un atome de chlore, cyano, trifluorométhyle, alkyle linéaire ou ramifié de 1 à 6 atomes de carbone, un groupe hydrocarbure aromatique substitué ou non substitué, un groupe hétérocyclique aromatique substitué ou non substitué ou un groupe aromatique polycyclique substitué ou non substitué, où R₁₉ à R₂₂ peuvent se lier à Ar₁₁ par le biais d'une liaison simple, de méthylène substitué ou non substitué, d'un atome d'oxygène ou d'un atome de soufre pour former un anneau.

2. Dispositif électroluminescent organique selon la revendication 1, dans lequel les couches qui sont adjacentes à la couche à émission de lumière n'incluent pas d'électroaccepteur.

3. Dispositif électroluminescent organique selon la revendication 1 ou 2, dans lequel l'électroaccepteur est un électroaccepteur sélectionné parmi l'hexachloroantimonate de trisbromophénylamine, le tétracyanoquinodiméthane (TCNQ), le 2,3,5,6-tétrafluoro-tétracyano-1,4-benzoquinodiméthane (F4TCNQ) et un dérivé de radialène.

4. Dispositif électroluminescent organique selon l'une quelconque des revendications 1 à 3, dans lequel l'électroaccepteur est un dérivé de radialène représenté par la formule générale suivante (2) : 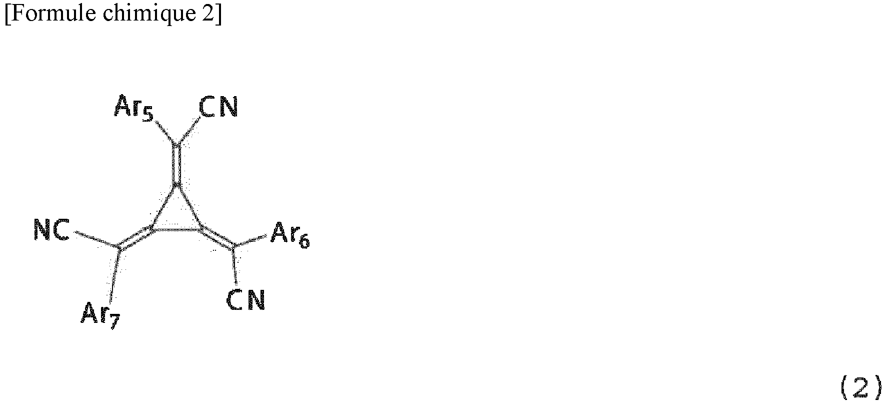 dans laquelle Ar₅ à Ar₇ peuvent être identiques ou différents, et représentent un groupe hydrocarbure aromatique, un groupe hétérocyclique aromatique ou un groupe aromatique polycyclique condensé, ayant un groupe électroaccepteur en tant que substituant.

5. Dispositif EL organique selon l'une quelconque des revendications 1 à 4, dans lequel la couche à émission de lumière inclut un dopant à émission de lumière bleue.

6. Dispositif EL organique selon la revendication 5, dans lequel la couche à émission de lumière inclut un dérivé de pyrène en tant que dopant à émission de lumière bleue.

7. Dispositif EL organique selon la revendication 5, dans lequel le dopant à émission de lumière bleue inclut un dopant à émission de lumière qui est un dérivé d'amine ayant une structure cyclique condensée représentée par la formule générale suivante (8) : 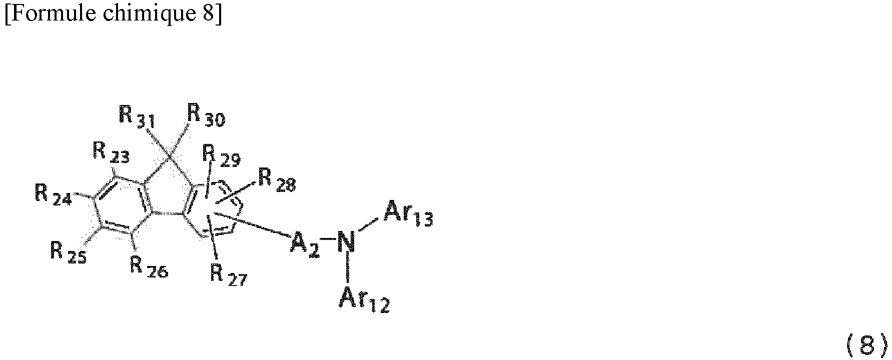 dans laquelle A₂ représente un groupe divalent d'un hydrocarbure aromatique substitué ou non substitué, un groupe divalent d'un anneau hétérocyclique aromatique substitué ou non substitué, un groupe divalent de composés aromatiques polycycliques condensés substitués ou non substitués, ou une liaison simple ; Ar₁₂ et Ar₁₃ peuvent être identiques ou différents, représentent un groupe hydrocarbure aromatique substitué ou non substitué, un groupe hétérocyclique aromatique substitué ou non substitué ou un groupe aromatique polycyclique condensé substitué ou non substitué, et peuvent se lier l'un à l'autre par le biais d'une liaison simple, de méthylène substitué ou non substitué, d'un atome d'oxygène ou d'un atome de soufre pour former un anneau ; R₂₃ à R₂₆ peuvent être identiques ou différents, et représentent un atome d'hydrogène, un atome de deutérium, un atome de fluor, un atome de chlore, cyano, nitro, alkyle linéaire ou ramifié de 1 à 6 atomes de carbone qui peut avoir un substituant, cycloalkyle de 5 à 10 atomes de carbone qui peut avoir un substituant, alkényle linéaire ou ramifié de 2 à 6 atomes de carbone qui peut avoir un substituant, alkyloxy linéaire ou ramifié de 1 à 6 atomes de carbone qui peut avoir un substituant, cycloalkyloxy de 5 à 10 atomes de carbone qui peut avoir un substituant, un groupe hydrocarbure aromatique substitué ou non substitué, un groupe hétérocyclique aromatique substitué ou non substitué ou un groupe aromatique polycyclique condensé substitué ou non substitué, aryloxy substitué ou non substitué, ou un groupe amino disubstitué substitué par des groupes sélectionnés parmi un groupe hydrocarbure aromatique, un groupe hétérocyclique aromatique et un groupe aromatique polycyclique condensé, où ces groupes peuvent se lier l'un à l'autre par le biais d'une liaison simple, de méthylène substitué ou non substitué, d'un atome d'oxygène ou d'un atome de soufre pour former un anneau, et peuvent se lier à l'anneau benzène se liant à R₂₃ à R₂₆ par le biais de méthylène substitué ou non substitué, d'un atome d'oxygène, d'un atome de soufre ou d'un groupe amino monosubstitué pour former un anneau ; R₂₇ à R₂₉ peuvent être identiques ou différents, et représentent un atome d'hydrogène, un atome de deutérium, un atome de fluor, un atome de chlore, cyano, nitro, alkyle linéaire ou ramifié de 1 à 6 atomes de carbone qui peut avoir un substituant, cycloalkyle de 5 à 10 atomes de carbone qui peut avoir un substituant, alkényle linéaire ou ramifié de 2 à 6 atomes de carbone qui peut avoir un substituant, alkyloxy linéaire ou ramifié de 1 à 6 atomes de carbone qui peut avoir un substituant, cycloalkyloxy de 5 à 10 atomes de carbone qui peut avoir un substituant, un groupe hydrocarbure aromatique substitué ou non substitué, un groupe hétérocyclique aromatique substitué ou non substitué, un groupe aromatique polycyclique condensé substitué ou non substitué, ou aryloxy substitué ou non substitué, où ces groupes peuvent se lier l'un à l'autre par le biais d'une liaison simple, de méthylène substitué ou non substitué, d'un atome d'oxygène ou d'un atome de soufre pour former un anneau, et peuvent se lier à l'anneau benzène se liant à R₂₇ à R₂₉ par le biais de méthylène substitué ou non substitué, d'un atome d'oxygène, d'un atome de soufre ou d'un groupe amino monosubstitué pour former un anneau ; et R₃₀ et R₃₁ peuvent être identiques ou différents, et représentent alkyle linéaire ou ramifié de 1 à 6 atomes de carbone qui peut avoir un substituant, cycloalkyle de 5 à 10 atomes de carbone qui peut avoir un substituant, alkényle linéaire ou ramifié de 2 à 6 atomes de carbone qui peut avoir un substituant, un groupe hydrocarbure aromatique substitué ou non substitué, un groupe hétérocyclique aromatique substitué ou non substitué, un groupe aromatique polycyclique condensé substitué ou non substitué, ou un aryloxy substitué ou non substitué, où ces groupes peuvent se lier l'un à l'autre par le biais d'une liaison simple, de méthylène substitué ou non substitué, d'un atome d'oxygène, d'un atome de soufre ou d'un groupe amino monosubstitué pour former un anneau.

8. Dispositif EL organique selon l'une quelconque des revendications 1 à 7, dans lequel la couche à émission de lumière inclut un dérivé d'anthracène.

9. Dispositif EL organique selon la revendication 8, dans lequel la couche à émission de lumière inclut un matériau hôte qui est le dérivé d'anthracène.
